(19) Europäisches Patentamt
European Patent Office
Office européen des brevets

(11) **EP 4 184 827 A1**

(12) **EUROPEAN PATENT APPLICATION**
published in accordance with Art. 153(4) EPC

(43) Date of publication:
**24.05.2023 Bulletin 2023/21**

(21) Application number: **21855298.2**

(22) Date of filing: **07.07.2021**

(51) International Patent Classification (IPC):
**H04L 1/00** (2006.01)

(52) Cooperative Patent Classification (CPC):
**H04L 1/00**

(86) International application number:
**PCT/CN2021/105002**

(87) International publication number:
**WO 2022/033245 (17.02.2022 Gazette 2022/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.08.2020 CN 202010820352**

(71) Applicant: **Huawei Technologies Co., Ltd.
Shenzhen, Guangdong 518129 (CN)**

(72) Inventor: **ZHENG, Ruobin
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **NETWORK CODING METHOD AND APPARATUS**

(57) Embodiments of this application provide a network encoding method and apparatus, to resolve a problem of poor data transmission performance. In embodiments of this application, a transmit end may send a packet encoded in a finite field with a low order, a finite field with an intermediate order, or a finite field with a high order. An intermediate node may determine a finite field for recoding based on an encoding computing power of the intermediate node, a finite field corresponding to an encoding coefficient carried in a received packet, network load, or the like, without depending on an encoding computing power of a transmit/receive end and a network configuration. A receive end may first perform most decoding in a high-speed first finite field, and then attempt to switch to a high-order finite field to perform remaining decoding, so that many requirements can be satisfied, and an application encoding requirement and finite field selection can be arbitrarily and independently adjusted at any time.

FIG. 5

**Description**

**CROSS-REFERENCE TO RELATED APPLICATIONS**

This application claims priority to Chinese Patent Application No. 202010820352.7, filed with the China National Intellectual Property Administration on August 14, 2020 and entitled "NETWORK ENCODING METHOD AND APPARATUS", which is incorporated herein by reference in its entirety.

**TECHNICAL FIELD**

This application relates to the field of communications technologies, and in particular, to a network encoding method and apparatus.

**BACKGROUND**

Network encoding is mainly used in a multicast network, and encoding is performed on a node to improve an information transmission rate. Currently, a transmit/receive end and a network node in network encoding need to consistently perform encoding/decoding in a same finite field (for example, a Galois field (galois field, GF)). For example, if a transmit end chooses to perform encoding in a finite field $GF(2^8)$, all intermediate nodes participating in network encoding need to perform recoding (Recoding) in the finite field $GF(2^8)$, and all receive ends need to perform decoding in the finite field $GF(2^8)$. Therefore, in a data transmission process, an encoding/decoding parameter consistent with that of a transmit/receive end needs to be configured for each network node for each stream or each application.

However, when the encoding/decoding parameter consistent with that of the transmit/receive end is configured for each network node for each stream or each application, there are the following problems:

(1) Because a network device usually has a limited encoding computing power, a throughput bottleneck may be caused.
(2) Because encoding computing powers of network nodes are different, if the network nodes all support encoding/decoding algorithms at a same level, an encoding/decoding algorithm at a relatively low level needs to be selected for data transmission. Consequently, a quality of service (quality of service, QoS) requirement may not be satisfied.
(3) Because the encoding/decoding parameter consistent with that of the transmit/receive end is configured for the network node for each stream or each application, configuration costs are high, and the encoding/decoding parameter needs to be reconfigured during path switching in data transmission, resulting in a high path switching latency.

**SUMMARY**

Embodiments of this application provide a network encoding method and apparatus, to resolve a problem of poor data transmission performance.

According to a first aspect, an embodiment of this application provides a network encoding method. The method may be applied to a transmit end, and the method includes: encoding k source data blocks in one generation to obtain a plurality of encoded data blocks, where k is an integer greater than 0, and encoding coefficients used for at least two of the plurality of encoded data blocks correspond to finite fields with different orders; and generating one or more packets based on the plurality of encoded data blocks and sending the one or more packets, where each packet carries at least one encoded data block and an encoding coefficient corresponding to the encoded data block. In this embodiment of this application, the transmit end encodes the source data blocks in a plurality of finite fields, so that a receive end can receive packets in different finite fields. Therefore, the receive end can independently select a finite field for encoding/decoding based on a computing power of the receive end and an application requirement.

In a possible design, the encoding k source data blocks in one generation to obtain a plurality of encoded data blocks includes: performing a first encoding operation on the k source data blocks by using a first encoding matrix to obtain the plurality of encoded data blocks, where the first encoding matrix includes encoding coefficients of at least two types of finite fields with different orders. In the foregoing design, the encoding matrix that includes encoding coefficients of at least two types of finite fields with different orders can be used to encode the source data blocks in a plurality of finite fields.

In a possible design, h1 packets are generated based on the k source data blocks and are sent, each of the h1 packets carries at least one source data block and an encoding coefficient corresponding to the source data block, encoding coefficients corresponding to the k source data blocks form a $k \times k$ matrix in which diagonal elements are 1 and elements other than the diagonal elements are 0, elements in any row in the matrix are k encoding coefficients corresponding to one of the k source data blocks, and h1 is an integer greater than 0 and not greater than k. According to the foregoing design, the transmit end can output system code.

In a possible design, the encoding k source data blocks in one generation to obtain a plurality of encoded data blocks includes: performing a second encoding operation on the k source data blocks by using a second encoding matrix to obtain $n_1$ encoded data blocks, where $n_1$ is an integer greater than 0, an order of a finite field corresponding to a first encoding coefficient included in the second encoding matrix is higher than an order of a first finite field, and the first finite field is a finite field corresponding to a third encoding matrix; and performing a third encoding operation on the $n_1$ encoded data blocks and the k source data blocks by using the third encoding matrix to obtain m encoded data blocks, where m is an integer greater than 0, and the plurality of encoded data blocks include the $n_1$ encoded data blocks and the m encoded data blocks.

In a possible design, h2 packets are generated based on the k source data blocks and are sent, each of the h2 packets carries at least one source data block and an encoding coefficient corresponding to the source data block, h2 is an integer greater than 0 and not greater than k, encoding coefficients corresponding to the k source data blocks and second encoding coefficients corresponding to the $n_1$ encoded data blocks form a $(k+n_1) \times (k+n_1)$ matrix in which diagonal elements are 1 and elements other than the diagonal elements are 0, elements in any row in the matrix are $k+n_1$ encoding coefficients corresponding to one of the k source data blocks or $k+n_1$ encoding coefficients corresponding to one of the $n_1$ encoded data blocks, and the second encoding coefficient is an encoding coefficient in encoding coefficients corresponding to the $n_1$ encoded data blocks other than the first encoding coefficient used for the second encoding operation.

In a possible design, the encoding k source data blocks in one generation to obtain a plurality of encoded data blocks includes: performing a fourth encoding operation on the k source data blocks by using a fourth encoding matrix to obtain $n_2$ intermediate data blocks, where $n_2$ is an integer greater than 0, an order of a finite field corresponding to an encoding coefficient included in the fourth encoding matrix is higher than an order of a second finite field, and the second finite field is a finite field corresponding to a fifth encoding matrix; and performing a fifth encoding operation on the nz intermediate data blocks and the k source data blocks by using the fifth encoding matrix to obtain the plurality of encoded data blocks.

In a possible design, the packet further carries indication information, and the indication information indicates an order of a finite field corresponding to a source data block carried in the packet, or the indication information indicates an order of a finite field corresponding to an encoded data block carried in the packet. According to the foregoing design, the receive end can directly determine a finite field corresponding to a data block.

According to a second aspect, an embodiment of this application provides a network encoding method. The method may be applied to an intermediate node, and the method includes: receiving n packets, where n is an integer greater than 1, one packet carries $a_1$ data blocks and encoding coefficients corresponding to the $a_1$ data blocks, $a_1$ is an integer greater than 0, and encoding coefficients carried in the n packets correspond to one or more finite fields; determining a finite field for recoding based on one or more of the following information: an encoding computing power of a network node, the finite field corresponding to the encoding coefficients carried in the n packets, and network load; recoding, based on the finite field for recoding, data blocks and the encoding coefficients carried in the n packets to obtain v encoding results, where v is an integer greater than 0; and sending m1 recoded packets, where one recoded packet carries at least one encoding result, and m 1 is an integer greater than 0 and not greater than v.

In this embodiment of this application, the intermediate node may determine the finite field for recoding based on an encoding computing power of the intermediate node, a finite field corresponding to an encoding coefficient carried in a received packet, network load, or the like, without being limited by an encoding computing power of a transmit/receive end. Therefore, flexibility of recoding can be implemented. In addition, the intermediate node may adjust the finite field for recoding at any time based on the encoding computing power of the intermediate node, the finite field corresponding to the encoding coefficient carried in the received packet, the network load, or the like, without renegotiating encoding computing powers of the transmit/receive end and another intermediate node. Therefore, a path can be directly switched, and a path switching latency is low.

In a possible design, there are one or more finite fields for recoding. In the foregoing design, the intermediate node recodes a packet output by the transmit end, so that the transmit end and the intermediate node can perform distributed encoding. To be specific, the transmit end encodes one part and the intermediate node encodes the other part. In this manner, the transmit end may perform encoding with relatively low complexity, and the intermediate node further recodes the packet output by the transmit end, so that network load can be reduced and transmission efficiency can be improved.

In a possible design, the recoding, based on the finite field for recoding, data blocks and the encoding coefficients carried in the n packets includes: performing, by using a seventh encoding matrix, an encoding operation on the data blocks carried in the n packets to obtain v recoded data blocks, where an encoding coefficient included in the seventh encoding matrix belongs to the finite field for recoding; and performing, by using the seventh encoding matrix, an encoding operation on the encoding coefficients carried in the n packets to obtain v groups of recoded encoding coefficients, where one encoding result includes one recoded data block and one group of corresponding recoded encoding coefficients. According to the foregoing design, a packet output by the transmit end can be further recoded. Therefore, the transmit end and the intermediate node can perform distributed encoding. To be specific, the transmit end encodes one part and the intermediate node encodes the other part. In this manner, network load can be reduced and transmission efficiency can be improved.

In a possible design, the determining a finite field for recoding based on the finite field corresponding to the encoding coefficients carried in the n packets includes: determining, as the finite field for recoding, a finite field with a highest order in the finite field corresponding to the encoding coefficients carried in the n packets.

According to a third aspect, an embodiment of this application provides a network encoding method. The method may be applied to a receive end, and the method includes: receiving a plurality of packets for k source data blocks in one generation, where k is an integer greater than 0, and one packet carries at least one data block and a group of encoding coefficients corresponding to each data block; and decoding the plurality of packets in a first decoding manner, a second decoding manner, a third decoding manner, a fourth decoding manner, or a fifth decoding manner.

The first decoding manner is decoding the plurality of packets in a first finite field, and the first finite field is a finite field with a lowest order in a network.

The second decoding manner is decoding the plurality of packets in a second finite field, and the second finite field is a finite field with a highest order in finite fields corresponding to encoding coefficients carried in the plurality of packets.

The third decoding manner is decoding the plurality of packets in a third finite field, the third finite field is another finite field other than a first finite field in finite fields corresponding to encoding coefficients carried in the plurality of packets, and the first finite field is a finite field with a lowest order in a network.

The fourth decoding manner is decoding the plurality of packets in a first finite field and a fourth finite field, the first finite field is a finite field with a lowest order in a network, the fourth finite field is any high-order finite field corresponding to encoding coefficients carried in the plurality of packets, and the high-order finite field is a finite field whose order is higher than that of the first finite field.

The fifth decoding manner is decoding the plurality of packets in a first finite field and a fifth finite field, the first finite field is a finite field with a lowest order in a network, the fifth finite field is a finite field with a highest order in any t high-order finite fields corresponding to encoding coefficients carried in the plurality of packets, the high-order finite field is a finite field whose order is higher than that of the first finite field, and t is an integer greater than 1.

In this embodiment of this application, the receive end may first perform most decoding in the high-speed first finite field and then attempt to switch to a high-order finite field to perform remaining decoding, and may independently select a finite field for encoding/decoding based on a computing power of the receive end and an application requirement, so that many requirements can be satisfied, and an application encoding requirement and finite field selection can be arbitrarily and independently adjusted at any time.

In a possible design, the decoding the plurality of packets in a first decoding manner includes: decoding the plurality of packets in the first finite field, so that after decoding, diagonal elements of a decoding matrix are 1, and elements other than the diagonal elements are 0, where elements in any row in the decoding matrix are a group of encoding coefficients corresponding to one data block. In the foregoing manner, the first decoding manner can improve a decoding speed, and the first decoding manner has advantages such as low computing complexity and a high throughput.

In a possible design, the plurality of packets carry k data blocks, and encoding coefficients corresponding to the k data blocks belong to the first finite field; or the plurality of packets carry k+n data blocks, a finite field corresponding to encoding coefficients corresponding to the k+n data blocks is the first finite field, n is a quantity of encoded data blocks encoded in a high-order finite field, and the high-order finite field is a finite field whose order is higher than that of the first finite field. In the foregoing manner, transmission overheads in the first decoding manner are relatively low.

In a possible design, the decoding the plurality of packets in a second decoding manner includes: decoding the plurality of packets in the second finite field, so that after decoding, diagonal elements of a decoding matrix are 1, and elements other than the diagonal elements are 0, where elements in any row in the decoding matrix are a group of encoding coefficients corresponding to one data block. In the foregoing manner, the second decoding manner can improve a decoding speed, and can improve a decoding success rate, so that a balance between the decoding speed and the decoding success rate can be implemented.

In a possible design, the plurality of packets carry k data blocks, and encoding coefficients corresponding to the k data blocks belong to two or more finite fields. In the foregoing manner, transmission overheads in the second decoding manner are relatively low.

In a possible design, the decoding the plurality of packets in a third decoding manner includes: decoding the plurality of packets in the third finite field, so that after decoding, diagonal elements of a decoding matrix are 1, and elements other than the diagonal elements are transformed into 0, where elements in any row in the decoding matrix are a group of encoding coefficients corresponding to one data block. In the foregoing design, in the third decoding manner, an encoding coefficient corresponding to a data block corresponds to only one finite field (that is, the third finite field) other than the first finite field. Because k»n actually, most coefficients in the decoding matrix are encoding coefficients 1 or 0 from the first finite field. Therefore, there are a very small quantity of decoding operations in the third finite field, so that operation complexity in the third finite field can be greatly reduced.

In a possible design, the plurality of packets carry k data blocks, an encoding coefficient corresponding to at least one of the k data blocks belongs to the first finite field, and an encoding coefficient corresponding to another data block other than the at least one data block in the k data blocks belongs to the third finite field. In the foregoing manner, transmission overheads in the third decoding manner are relatively low.

In a possible design, the decoding the plurality of packets in a fourth decoding manner includes: performing a first decoding operation on the plurality of packets in the first finite field; and performing a second decoding operation on a result of the first decoding operation in the fourth finite field. In the foregoing manner, most coefficients in the decoding matrix are encoding coefficients 1 or 0 from the first finite field. Therefore, there are a very small quantity of decoding operations in the fourth finite field, so that operation complexity in the fourth finite field can be greatly reduced.

In a possible design, the performing a second decoding operation on a result of the first decoding operation in the fourth finite field includes: performing the second decoding operation on the result of the first decoding operation in the fourth finite field, so that after the second decoding operation, diagonal elements of a first decoding matrix are 1, and elements other than the diagonal elements are 0, where an upper matrix of the first decoding matrix includes an element in an $i^{th}$ row and a $g^{th}$ column of a second decoding matrix, a lower matrix of the first decoding matrix is a result of performing an operation on an element in a $T^{th}$ row and the $g^{th}$ column of the second decoding matrix and an encoding coefficient belonging to the fourth finite field in encoding coefficients corresponding to the $T^{th}$ row, elements in any row in the second decoding matrix are a result of performing the first decoding operation on an encoding coefficient belonging to the first finite field in a group of encoding coefficients corresponding to one data block, i={ 1, 2, ..., and H-n}, g={ 1, 2, ..., and k}, the $T^{th}$ row of the second decoding matrix is a row corresponding to an encoding coefficient in the fourth finite field, H is a quantity of data blocks carried in the plurality of packets, and n is a quantity of encoded data blocks encoded in the high-order finite field. In the foregoing design, because of a decoding success rate in the fourth finite field, performing some decoding operations in the fourth finite field can improve a decoding success rate.

In a possible design, the performing a first decoding operation on the plurality of packets in the first finite field includes: performing the first decoding operation on the plurality of packets in the first finite field, so that after the first decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0.

Elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, the $h^{th}$ row of the fifth decoding matrix obtained after the first decoding operation is a row corresponding to the encoding coefficient in the fourth finite field, H is the quantity of data blocks carried in the plurality of packets, and n is the quantity of encoded data blocks encoded in the high-order finite field. In the foregoing design, because decoding complexity in the first finite field is relatively low and a decoding speed in the first finite field is relatively high, performing some decoding operations in the first finite field can improve a decoding speed.

In a possible design, the plurality of packets carry (k-1)+n data blocks, an encoding coefficient corresponding to at least one of the (k-1)+n data blocks belongs to the fourth finite field, and n is the quantity of encoded data blocks encoded in the high-order finite field. In the foregoing manner, transmission overheads can be reduced.

In a possible design, the decoding the plurality of packets in a fifth decoding manner includes: performing a fourth decoding operation on the plurality of packets in the first finite field; and performing a third decoding operation on a result of the fourth decoding operation in the fifth finite field. In the foregoing manner, most coefficients in the decoding matrix are encoding coefficients 1 or 0 from the first finite field. Therefore, there are a very small quantity of decoding operations in the fifth finite field, so that operation complexity in the fifth finite field can be greatly reduced.

In a possible design, the performing a third decoding operation on a result of the fourth decoding operation in the fifth finite field includes: performing the third decoding operation on the result of the fourth decoding operation in the fifth finite field, so that after the third decoding operation, diagonal elements of a third decoding matrix are 1, and elements other than the diagonal elements are 0, where an upper matrix of the third decoding matrix includes an element in an $i^{th}$ row and a $g^{th}$ column of a fourth decoding matrix, a lower matrix of the first decoding matrix is a result of performing an operation on elements in a $g^{th}$ column of any t rows in an $(H-n+1)^{th}$ row to an $H^{th}$ row of the fourth decoding matrix and an encoding coefficient belonging to the high-order finite field in encoding coefficients corresponding to the any t rows, elements in any row in the fourth decoding matrix are a result of performing the first decoding operation on an encoding coefficient belonging to the first finite field in a group of encoding coefficients corresponding to one data block, i={ 1, 2, ..., and H-n}, g={ 1, 2, ..., and k}, H is a quantity of data blocks carried in the plurality of packets, and n is a quantity of encoded data blocks encoded in the high-order finite field. In the foregoing design, from a perspective of a decoding success rate or transmission overheads, the high-order finite field may be used to improve the decoding success rate.

In a possible design, the performing a fourth decoding operation on the plurality of packets in the first finite field includes: performing the fourth decoding operation on the plurality of packets in the first finite field, so that after the fourth decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0, where elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, h is any t integers greater than H-n and less than H+1, H is the quantity of data blocks carried in the plurality of packets, and n is the quantity of encoded data blocks encoded in the high-order finite field. In the foregoing design, from a perspective of a decoding speed or a throughput, most operations are performed in the first finite field in the fifth decoding manner. Compared with the conventional technology in which operations are performed in a high-order finite field, the fifth decoding manner can effectively reduce computing complexity, and improve a decoding speed and a throughput.

In a possible design, the plurality of packets carry k+n-t data blocks, encoding coefficients corresponding to the k+n-t data blocks belong to at least t different high-order finite fields, and n is the quantity of encoded data blocks encoded in the high-order finite field. In the foregoing manner, transmission overheads can be reduced.

According to a fourth aspect, this application provides a network encoding apparatus. The apparatus may be a communications device, or may be a chip or a chip set in the communications device. The communications device may be a transmit end, or may be an intermediate node or a receive end. The apparatus may include a processing unit and a transceiver unit. When the apparatus is a communications device, the processing unit may be a processor, and the transceiver unit may be a transceiver. The apparatus may further include a storage module, and the storage module may be a memory. The storage module is configured to store instructions. The processing unit executes the instructions stored in the storage module, so that the transmit end performs a corresponding function in the first aspect, or the intermediate node performs a corresponding function in the first aspect, or the receive end performs a corresponding function in the first aspect. When the apparatus is a chip or a chip set in a communications device, the processing unit may be a processor, and the transceiver unit may be an input/output interface, a pin, a circuit, or the like. The processing unit executes instructions stored in a storage module, so that the transmit end performs a corresponding function in the first aspect, or the intermediate node performs a corresponding function in the first aspect, or the receive end performs a corresponding function in the first aspect. The storage module may be a storage module (for example, a register or a cache) in the chip or the chip set, or may be a storage module (for example, a read-only memory or a random access memory) located outside the chip or the chip set.

According to a fifth aspect, a network encoding apparatus is provided, including a processor, a communications interface, and a memory. The communications interface is configured to transmit information, and/or messages, and/or data between the apparatus and another apparatus. The memory is configured to store computer-executable instructions. When the apparatus runs, the processor executes the computer-executable instructions stored in the memory, so that the apparatus performs the method according to any one of the first aspect to the third aspect or any design in any aspect.

According to a sixth aspect, this application further provides a computer-readable storage medium. The computer-readable storage medium stores instructions, and when the instructions are run on a computer, the computer is enabled to perform the method according to any one of the first aspect to the third aspect or any design in any aspect.

According to a seventh aspect, this application further provides a computer program product including instructions. When the computer program product runs on a computer, the computer is enabled to perform the method according to any one of the first aspect to the third aspect or any design in any aspect.

According to an eighth aspect, an embodiment of this application provides a chip. The chip is coupled to a memory, and performs the method according to any one of the first aspect to the third aspect or any design in any aspect.

It should be noted that in embodiments of this application, "coupling" means that two components are directly or indirectly combined with each other.

## BRIEF DESCRIPTION OF DRAWINGS

FIG. 1 is a schematic diagram of an architecture of a communications system in a multicast scenario according to an embodiment of this application;

FIG. 2 is a schematic diagram of an architecture of a communications system in a unicast scenario according to an embodiment of this application;

FIG. 3 is a schematic diagram of a multicast scenario according to an embodiment of this application;

FIG. 4 is a schematic diagram of a unicast scenario according to an embodiment of this application;

FIG. 5 is a schematic flowchart of a network encoding method according to an embodiment of this application;

FIG. 6 is a schematic diagram of an encoding manner according to an embodiment of this application;

FIG. 7 is a schematic diagram of an encoding process according to an embodiment of this application;

FIG. 8 is a schematic diagram of another encoding manner according to an embodiment of this application;

FIG. 9 is a schematic diagram of a second encoding operation process according to an embodiment of this application;

FIG. 10 is a schematic diagram of a third encoding operation process according to an embodiment of this application;

FIG. 11 is a schematic diagram of a fourth encoding operation process according to an embodiment of this application;

FIG. 12 is a schematic diagram of a fifth encoding operation process according to an embodiment of this application;

FIG. 13 is a schematic flowchart of a network encoding method according to an embodiment of this application;

FIG. 14 is a schematic diagram of a recoding manner according to an embodiment of this application;

FIG. 15 is a schematic diagram of a recoding process according to an embodiment of this application;

FIG. 16 is a schematic diagram of another recoding process according to an embodiment of this application;

FIG. 17 is a schematic flowchart of a network encoding method according to an embodiment of this application;

FIG. 18 is a schematic diagram of a first decoding manner according to an embodiment of this application;

FIG. 19 is a schematic diagram of a second decoding manner according to an embodiment of this application;

FIG. 20 is a schematic diagram of another second decoding manner according to an embodiment of this application;

FIG. 21 is a schematic diagram of another second decoding manner according to an embodiment of this application;

FIG. 22 is a schematic diagram of a third decoding manner according to an embodiment of this application;

FIG. 23 is a schematic diagram of another third decoding manner according to an embodiment of this application;

FIG. 24 is a schematic diagram of another first decoding manner according to an embodiment of this application;

FIG. 25 is a schematic diagram of a fourth decoding manner according to an embodiment of this application;

FIG. 26 is a schematic diagram of performing an addition operation in a finite field $GF(2^N)$ according to an embodiment of this application;

FIG. 27 is a schematic diagram of another fourth decoding manner according to an embodiment of this application;

FIG. 28 is a schematic diagram of another fourth decoding manner according to an embodiment of this application;

FIG. 29 is a schematic diagram of another fourth decoding manner according to an embodiment of this application;

FIG. 30 is a schematic diagram of a fifth decoding manner according to an embodiment of this application;

FIG. 31 is a schematic diagram of an addition table in a finite field according to an embodiment of this application;

FIG. 32 is a schematic diagram of an encoding coefficient operation according to an embodiment of this application;

FIG. 33 is a schematic diagram of another fifth decoding manner according to an embodiment of this application;

FIG. 34 is a schematic diagram of another fifth decoding manner according to an embodiment of this application;

FIG. 35 is a schematic diagram of a structure of a network encoding apparatus according to an embodiment of this application; and

FIG. 36 is a schematic diagram of a structure of another network encoding apparatus according to an embodiment of this application.

## DESCRIPTION OF EMBODIMENTS

To better understand embodiments of this application, the following describes technical terms in embodiments of this application.

Finite field (finite field): The finite field is a field containing a plurality of elements with a limited quantity. The finite field may also be referred to as a Galois field (Galois field, GF). Like another field, the finite field is a set that satisfies a specific rule and in which an addition operation, a subtraction operation, a multiplication operation, and a division operation are all defined. A quantity of elements in the finite field is referred to as an order of the finite field, and the order of the finite field is usually a power of a prime number. The finite field is a technology known to a person skilled in the art. For specific description, refer to the conventional technology. Details are not described herein.

For ease of description, in embodiments of this application, different finite fields are distinguished based on orders of the finite fields. For example, using the prime number 2 as an example, a finite field whose element quantity (order) is $2^1$ may be referred to as $GF(2^1)$, a finite field whose element quantity (order) is $2^2$ may be referred to as $GF(2^2)$, and a finite field whose element quantity (order) is $2^n$ may be referred to as $GF(2^n)$. It should be understood that only the prime number 2 is used as an example herein for description, and a value of the prime number is not specifically limited.

To make objectives, technical solution, and advantages of embodiments of this application clearer, the following further describes embodiments of this application in detail with reference to the accompanying drawings.

A network encoding method provided in this application may be applied to various communications systems, for example, an internet of things (internet of things, IoT), a narrow band internet of things (narrow band internet of things, NB-IoT), long term evolution (long term evolution, LTE), a 5th generation (5G) communications system, a hybrid architecture of LTE and 5G, a 5G new radio (new radio, NR) system, and a new communications system emerging in future communication development. The 5G communications system described in this application may include at least one of a non-standalone (non-standalone, NSA) 5G communications system and a standalone (standalone, SA) 5G communications system. The communications system may alternatively be a public land mobile network (public land mobile network, PLMN), a device-to-device (device-to-device, D2D) network, a machine-to-machine (machine to machine, M2M) network, or another network.

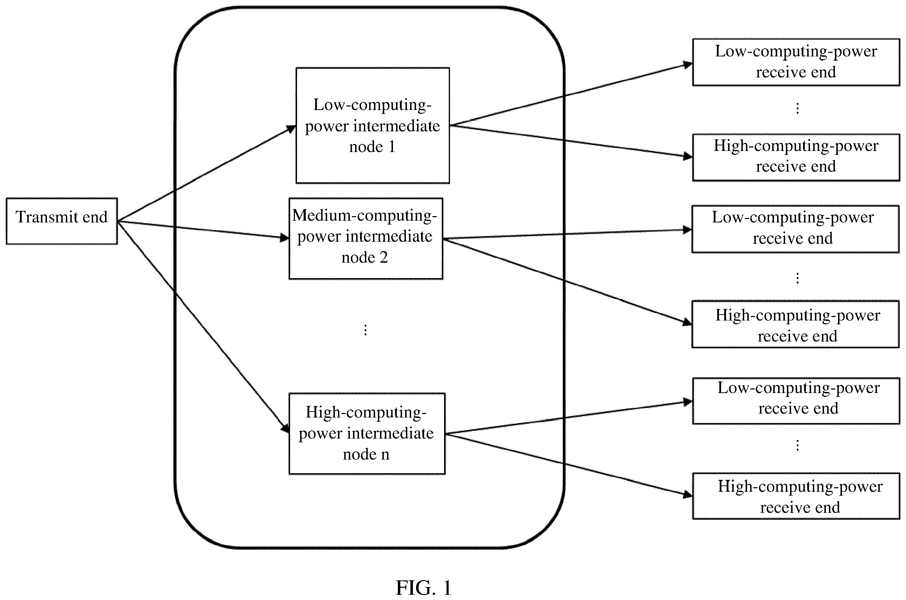

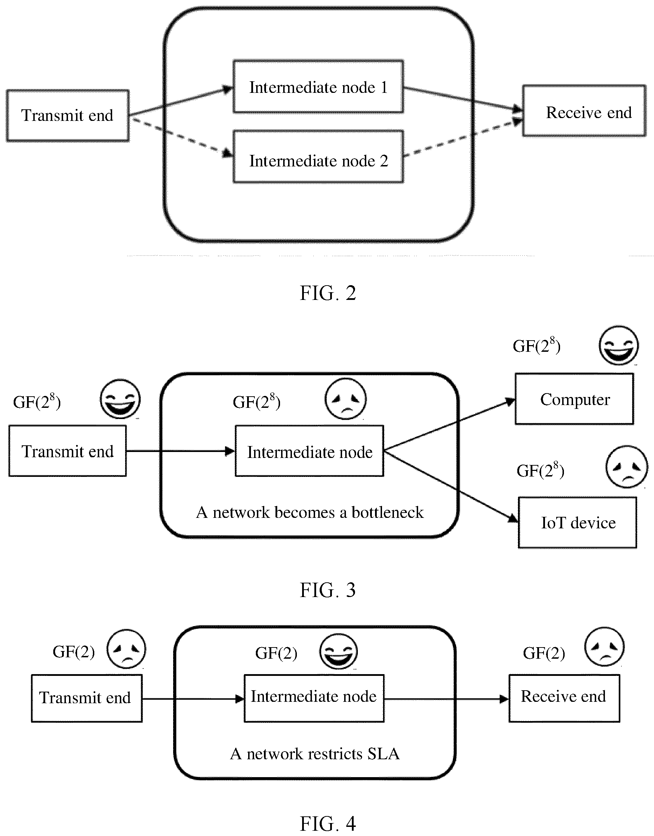

The communications system applied to embodiments of this application may include one or more transmit ends and one or more receive ends. The communications system may further include one or more intermediate nodes. One transmit end may transmit data to one or more receive ends. A plurality of transmit ends may simultaneously transmit data to one receive end. One transmit end may simultaneously transmit data to a plurality of receive ends. A transmit end may transmit data to a receive end through one or more intermediate nodes. Embodiments of this application may be applied to a multicast scenario, or may be applied to a unicast scenario. For example, for an architecture of a communications system in the multicast scenario, refer to FIG. 1. For an architecture of a communications system in the unicast scenario, refer to FIG. 2. It should be understood that FIG. 1 and FIG. 2 are merely examples for description, and do not constitute a specific limitation on a connection relationship and quantities of transmit ends, intermediate nodes, and receive ends in the communications system. For example, the transmit end may be a network device, a terminal device, another data sending device, or an encoder. The receive end may be a terminal device, another data receiving device, or a decoder. The intermediate node may be a transmission device such as a routing node, a forwarding node, or a relay node, or may be an encoder.

The terminal device in embodiments of this application is an entity for receiving or transmitting a signal on a user side. The terminal device may be a device that provides voice and data connectivity for a user, for example, a handheld device having a wireless connection function or a vehicle-mounted device. The terminal device may alternatively be another processing device connected to a wireless modem. The terminal device may communicate with one or more core networks through a radio access network (radio access network, RAN). The terminal device may alternatively be referred to as a wireless terminal, a subscriber unit (subscriber unit), a subscriber station (subscriber station), a mobile station (mobile station), a mobile (mobile), a remote station (remote station), an access point (access point), a remote terminal (remote terminal), an access terminal (access terminal), a user terminal (user terminal), a user agent (user agent), a user device (user device), user equipment (user equipment), or the like. The terminal device may be a mobile terminal, for example, a mobile phone (or referred to as a "cellular" phone), or a computer that has a mobile terminal. For example, the terminal device may be a portable, pocket-sized, handheld, computer built-in, or vehicle-mounted mobile apparatus, which exchanges a voice and/or data with the radio access network. For example, the terminal device may alternatively be a device such as a personal communication service (personal communication service, PCS) phone, a cordless telephone set, a session initiation protocol (session initiation protocol, SIP) phone, a wireless local loop (wireless local loop, WLL) station, or a personal digital assistant (personal digital assistant, PDA). Common terminal devices include, for example, a mobile phone, a tablet computer, a notebook computer, a palmtop computer, a mobile internet device (mobile internet device, MID), and a wearable device such as a smartwatch, a smart band, or a pedometer. However, embodiments of this application are not limited thereto. The terminal device in embodiments of this application may alternatively be a terminal device emerging in a future evolved PLMN or the like. This is not limited in embodiments of this application.

In addition, in embodiments of this application, the terminal device may alternatively be a terminal device in an IoT system. IoT is an important part of future information technology development. A main technical feature of IoT is that an article is connected to a network by using a communications technology, to implement an intelligent network of man-machine interconnection and interconnection between things. In embodiments of this application, the IoT technology can implement massive connections, deep coverage, and terminal power saving by using, for example, a narrow band (narrow band, NB) technology.

In addition, in embodiments of this application, the terminal device may alternatively include a sensor such as an intelligent printer, a train detector, or a gas station. Main functions include collecting data (some terminal devices), receiving control information and downlink data from a network device, sending an electromagnetic wave, and transmitting uplink data to the network device.

The network device in embodiments of this application is an entity for transmitting or receiving a signal on a network side. The network device in embodiments of this application may be a device in a radio network, for example, a RAN node for connecting a terminal to the radio network. For example, the network device may be an evolved NodeB (evolved Node B, eNB or e-NodeB) in LTE, a new radio controller (new radio controller, NR controller), a gNodeB (gNB) in a 5G system, a centralized unit (centralized unit, CU), a new radio base station, a remote radio module, a micro base station, a relay (relay), a distributed unit (distributed unit, DU), a home base station, a transmission reception point (transmission reception point, TRP), a transmission point (transmission point, TP), or any other radio access device. However, embodiments of this application are not limited thereto. The network device may cover one or more cells.

A system architecture and a service scenario described in embodiments of this application are intended to describe the technical solutions in embodiments of this application more clearly, and do not constitute any limitation on the technical solutions provided in embodiments of this application. A person of ordinary skill in the art may know that with evolution of the network architecture and emergence of a new service scenario, the technical solutions provided in embodiments of this application are also applicable to similar technical problems.

Network encoding is mainly used in a multicast network, and encoding is performed on an intermediate node to improve an information transmission rate. In network encoding, a transmit end, a receive end, and an intermediate node need to consistently perform encoding/decoding in a same finite field (GF). For example, if a transmit end chooses to perform encoding in a finite field whose order is $2^8$, all intermediate nodes participating in network encoding need to perform recoding in the finite field whose order is $2^8$, and all receive ends need to perform decoding in the finite field whose order is $2^8$. Therefore, all network node devices participating in network encoding need to support an encoding/decoding parameter that is consistent with that of a transmit end and a receive end and that is configured for each stream or each application.

However, when the transmit end, the receive end, and the intermediate node need to consistently perform encoding/decoding in the same finite field, because the intermediate node usually has a limited encoding computing power, a throughput bottleneck is caused.

Then, computing capabilities of terminals are different. Consequently, a multicast or unicast application may fail to be developed. For example, a household device, such as a low-power-consumption IoT device or a television, with a limited computing capability can perform encoding/decoding by using only a finite field with a relatively low order, for example, a finite field whose order is $2^1$, to reduce overheads and computing costs. A device, such as a server, a computer, or a smartphone, with a high computing capability can process encoding/decoding in a finite field higher than $GF(2^8)$. Therefore, when a multicast application is considered, if a transmit end chooses to perform encoding in a finite field such as $GF(2^8)$, all receive ends need to perform decoding in the finite field $GF(2^8)$. A computing capability of a receiving device such as a computer or a smartphone can satisfy a decoding requirement for smooth decoding. However, a device such as a television in a same multicast tree cannot implement decoding because a computing capability is insufficient, and consequently, the multicast application cannot be developed, for example, as shown in FIG. 3. When a unicast application is considered, to eliminate a throughput bottleneck caused due to a limited encoding computing power, an intermediate node usually chooses to perform encoding/decoding in a low-order finite field such as $GF(2^1)$. A transmit end and a receive end also need to perform encoding/decoding in the same finite field (that is, $GF(2^1)$). However, because encoding/decoding performance in $GF(2^1)$ is poor, communication between the transmit end and the receive end cannot satisfy a quality of service (quality of service, QoS) requirement of an upper-layer application, for example, as shown in FIG. 4.

In addition, the intermediate node needs to support an encoding/decoding parameter that is configured for each stream or each application and that is consistent with that of the transmit/receive end. Costs are very high because configuration needs to be performed for each stream or each application, and a configuration on the intermediate node cannot be adjusted in a timely manner to adapt to a requirement of each stream or each application and a change in finite field selection. For example, if it is found that an intermediate node 1 is faulty, switching to another path is required, and a finite field configuration of a transmit/receive end and an intermediate node 2 on the another path needs to be renegotiated, resulting in a high path switching latency.

Based on this, embodiments of this application provide a network encoding method and apparatus, to resolve a problem of poor data transmission performance. The method and an apparatus are based on a same inventive concept. Because the method and the apparatus have a similar problem-resolving principle, for implementations of the apparatus and the method, refer to each other, and no repeated description is provided.

It should be understood that, in embodiments of this application, "at least one" refers to one or more, and "a plurality of" refers to two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between associated objects. At least one of the following items (pieces) or a similar expression thereof indicates any combination of these items, including a single item (piece) or any combination of a plurality of items (pieces). For example, at least one of a, b, or c may represent a, b, c, a and b, a and c, b and c, or a, b, and c, where a, b, and c may be singular or plural.

In addition, it should be understood that in descriptions of this application, terms such as "first" and "second" are merely intended for purposes of description, and should not be understood as an indication or implication of relative importance, cannot be understood as an indication or implication of a sequence, and cannot represent a quantity.

In embodiments of this application, a "first finite field" is a finite field with a lowest order in a network. For example, if a finite field with a lowest order in a current network is $GF(2^1)$, the first finite field may be $GF(2^1)$. If a finite field with a lowest order in the network in future communication development is another finite field, the first finite field may be the another finite field.

In embodiments of this application, a "high-order finite field" is a finite field whose order is higher than that of the first finite field.

The following specifically describes the method in embodiments of this application with reference to the accompanying drawings.

This application provides a network encoding method. The method may be applied to the communications system shown in FIG. 1 or FIG. 2. In the communications system, an intermediate node may exist between a transmit end and a receive end and recode a packet sent by the transmit end. Alternatively, there may be no intermediate node between a transmit end and a receive end. Alternatively, an intermediate node exists between a transmit end and a receive end, but the intermediate node does not perform recoding. This is not specifically limited in this application. The following separately describes methods on a transmit end side, an intermediate node side, and a receive end side.

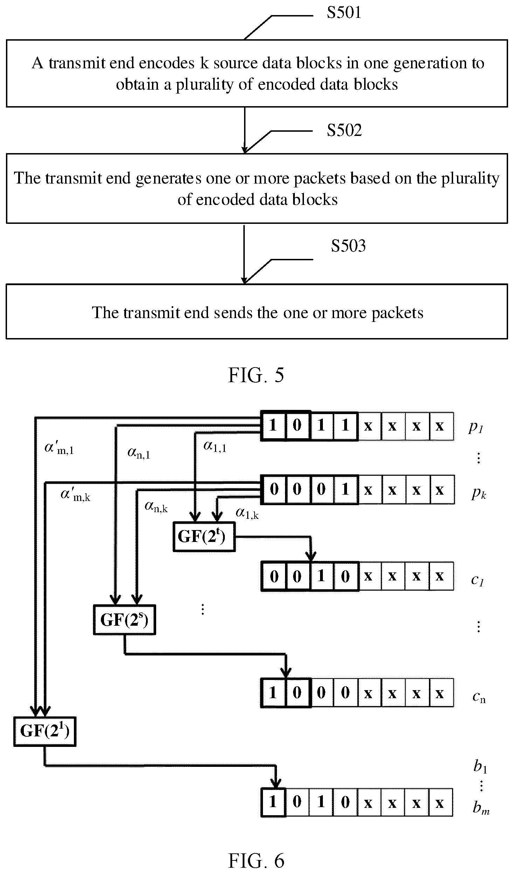

FIG. 5 is a schematic flowchart of a network encoding method according to this application. The method may be applied to a transmit end, and the transmit end may be a communications device, a chip, a chip set, or the like. The method includes the following steps.

S501: The transmit end encodes k source data blocks in one generation (Generation) to obtain a plurality of encoded data blocks, where k is an integer greater than 0, and encoding coefficients used for at least two of the plurality of encoded data blocks correspond to finite fields with different orders.

One generation may include one to-be-encoded sequence, or may include a plurality of to-be-encoded sequences.

In an implementation, when encoding the k source data blocks in one generation to obtain the plurality of encoded data blocks, the transmit end may perform a first encoding operation on the k source data blocks by using a first encoding matrix to obtain the plurality of encoded data blocks. The first encoding matrix includes encoding coefficients of at least two types of finite fields with different orders.

It should be noted that an encoding matrix (for example, the first encoding matrix or a second encoding matrix) in this embodiment of this application may include a plurality of groups of encoding coefficients. One row of elements in the encoding matrix is one group of encoding coefficients, or one column of elements in the encoding matrix is one group of encoding coefficients. When a plurality of data blocks are multiplied by an encoding matrix, the plurality of data blocks may be multiplied by each group of encoding coefficients. For example, if one row of elements in an encoding matrix is one group of encoding coefficients, when the first encoding operation is performed on the k source data blocks by using the first encoding matrix, each row of elements in the first encoding matrix may be multiplied by the k source data blocks. If one column of elements in an encoding matrix is one group of encoding coefficients, when the first encoding operation is performed on the k source data blocks by using the first encoding matrix, each column of elements in the first encoding matrix may be multiplied by the k source data blocks. For ease of description, the following provides descriptions by using an example in which one row of elements in an encoding matrix is one group of encoding coefficients. It should be understood that, logic in which the transmit end encodes a source data block when one column of elements in an encoding matrix is one group of encoding coefficients is similar to logic in which the transmit end encodes a source data block when one row of elements in an encoding matrix is one group of encoding coefficients.

Further, the transmit end may generate h1 packets based on the k source data blocks, and send the h1 packets. Each of the h1 packets carries at least one source data block and an encoding coefficient corresponding to the source data block, encoding coefficients corresponding to the k source data blocks form a k×k matrix in which diagonal elements are 1 and elements other than the diagonal elements are 0, elements in any row in the matrix are k encoding coefficients corresponding to one of the k source data blocks, and h1 is an integer greater than 0 and not greater than k.

In other words, data blocks output by the transmit end include the plurality of encoded data blocks obtained by encoding the k source data blocks in one generation, and may further include the k source data blocks.

In an example description, as shown in FIG. 6, it is assumed that one generation includes k source data blocks $p_1$ to $p_k$, and the transmit end generates a series of encoded data $c_1$, ..., and $c_n$ in different finite fields based on $p_1$ to $p_k$, where $c_1$ is an encoded data block obtained by encoding $p_1$ to $p_k$ in a finite field $GF(2^t)$. To be specific, the transmit end obtains $c_1$ by encoding $p_1$ to $p_k$ by using encoding coefficients $a_{1,1}$ to $a_{1,k}$ in the finite field $GF(2^t)$, where t may be an integer greater than 1. $c_1$ may satisfy the following formula:

$$c_1 = \sum_{j=1}^{k} \alpha_{1,j} p_j$$

Herein, $\alpha_{1,1} \dots \alpha_{1,k}$ are random encoding coefficients in the finite field $GF(2^t)$.

$c_n$ is an encoded data block obtained by encoding $p_1$ to $p_k$ in a finite field $GF(2^s)$. To be specific, the transmit end obtains $c_n$ by encoding $p_1$ to $p_k$ by using encoding coefficients $a_{n,l}$ to $a_{n,k}$ in the finite field $GF(2^s)$, where s may be an integer greater than 1. $c_n$ may satisfy the following formula:

$$c_n = \sum_{j=1}^{k} \alpha_{n,j} p_j$$

Herein, $\alpha_{n,1} \dots \alpha_{n,k}$ are random encoding coefficients in the finite field $GF(2')$.

The transmit end may further generate m pieces of encoded data $b_1$, ..., and $b_m$ in a finite field $GF(2^1)$ based on $p_1$ to $p_k$. To be specific, the transmit end obtains $b_1$ by encoding $p_1$ to $p_k$ by using encoding coefficients $\alpha'_{1,1} \sim \alpha'_{1,k}$ in the finite field $GF(2^1)$, obtains $b_2$ by encoding $p_1$ to $p_k$ by using encoding coefficients $\alpha'_{2,1} \sim \alpha'_{2,k}$ in the finite field $GF(2^1)$, and by analogy, obtains $b_m$ by encoding $p_1$ to $p_k$ by using encoding coefficients $\alpha'_{m,1} \sim \alpha'_{m,k}$ in the finite field $GF(2^1)$. $b_m$ is used as an example, and $b_m$ may satisfy the following formula:

$$b_m = \sum_{j=1}^{k} \alpha'_{m,j} p_j$$

Herein, $\alpha'_{m,1} \ldots \alpha'_{m,k}$ are random encoding coefficients in the finite field $GF(2^1)$.

Data blocks output by the transmit end include $\{p_1 \ldots p_k\} \cup \{c_1 \ldots c_n\} \cup \{b_1 \ldots b_m\}$. For ease of description, the data blocks sent by the transmit end are collectively referred to as "output data blocks" below.

It should be noted that in this embodiment of this application, when the transmit end performs encoding, regardless of a used encoding manner, there may be one or more encoded data blocks in a same finite field. For example, there may be one encoded data block such as $c_1$ or a plurality of encoded data blocks such as $c_1 \ldots c_h$ in the finite field $GF(2^t)$. There may be one encoded data block such as $c_{h+1}$ or a plurality of encoded data blocks such as $c_{h+1} \ldots c_{h+p}$ in the finite field $GF(2^s)$. h and p are integers greater than 1. Unified description is provided herein, and no repeated description is provided below.

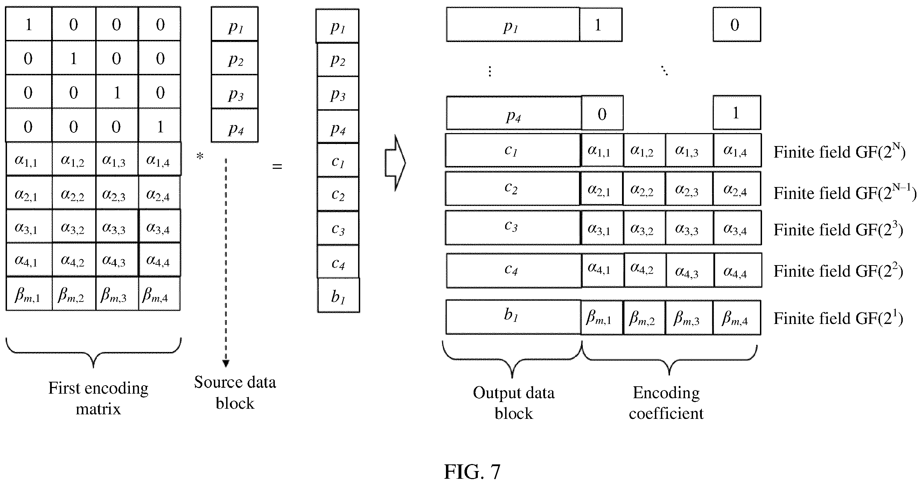

For example, the following provides descriptions by using an example in which one generation includes four source data blocks $p_1$, ..., and $p_4$, the transmit end performs encoding in a finite field $GF(2^N)$, a finite field $GF(2^{N-1})$, a finite field $GF(2^3)$, a finite field $GF(2^2)$, and the finite field $GF(2^1)$, $GF(2^1)$ is a finite field with a lowest order in a network, and one encoded data block is obtained in each finite field, as shown in FIG. 7.

The transmit end multiplies the first encoding matrix by $p_1$ to $p_4$, where the first encoding matrix is a $9\times4$ matrix, and the first row to the fourth row form a $4\times4$ matrix in which diagonal elements are 1 and elements other than the diagonal elements are 0. $p_1$ is obtained by multiplying encoding coefficients in the first row in the first encoding matrix by $p_1$ to $p_4$. $p_2$ is obtained by multiplying encoding coefficients in the second row in the first encoding matrix by $p_1$ to $p_4$. $p_3$ is obtained by multiplying encoding coefficients in the third row in the first encoding matrix by $p_1$ to $p_4$. $p_4$ is obtained by multiplying encoding coefficients in the fourth row in the first encoding matrix by $p_1$ to $p_4$. It should be noted that the encoding coefficients in the first four rows in the first encoding matrix shown in FIG. 7 may alternatively not be multiplied by $p_1$, ..., and $p_4$, but corresponding encoding coefficients are carried when $p_1$ to $p_4$ are sent. For example, the encoding coefficients in the first row in the first encoding matrix are carried when $p_1$ is sent, and the encoding coefficients in the second row in the first encoding matrix are carried when $p_2$ is sent.

The fifth row in the first encoding matrix is a group of encoding coefficients $\{\alpha_{1,1} \ldots \alpha_{1,4}\}$ in the finite field $GF(2^N)$, and $c_1$ is obtained by multiplying the encoding coefficients in the fifth row in the first encoding matrix by $p_1$ to $p_4$. Therefore, a group of encoding coefficients corresponding to $c_1$ is $\{\alpha_{1,1} \ldots \alpha_{1,4}\}$.

The sixth row in the first encoding matrix is a group of encoding coefficients $\{\alpha_{2,1} \ldots \alpha_{2,4}\}$ in the finite field $GF(2^{N-1})$, and $c_2$ is obtained by multiplying the encoding coefficients in the sixth row in the first encoding matrix by $p_1$ to $p_4$. Therefore, a group of encoding coefficients corresponding to $c_2$ is $\{\alpha_{2,1} \ldots \alpha_{2,4}\}$.

The seventh row in the first encoding matrix is a group of encoding coefficients $\{\alpha_{3,1} \ldots \alpha_{3,4}\}$ in the finite field $GF(2')$, and $c_3$ is obtained by multiplying the encoding coefficients in the seventh row in the first encoding matrix by $p_1$ to $p_4$. Therefore, a group of encoding coefficients corresponding to $c_3$ is $\{\alpha_{3,1} \ldots \alpha_{3,4}\}$.

The eighth row in the first encoding matrix is a group of encoding coefficients $\{\alpha_{4,1} \ldots \alpha_{4,4}\}$ in the finite field $GF(2^2)$, and $c_4$ is obtained by multiplying the encoding coefficients in the eighth row in the first encoding matrix by $p_1$ to $p_4$. Therefore, a group of encoding coefficients corresponding to $c_4$ is $\{\alpha_{4,1} \ldots \alpha_{4,4}\}$.

The ninth row in the first encoding matrix is a group of encoding coefficients $\{\beta_{m,1} \ldots \beta_{m,4}\}$ in the finite field $GF(2^1)$. $b_1$ is obtained by multiplying the encoding coefficients in the ninth row in the first encoding matrix by $p_1$ to $p_4$. Therefore, a group of encoding coefficients corresponding to $b_1$ is $\{\beta_{m,1} \ldots \beta_{m,4}\}$.

In this implementation, output data blocks sent by the transmit end include $p_1$ to $p_4$, $c_1$ to $c_4$, and $b_1$. In addition, the encoding coefficients $\{1000\}$ in the first row in the first encoding matrix are carried when $p_1$ is sent, the encoding coefficients $\{0100\}$ in the second row in the first encoding matrix are carried when $p_2$ is sent, the encoding coefficients $\{0010\}$ in the third row in the first encoding matrix are carried when $p_3$ is sent, the encoding coefficients $\{0001\}$ in the fourth row in the first encoding matrix are carried when $p_4$ is sent, the encoding coefficients $\{\alpha_{1,1} \ldots \alpha_{1,4}\}$ in the fifth row in the first encoding matrix are carried when $c_1$ is sent, the encoding coefficients $\{\alpha_{2,1} \ldots \alpha_{2,4}\}$ in the sixth row in the first encoding matrix are carried when $c_2$ is sent, the encoding coefficients $\{\alpha_{3,1} \ldots \alpha_{3,4}\}$ in the seventh row in the first encoding matrix are carried when $c_3$ is sent, the encoding coefficients $\{\alpha_{4,1} \ldots \alpha_{4,4}\}$ in the eighth row in the first encoding matrix are carried when $c_4$ is sent, and the encoding coefficients $\{\beta_{m,1} \ldots \beta_{m,4}\}$ in the ninth row in the first encoding matrix are carried when $b_1$ is sent.

It should be understood that FIG. 7 is merely an example for description, and a location of an encoding coefficient of each finite field in the first encoding matrix is not specifically limited.

In another implementation, when encoding the k source data blocks in one generation to obtain the plurality of encoded data blocks, the transmit end may perform encoding operations in two steps. A plurality of intermediate data blocks are obtained through an encoding operation in a first step, and output data blocks are obtained by encoding the plurality of intermediate data blocks in an encoding operation in a second step.

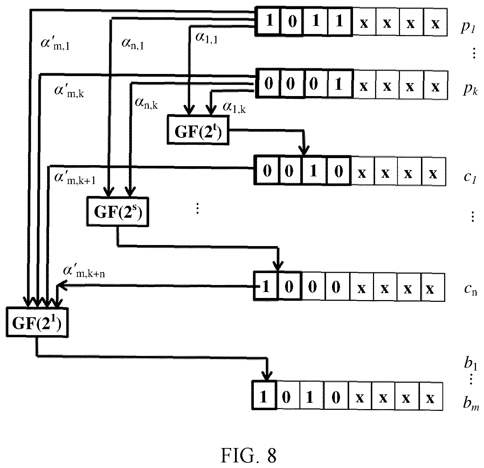

In an example description, as shown in FIG. 8, it is assumed that one generation includes k source data blocks $p_1$ to $p_k$, and the transmit end generates a series of encoded data $c_1$, ..., and $c_n$ in different finite fields based on $p_1$ to $p_k$, where $c_1$ is an encoded data block obtained by encoding $p_1$ to $p_k$ in a finite field $GF(2^t)$. To be specific, the transmit end obtains $c_1$ by encoding $p_1$ to $p_k$ by using encoding coefficients $a_{1,1}$ to $a_{1,k}$ in the finite field $GF(2^t)$, where t may be an integer greater than 1. $c_1$ may satisfy the following formula:

$$c_1 = \sum_{j=1}^{k} \alpha_{1,j} p_j$$

Herein, $\alpha_{1,1}$ ... $\alpha_{1,k}$ are random encoding coefficients in the finite field $GF(2^t)$.

$c_n$ is an encoded data block obtained by encoding $p_1$ to $p_k$ in a finite field $GF(2^s)$. To be specific, the transmit end obtains $c_n$ by encoding $p_1$ to $p_k$ by using encoding coefficients $a_{n,1}$ to $a_{n,k}$ in the finite field $GF(2^s)$, where s may be an integer greater than 1. $c_n$ may satisfy the following formula:

$$c_n = \sum_{j=1}^{k} \alpha_{n,j} p_j$$

Herein, $\alpha_{n,1}$ ... $\alpha_{n,k}$ are random encoding coefficients in the finite field $GF(2')$.

The transmit end may further generate m pieces of encoded data $b_1$, ..., and $b_m$ in a finite field $GF(2^1)$ based on $p_1$ to $p_k$ and $c_1$ to $c_n$. To be specific, the transmit end obtains $b_1$ by encoding $p_1$ to $p_k$ and $c_1$ to $c_n$ by using encoding coefficients $\alpha'_{1,1} \sim \alpha'_{1,k}$ and $\alpha'_{1,k+1} \sim \alpha'_{1,k+n}$ in the finite field $GF(2^1)$, obtains $b_2$ by encoding $p_1$ to $p_k$ and $c_1$ to $c_n$ by using encoding coefficients $\alpha'_{2,1} \sim \alpha'_{2,k}$ and $\alpha'_{2,k+1} \sim \alpha'_{2,k+n}$ in the finite field $GF(2^1)$, and by analogy, obtains $b_m$ by encoding $p_1$ to $p_k$ and $c_1$ to $c_n$ by using encoding coefficients $\alpha'_{m,1} \sim \alpha'_{m,k}$ and $\alpha'_{m,k+1} \sim \alpha'_{m,k+n}$ in the finite field $GF(2^1)$. $b_m$ is used as an example, and $b_m$ may satisfy the following formula:

$$b_m = \sum_{j=1}^{k} \alpha'_{m,j} p_j + \sum_{i=1}^{n} \alpha'_{m,k+i} c_i$$

Herein, $\alpha'_{m,1}$ ... $\alpha'_{m,k}$ ... $\alpha'_{m,k+n}$ are random encoding coefficients in the finite field $GF(2^1)$.

Output data blocks output by the transmit end include $\{p_1...p_k\} U \{c_1 ... c_n\} U \{b_1 ... b_m\}$, or $\{c_1 ... c_n\} U \{b_1 ... b_m\}$, or $\{b_1 ... b_m\}$.

For example, in a possible implementation, when encoding the k source data blocks in one generation to obtain the plurality of encoded data blocks, the transmit end may perform a second encoding operation on the k source data blocks by using a second encoding matrix to obtain $n_1$ encoded data blocks, where $n_1$ is an integer greater than 0. Then, a third encoding operation is performed on the $n_1$ encoded data blocks and the k source data blocks by using a third encoding matrix to obtain m encoded data blocks, where m is an integer greater than 0. In this implementation, output data blocks to be output by the transmit end include the $n_1$ encoded data blocks and the m encoded data blocks.

An order of a finite field corresponding to a first encoding coefficient included in the second encoding matrix is higher than an order of a first finite field, and the first finite field is a finite field with a lowest order in a network. For example, if a finite field with a lowest order in a current network is $GF(2^1)$, the first finite field may be $GF(2^1)$. If a finite field with a lowest order in the network in future communication development is another finite field, the first finite field may be the another finite field. All encoding coefficients included in the third encoding matrix belong to the first finite field.

Further, the transmit end may generate h2 packets based on the k source data blocks, where each of the h2 packets carries at least one source data block and an encoding coefficient corresponding to the source data block, and h2 is an integer greater than 0 and not greater than k.

Encoding coefficients corresponding to the k source data blocks and second encoding coefficients corresponding to the $n_1$ encoded data blocks form a $(k+n_1) \times (k+n_1)$ matrix in which diagonal elements are 1 and elements other than the diagonal elements are 0, elements in any row in the matrix are $k+n_1$ encoding coefficients corresponding to one of the k source data blocks or $k+n_1$ encoding coefficients corresponding to one of the $n_1$ encoded data blocks, and the second encoding coefficient is an encoding coefficient in encoding coefficients corresponding to the $n_1$ encoded data blocks other than the first encoding coefficient used for the second encoding operation.

In other words, output data blocks output by the transmit end include the m encoded data blocks, or include the $n_1$ encoded data blocks and the m encoded data blocks, or may include the k source data blocks, the $n_1$ encoded

data blocks, and the m encoded data blocks. When outputting the output data blocks, the transmit end may send the output data blocks in a manner in which one packet carries one data block, or may send the output data blocks in a manner in which one packet carries a plurality of data blocks. This is not specifically limited herein.

For example, the following provides descriptions by using an example in which one generation includes four source data blocks $p_1$, ..., and $p_4$, the transmit end performs encoding in a finite field $GF(2^N)$, a finite field $GF(2^{N-1})$, a finite field $GF(2^3)$, a finite field $GF(2^2)$, and the finite field $GF(2^1)$, $GF(2^1)$ is a finite field with a lowest order in a network, and one encoded data block is obtained in each finite field.

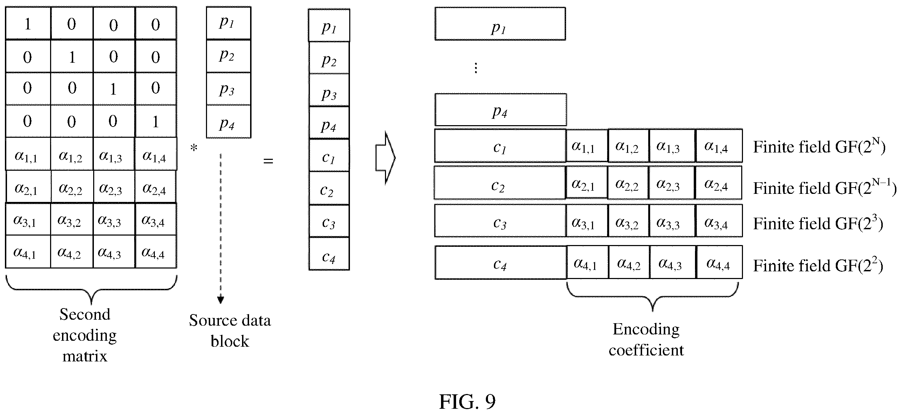

As shown in FIG. 9, a process of the second encoding operation is as follows: The transmit end multiplies the second encoding matrix by $p_1$ to $p_4$, where the second encoding matrix is an $8 \times 4$ matrix, and the first row to the fourth row form a $4 \times 4$ matrix in which diagonal elements are 1 and elements other than the diagonal elements are 0. $p_1$ is obtained by multiplying encoding coefficients in the first row in the second encoding matrix by $p_1$ to $p_4$. $p_2$ is obtained by multiplying encoding coefficients in the second row in the second encoding matrix by $p_1$ to $p_4$. $p_3$ is obtained by multiplying encoding coefficients in the third row in the second encoding matrix by $p_1$ to $p_4$. $p_4$ is obtained by multiplying encoding coefficients in the fourth row in the second encoding matrix by $p_1$ to $p_4$. It should be noted that the encoding coefficients in the first four rows in the second encoding matrix shown in FIG. 9 may alternatively not be multiplied by $p_1$, ..., and $p_4$, or the second encoding matrix does not include the $4 \times 4$ matrix in which diagonal elements are 1 and elements other than the diagonal elements are 0, but encoding is performed based on $p_1$ to $p_4$ during the third encoding operation.

The fifth row in the second encoding matrix is a group of encoding coefficients { $\alpha_{1,1} \ldots \alpha_{1,4}$ } in the finite field $GF(2^N)$, and $c_1$ is obtained by multiplying the encoding coefficients in the fifth row in the second encoding matrix by $p_1$ to $p_4$. Therefore, a group of encoding coefficients corresponding to $c_1$ is $\{\alpha_{1,1} \ldots \alpha_{1,4}\}$.

The sixth row in the second encoding matrix is a group of encoding coefficients { $\alpha_{2,1} \ldots \alpha_{2,4}$} in the finite field $GF(2^{N-1})$, and $c_2$ is obtained by multiplying the encoding coefficients in the sixth row in the second encoding matrix by $p_1$ to $p_4$. Therefore, a group of encoding coefficients corresponding to $c_2$ is $\{\alpha_{2,1} \ldots \alpha_{2,4}\}$.

The seventh row in the second encoding matrix is a group of encoding coefficients { $\alpha_{3,1} \ldots \alpha_{3,4}$ } in the finite field $GF(2')$, and $c_3$ is obtained by multiplying the encoding coefficients in the seventh row in the second encoding matrix by $p_1$ to $p_4$. Therefore, a group of encoding coefficients corresponding to $c_3$ is $\{\alpha_{3,1} \ldots \alpha_{3,4}\}$.

The eighth row in the second encoding matrix is a group of encoding coefficients { $\alpha_{4,1} \ldots \alpha_{4,4}$ } in the finite field $GF(2^2)$, and $c_4$ is obtained by multiplying the encoding coefficients in the eighth row in the second encoding matrix by $p_1$ to $p_4$. Therefore, a group of encoding coefficients corresponding to $c_4$ is $\{\alpha_{4,1} \ldots \alpha_{4,4}\}$.

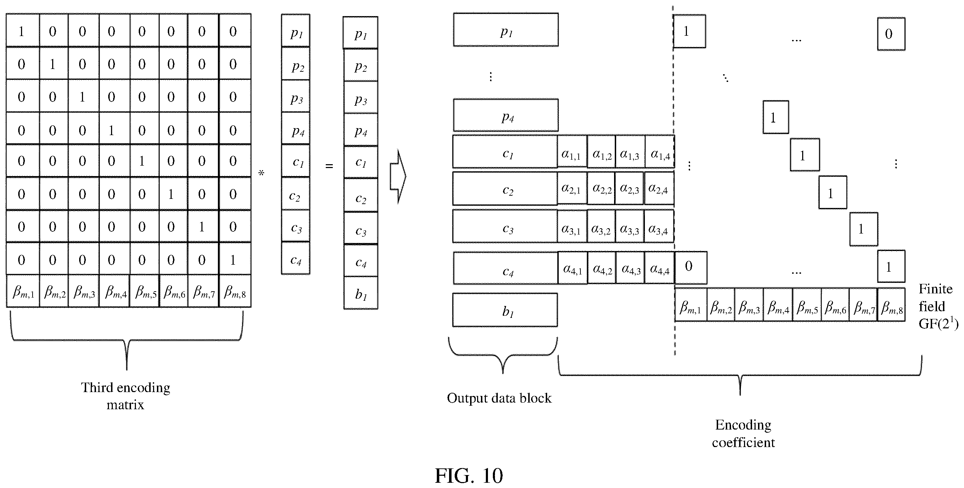

As shown in FIG. 10, a process of the third encoding operation is as follows: The transmit end multiplies the third encoding matrix by $p_1$ to $p_4$ and $c_1$ to $c_4$, where the third encoding matrix is a $9 \times 8$ matrix, and the first row to the eighth row form an $8 \times 8$ matrix in which diagonal elements are 1 and elements other than the diagonal elements are 0. $p_1$ is obtained by multiplying encoding coefficients in the first row in the third encoding matrix by $p_1$ to $p_4$ and $c_1$ to $c_4$. $p_2$ is obtained by multiplying encoding coefficients in the second row in the third encoding matrix by $p_1$ to $p_4$ and $c_1$ to $c_4$. $p_3$ is obtained by multiplying encoding coefficients in the third row in the third encoding matrix by $p_1$ to $p_4$ and $c_1$ to $c_4$. $p_4$ is obtained by multiplying encoding coefficients in the fourth row in the third encoding matrix by $p_1$ to $p_4$ and $c_1$ to $c_4$. $c_1$ is obtained by multiplying encoding coefficients in the fifth row in the third encoding matrix by $p_1$ to $p_4$ and $c_1$ to $c_4$. $c_2$ is obtained by multiplying encoding coefficients in the sixth row in the third encoding matrix by $p_1$ to $p_4$ and $c_1$ to $c_4$. $c_3$ is obtained by multiplying encoding coefficients in the seventh row in the third encoding matrix by $p_1$ to $p_4$ and $c_1$ to $c_4$. $c_4$ is obtained by multiplying encoding coefficients in the eighth row in the third encoding matrix by $p_1$ to $p_4$ and $c_1$ to $c_4$. It should be noted that the encoding coefficients in the first eight rows in the third encoding matrix shown in FIG. 10 may alternatively not be multiplied by $p_1$ to $p_4$ and $c_1$ to $c_4$, but corresponding encoding coefficients are carried when $p_1$ to $p_4$ and $c_1$ to $c_4$ are sent. For example, the encoding coefficients in the first row in the third encoding matrix are carried when $p_1$ is sent, and the encoding coefficients in the second row in the third encoding matrix are carried when $p_2$ is sent.

The ninth row in the third encoding matrix is a group of encoding coefficients $\{\beta_{m,1} \ldots \beta_{m,4}\}$ in the finite field $GF(2^1)$. $b_1$ is obtained by multiplying the encoding coefficients in the ninth row in the third encoding matrix by $p_1$ to $p_4$ and $c_1$ to $c_4$. Therefore, a group of encoding coefficients corresponding to $b_1$ is $\{\beta_{m,1} \ldots \beta_{m,8}\}$.

In this implementation, output data blocks sent by the transmit end include $p_1$ to $p_4$, $c_1$ to $c_4$, and $b_1$. In addition, a group of encoding coefficients carried when $p_1$ is sent is the encoding coefficients { 10000000} in the first row in the third encoding matrix, a group of encoding coefficients carried when $p_2$ is sent is the encoding coefficients {01000000} in the second row in the third encoding matrix, a group of encoding coefficients carried when $p_3$ is sent is the encoding coefficients {00100000} in the third row in the third encoding matrix, and a group of encoding coefficients carried when $p_4$ is sent is the encoding coefficients {00010000} in the fourth row in the third encoding matrix. A group of encoding coefficients carried when $c_1$ is sent is the encoding coefficients { $\alpha_{1,1} \ldots \alpha_{1,4}$ } in the fifth row in the second encoding matrix and the encoding coefficients {00001000} in the fifth row in the third encoding matrix, a group of encoding coefficients carried when $c_2$ is sent is the encoding coefficients $\{\alpha_{2,1} \ldots \alpha_{2,4}\}$ in the sixth row in the second encoding matrix and the encoding coefficients {00000100} in the sixth row in the third encoding matrix, a group of encoding coefficients carried when $c_3$ is sent is the encoding coefficients $\{\alpha_{3,1} \dots \alpha_{3,4}\}$ in the seventh row in the second encoding matrix and the encoding coefficients {00000010} in the seventh row in the third encoding matrix, a group of encoding coefficients carried when $c_4$ is sent is the encoding coefficients $\{\alpha_{4,1} \dots \alpha_{4,4}\}$ in the eighth row in the second encoding matrix and the encoding coefficients { 00000001 } in the eighth row in the third encoding matrix, and a group of encoding coefficients carried when $b_1$ is sent is the encoding coefficients $\{\beta_{m,1} \dots \beta_{m,8}\}$ in the ninth row in the third encoding matrix.

For another example, in another possible implementation, when encoding the k source data blocks in one generation to obtain the plurality of encoded data blocks, the transmit end may perform a fourth encoding operation on the k source data blocks by using a fourth encoding matrix to obtain $n_2$ intermediate data blocks, where $n_2$ is an integer greater than 0. Then, a fifth encoding operation is performed on the nz intermediate data blocks and the k source data blocks by using a fifth encoding matrix to obtain the plurality of encoded data blocks. In this implementation, output data blocks to be output by the transmit end include the encoded data blocks obtained through the fifth encoding operation.

An order of a finite field corresponding to an encoding coefficient included in the fourth encoding matrix is higher than an order of a first finite field, and the first finite field is a finite field with a lowest order in a network. For example, if a finite field with a lowest order in a current network is $GF(2^1)$, the first finite field may be $GF(2^1)$. If a finite field with a lowest order in the network in future communication development is another finite field, the first finite field may be the another finite field. All encoding coefficients included in the fifth encoding matrix belong to the first finite field.

For example, the following provides descriptions by using an example in which one generation includes four source data blocks $p_1$, ..., and $p_4$, the transmit end performs encoding in a finite field $GF(2^N)$, a finite field $GF(2^{N-1})$, a finite field $GF(2^3)$, a finite field $GF(2^2)$, and the finite field $GF(2^1)$, $GF(2^1)$ is a finite field with a lowest order in a network, and one encoded data block is obtained in each finite field.

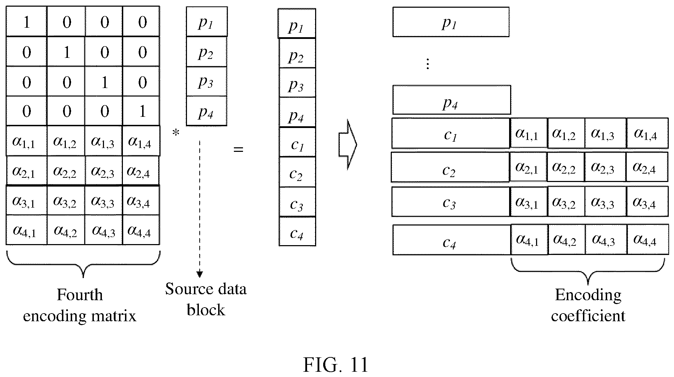

As shown in FIG. 11, a process of the fourth encoding operation is as follows: The transmit end multiplies the fourth encoding matrix by $p_1$ to $p_4$, where the fourth encoding matrix is an $8 \times 4$ matrix, and the first row to the fourth row form a $4 \times 4$ matrix in which diagonal elements are 1 and elements other than the diagonal elements are 0. $p_1$ is obtained by multiplying encoding coefficients in the first row in the fourth encoding matrix by $p_1$ to $p_4$. $p_2$ is obtained by multiplying encoding coefficients in the second row in the fourth encoding matrix by $p_1$ to $p_4$. $p_3$ is obtained by multiplying encoding coefficients in the third row in the fourth encoding matrix by $p_1$ to $p_4$. $p_4$ is obtained by multiplying encoding coefficients in the fourth row in the fourth encoding matrix by $p_1$ to $p_4$. It should be noted that the encoding coefficients in the first four rows in the fourth encoding matrix shown in FIG. 11 may alternatively not be multiplied by p1, ..., and p4, or the fourth encoding matrix does not include the $4 \times 4$ matrix in which diagonal elements are 1 and elements other than the diagonal elements are 0, but encoding is performed based on $p_1$ to $p_4$ during the fourth encoding operation.

The fifth row in the fourth encoding matrix is a group of encoding coefficients $\{ \alpha_{1,1} \dots \alpha_{1,4} \}$ in the finite field $GF(2^N)$, and $c_1$ is obtained by multiplying the encoding coefficients in the fifth row in the fourth encoding matrix by $p_1$ to $p_4$. Therefore, a group of encoding coefficients corresponding to $c_1$ is $\{\alpha_{1,1} \dots \alpha_{1,4}\}$.

The sixth row in the fourth encoding matrix is a group of encoding coefficients $\{ \alpha_{2,1} \dots \alpha_{2,4} \}$ in the finite field $GF(2^{N-1})$, and $c_2$ is obtained by multiplying the encoding coefficients in the sixth row in the fourth encoding matrix by $p_1$ to $p_4$. Therefore, a group of encoding coefficients corresponding to $c_2$ is $\{\alpha_{2,1} \dots \alpha_{2,4}\}$.

The seventh row in the fourth encoding matrix is a group of encoding coefficients $\{ \alpha_{3,1} \dots \alpha_{3,4} \}$ in the finite field $GF(2')$, and $c_3$ is obtained by multiplying the encoding coefficients in the seventh row in the fourth encoding matrix by $p_1$ to $p_4$. Therefore, a group of encoding coefficients corresponding to $c_3$ is $\{\alpha_{3,1} \dots \alpha_{3,4}\}$.

The eighth row in the fourth encoding matrix is a group of encoding coefficients $\{ \alpha_{4,1} \dots \alpha_{4,4} \}$ in the finite field $GF(2^2)$, and $c_4$ is obtained by multiplying the encoding coefficients in the eighth row in the fourth encoding matrix by $p_1$ to $p_4$. Therefore, a group of encoding coefficients corresponding to $c_4$ is $\{\alpha_{4,1} \dots \alpha_{4,4}\}$.

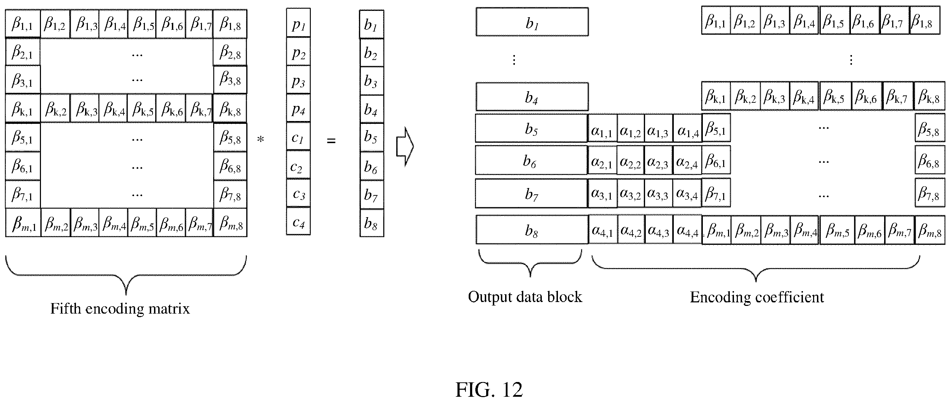

As shown in FIG. 12, a process of the fifth encoding operation is as follows: The transmit end multiplies the fifth encoding matrix by $p_1$ to $p_4$ and $c_1$ to $c_4$, where the fifth encoding matrix is an $8 \times 8$ matrix, and an encoding coefficient included in the fifth encoding matrix belongs to $GF(2^1)$.

Encoding coefficients in the first row in the fifth encoding matrix are a group of encoding coefficients $\{\beta_{1,1} \dots \beta_{1,8}\}$ in the finite field $GF(2^1)$. $b_1$ is obtained by multiplying the encoding coefficients $\{\beta_{1,1} \dots \beta_{1,8}\}$ in the first row in the fifth encoding matrix by $p_1$ to $p_4$ and $c_1$ to $c_4$. Therefore, a group of encoding coefficients corresponding to $b_1$ is $\{\beta_{1,1} \dots \beta_{1,8}\}$.

Encoding coefficients in the second row in the fifth encoding matrix are a group of encoding coefficients $\{\beta_{2,1} \dots \beta_{2,8}\}$ in the finite field $GF(2^1)$. $b_2$ is obtained by multiplying the encoding coefficients $\{\beta_{2,1} \dots \beta_{2,8}\}$ in the second row in the fifth encoding matrix by $p_1$ to $p_4$ and $c_1$ to $c_4$. Therefore, a group of encoding coefficients corresponding to $b_2$ is $\{\beta_{2,1} \dots \beta_{2,8}\}$.

Encoding coefficients in the third row in the fifth encoding matrix are a group of encoding coefficients $\{\beta_{3,1} \dots \beta_{3,8}\}$ in the finite field $GF(2^1)$. $b_3$ is obtained by multiplying the encoding coefficients $\{\beta_{3,1} \dots \beta_{3,8}\}$ in the third row in the fifth encoding matrix by $p_1$ to $p_4$ and $c_1$ to $c_4$. Therefore, a group of encoding coefficients corresponding to $b_3$ is $\{\beta_{3,1} \dots \beta_{3,8}\}$.

Encoding coefficients in the fourth row in the fifth encoding matrix are a group of encoding coefficients $\{\beta_{4,1} \dots \beta_{4,8}\}$ in the finite field $GF(2^1)$. $b_4$ is obtained by multiplying the encoding coefficients $\{\beta_{4,1} \dots \beta_{4,8}\}$ in the fourth row in the fifth encoding matrix by $p_1$ to $p_4$ and $c_1$ to $c_4$. Therefore, a group of encoding coefficients corresponding to $b_4$ is $\{\beta_{4,1} ... \beta_{4,8}\}$.

Encoding coefficients in the fifth row in the fifth encoding matrix are a group of encoding coefficients $\{\beta_{5,1} ... \beta_{5,8}\}$ in the finite field GF($2^1$). $b_5$ is obtained by multiplying the encoding coefficients $\{\beta_{5,1} ... \beta_{5,8}\}$ in the fifth row in the fifth encoding matrix by $p_1$ to $p_4$ and $c_1$ to $c_4$. Therefore, a group of encoding coefficients corresponding to $b_5$ is $\{\beta_{5,1} ... \beta_{5,8}\}$.

Encoding coefficients in the sixth row in the fifth encoding matrix are a group of encoding coefficients $\{\beta_{6,1} ... \beta_{6,8}\}$ in the finite field GF($2^1$). $b_6$ is obtained by multiplying the encoding coefficients $\{\beta_{6,1} ... \beta_{6,8}\}$ in the sixth row in the fifth encoding matrix by $p_1$ to $p_4$ and $c_1$ to $c_4$. Therefore, a group of encoding coefficients corresponding to $b_6$ is $\{\beta_{6,1} ... \beta_{6,8}\}$.

Encoding coefficients in the seventh row in the fifth encoding matrix are a group of encoding coefficients $\{\beta_{7,1} ... \beta_{7,8}\}$ in the finite field GF($2^1$). $b_7$ is obtained by multiplying the encoding coefficients $\{\beta_{7,1} ... \beta_{7,8}\}$ in the seventh row in the fifth encoding matrix by $p_1$ to $p_4$ and $c_1$ to $c_4$. Therefore, a group of encoding coefficients corresponding to $b_7$ is $\{\beta_{7,1} ... \beta_{7,8}\}$.

Encoding coefficients in the eighth row in the fifth encoding matrix are a group of encoding coefficients $\{\beta_{8,1} ... \beta_{8,8}\}$ in the finite field GF($2^1$). $b_8$ is obtained by multiplying the encoding coefficients $\{\beta_{8,1} ... \beta_{8,8}\}$ in the eighth row in the fifth encoding matrix by $p_1$ to $p_4$ and $c_1$ to $c_4$. Therefore, a group of encoding coefficients corresponding to $b_8$ is $\{\beta_{8,1} ... \beta_{8,8}\}$.

In this implementation, output data blocks sent by the transmit end include $b_1$ to $b_8$. In addition, a group of encoding coefficients carried when $b_1$ is sent is the encoding coefficients $\{\beta_{1,1} ... \beta_{1,8}\}$ in the first row in the fifth encoding matrix, a group of encoding coefficients carried when $b_2$ is sent is the encoding coefficients $\{\beta_{2,1} ... \beta_{2,8}\}$ in the second row in the fifth encoding matrix, a group of encoding coefficients carried when $b_3$ is sent is the encoding coefficients $\{\beta_{3,1} ... \beta_{3,8}\}$ in the third row in the fifth encoding matrix, and a group of encoding coefficients carried when $b_4$ is sent is the encoding coefficients $\{\beta_{4,1} ... \beta_{4,8}\}$ in the fourth row in the fifth encoding matrix. A group of encoding coefficients carried when $b_5$ is sent is the encoding coefficients $\{\alpha_{1,1} ... \alpha_{1,4}\}$ in the fifth row in the fourth encoding matrix and the encoding coefficients $\{\beta_{5,1} ... \beta_{5,8}\}$ in the fifth row in the fifth encoding matrix, a group of encoding coefficients carried when be is sent is the encoding coefficients $\{\alpha_{2,1} ... \alpha_{2,4}\}$ in the sixth row in the fourth encoding matrix and the encoding coefficients $\{\beta_{6,1} ... \beta_{6,8}\}$ in the sixth row in the fifth encoding matrix, a group of encoding coefficients carried when $b_7$ is sent is the encoding coefficients $\{a_{3,1} ... a_{3,4}\}$ in the seventh row in the fourth encoding matrix and the encoding coefficients $\{\beta_{7,1} ... \beta_{7,8}\}$ in the seventh row in the fifth encoding matrix, and a group of encoding coefficients carried when $b_8$ is sent is the encoding coefficients $\{\alpha_{4,1} ... \alpha_{4,4}\}$ in the eighth row in the fourth encoding matrix and the encoding coefficients $\{\beta_{8,1} ... \beta_{8,8}\}$ in the eighth row in the fifth encoding matrix.

S502: The transmit end generates one or more packets based on the plurality of encoded data blocks, where each packet carries at least one encoded data block and an encoding coefficient corresponding to the encoded data block.

It should be noted that, in this embodiment of this application, when sending the output data blocks, the transmit end may send the output data blocks in a manner in which one packet carries one data block, or may send the output data blocks in a manner in which one packet carries a plurality of data blocks. This is not specifically limited herein.

For example, the transmit end sends the data blocks in a manner in which one packet carries one output data block. The transmit end may add a packet header to each output data block to form a packet, and add a corresponding encoding coefficient to the packet header or a packet tail for sending together with the packet.

Optionally, the transmit end may further use the packet to carry indication information, and the indication information indicates an order of a finite field corresponding to the output data block carried in the packet. For example, the indication information may be a value of a power corresponding to the finite field. For example, if the order of the finite field is $2^2$, the indication information may be 2.

S503: The transmit end sends the one or more packets.

In this embodiment of this application, the transmit end encodes the source data blocks in a plurality of finite fields, so that a receive end can receive packets in different finite fields. Therefore, the receive end can independently select a finite field for encoding/decoding based on a computing power of the receive end and an application requirement.

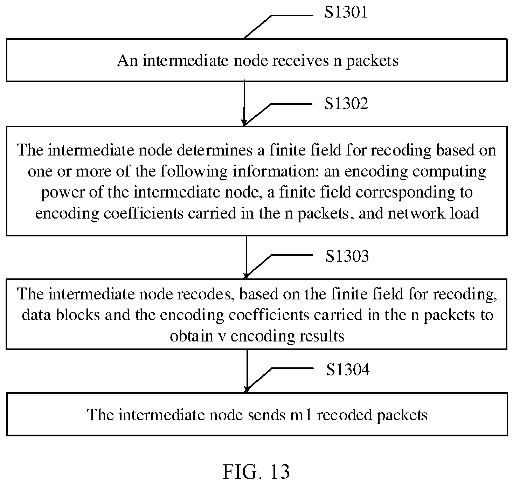

FIG. 13 is a schematic flowchart of a network encoding method according to this application. The method may be applied to an intermediate node, and the intermediate node may be a communications device, a chip, a chip set, or the like. The method includes the following steps.

S1301: The intermediate node receives n packets, where n is an integer greater than 1, one packet carries $a_1$ data blocks and encoding coefficients corresponding to the $a_1$ data blocks, $a_1$ is an integer greater than 0, and encoding coefficients carried in the n packets correspond to one or more finite fields.

For example, the intermediate node may receive a packet sent by a previous-hop node, and the previous-hop node may be another intermediate node, or may be a transmit end.

S1302: The intermediate node determines a finite field for recoding based on one or more of the following information: an encoding computing power of the intermediate node, the finite field corresponding to the encoding coefficients carried in the n packets, and network load.

For example, when the intermediate node determines the finite field for recoding based the encoding computing power of the intermediate node, if the encoding computing power of the intermediate node is relatively strong, one or more finite fields with a relatively high order may be determined as finite fields for recoding. If the encoding computing power of the intermediate node is relatively weak, one or more finite fields with a relatively low order may be determined as finite fields for recoding.

When the intermediate node determines the finite field for recoding based on the network load, if the network load is relatively light, one or more finite fields with a relatively high order may be determined as finite fields for recoding. If the network load is relatively heavy, one or more finite fields with a relatively low order may be determined as finite fields for recoding.

When determining the finite field for recoding based on the finite field corresponding to the encoding coefficients carried in the n packets, the intermediate node may determine, as the finite field for recoding, a finite field with a highest order in the finite field corresponding to the encoding coefficients carried in the n packets.

S1303. The intermediate node recodes, based on the finite field for recoding, data blocks and the encoding coefficients carried in the n packets to obtain v encoding results, where v is an integer greater than 0. There are one or more finite fields for recoding.

In some embodiments, the intermediate node may perform, by using a seventh encoding matrix, an encoding operation on the data blocks carried in the n packets to obtain v recoded data blocks; and perform, by using the seventh encoding matrix, an encoding operation on the encoding coefficients carried in the n packets to obtain v groups of recoded encoding coefficients, where one encoding result includes one recoded data block and one group of corresponding recoded encoding coefficients.

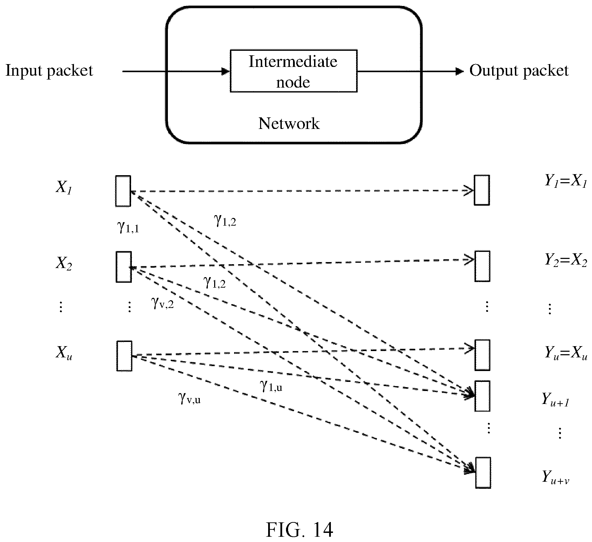

In an implementation, as shown in FIG. 14, it is assumed that packets received by the intermediate node are $X_1$ to $X_u$. One packet may include one data block and an encoding coefficient corresponding to the data block. The intermediate node obtains new packets $Y_{u+1}$ to $Y_{u+v}$ by multiplying $X_1$ to $X_u$ by the seventh encoding matrix. An encoding coefficient included in the seventh encoding matrix belongs to the finite field for recoding. Encoding coefficients in the first row in the seventh encoding matrix may be $\{\gamma_{1,1} ... \gamma_{1,u}\}$, and $Y_{u+1}$ is obtained by multiplying $X_1$ to $X_u$ by $\{\gamma_{1,1} ...\gamma_{1,u}\}$. By analogy, encoding coefficients in the $v^{th}$ row in the seventh encoding matrix may be $\{\gamma_{v,1} ...\gamma_{v,u}\}$, and $Y_{u+v}$ is obtained by multiplying $X_1$ to $X_u$ by $\{\gamma_{v,1} ... \gamma_{v,u}\}$.

$Y_{u+1}$ is used as an example, and $Y_{u+1}$ may satisfy the following formula:

$$Y_{u+1} = \sum_{j=1}^{u} \gamma_{1,j} X_j$$

Herein, $\gamma_{1,1} ...\gamma_{1,u}$ are random encoding coefficients in a finite field $GF(2^t)$. $GF(2^1)$ is the finite field for recoding determined by the intermediate node.

$Y_{u+v}$ is used as an example, and $Y_{u+v}$ may satisfy the following formula:

$$Y_{u+v} = \sum_{j=1}^{u} \gamma_{v,j} X_j$$

Herein, $\gamma_{v,1} ... \gamma_{v,u}$ are random encoding coefficients in a finite field $GF(2^t)$. $GF(2^t)$ is the finite field for recoding determined by the intermediate node.

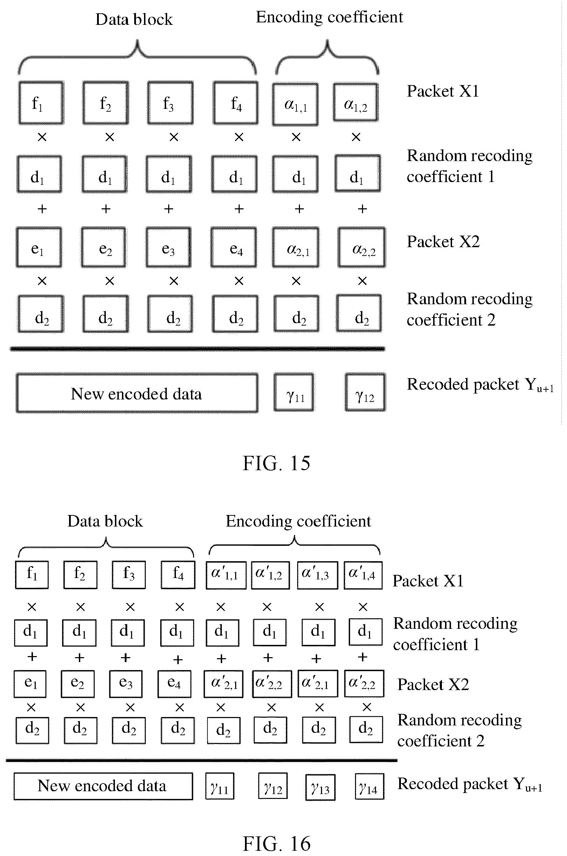

In an example description, it is assumed that u=2 and v=1. If a transmit end outputs packets $X_1$ and $X_2$ in the encoding manner shown in FIG. 6, where data blocks carried in $X_1$ include $f_1$ to $f_4$, encoding coefficients carried in $X_1$ are $\alpha_{1,1}$ and $\alpha_{1,2}$, data blocks carried in $X_2$ include $e_1$ to $e_4$, and encoding coefficients carried in $X_2$ are $\alpha_{2,1}$ and $\alpha_{2,2}$, and the seventh encoding matrix includes a random recoding coefficient 1 and a random recoding coefficient 2, the intermediate node obtains new encoded data and encoding coefficients $\gamma_{11}$ and $\gamma_{12}$ after recoding $X_1$ and $X_2$, as shown in FIG. 15.

Herein, $\gamma_{11} = d_1\alpha_{1,1}+d_2\alpha_{2,1}$, $\gamma_{12} = d_1\alpha_{1,2}+d_2\alpha_{2,2}$, $X_1 = \alpha_{1,1}p_1+\alpha_{1,2}p_2$, and $X_2 = \alpha_{2,1}p_1+\alpha_{2,2}p_2$, where $p_1$ and $p_2$ are source data blocks.

Therefore, $Y_{u+1} = d_1X_1+d_2X_2 = d_1\alpha_{1,1}p_1+d_1\alpha_{1,2}p_2 + d_2\alpha_{2,1}p_1+d_2\alpha_{2,2}p_2 = \gamma_{11} p_1+\gamma_{12} p_2$. It can be learned that the recorded packet $Y_{u+1}$ is a new packet obtained by encoding the source data blocks $p_1$ and $p_2$ by using the random encoding coefficients $\gamma_{11}$ and $\gamma_{12}$. The intermediate network node uses a packet header or a packet tail of the recoded packet $Y_{u+1}$ to carry the encoding coefficients $\gamma_{11}$ and $\gamma_{12}$ of a corresponding field, and sends the recoded packet to a next hop.

For example, $\alpha_{1,1}$ and $\alpha_{1,2}$ belong to the finite field $GF(2^t)$, and $\alpha_{2,1}$ and $\alpha_{2,2}$ belong to a finite field $GF(2')$. If $t \geq s$, random recoding coefficients may be selected for $X_1$ and $X_2$ in the finite field $GF(2^t)$ to perform a finite-field operation.

In a finite field $GF(2^1)$, each packet has a probability of 1/2 of being recoded with another packet to generate a recoded packet. Therefore, in the foregoing manner, recoding is performed in a finite field with a higher order, so that a success rate of recoding can be improved.

In another example description, it is assumed that u=2 and v=1. If a transmit end outputs packets $X_1$ and $X_2$ in the encoding manner shown in FIG. 8, where data blocks carried in $X_1$ include $f_1$ to $f_4$, encoding coefficients carried

in $X_1$ are $\beta_{1,1} ... \beta_{1,4}$, data blocks carried in $X_2$ include $e_1$ to $e_4$, and encoding coefficients carried in $X_2$ are $\beta_{2,1} ... \beta_{2,4}$, and the seventh encoding matrix includes a random recoding coefficient 1 and a random recoding coefficient 2, the intermediate node obtains new encoded data and encoding coefficients $\gamma_{11}, ...,$ and $\gamma_{14}$ after recoding $X_1$ and $X_2$, as shown in FIG. 16.

Herein, $\gamma_{11} = d_1\beta_{1,1} + d_2\beta_{2,1}$, $\gamma_{12} = d_1\beta_{1,2} + d_2\beta_{2,2}$, $\gamma_{13} = d_1\beta_{1,3} + d_2\beta_{2,3}$, $\gamma_{14} = d_1\beta_{1,4} + d_2\beta_{2,4}$, $X_1 = \beta_{1,1}p_1 + \beta_{1,2}p_2 + \beta_{1,3}c_1 + \beta_{1,4}c_2$, and $X_2 = \beta_{2,1}p_1 + \beta_{2,2}p_2 + \beta_{2,3}c_1 + \beta_{2,4}c_2$, where $p_1$ and $p_2$ are source data blocks, and $c_1$ and $c_2$ are intermediate data blocks obtained by performing a fourth encoding operation on $p_1$ and $p_2$ by the transmit end.

Therefore,

$$Y_{u+1} = d_1X_1 + d_2X_2$$

$$= d_1\alpha'_{1,1}p_1 + d_1\alpha'_{1,2}p_2 + d_1\alpha'_{1,3}c_1 + d_1\alpha'_{1,4}c_2$$

$$+ d_2\alpha'_{2,1}p_1 + d_2\alpha'_{2,2}p_2 + d_2\alpha'_{2,3}c_1 + d_2\alpha'_{2,4}c_2$$

$$= \gamma_{11}p_1 + \gamma_{12}p_2 + \gamma_{13}c_1 + \gamma_{14}c_2.$$

It can be learned that the recorded packet $Y_{u+1}$ is a new packet obtained by encoding the source data blocks $p_1$ and $p_2$ and the intermediate data blocks $c_1$ and $c_2$ by using the random encoding coefficients $\gamma_{11}, ...,$ and $\gamma_{14}$. The intermediate network node uses a packet header or a packet tail of the recoded packet $Y_{u+1}$ to carry the encoding coefficients $\gamma_{11}$ and $\gamma_{12}$ of a corresponding field, and sends the recoded packet to a next hop.

S1304: The intermediate node sends m1 recoded packets, where one recoded packet carries at least one encoding result, and m1 is an integer greater than 0 and not greater than v.

In an implementation, when sending the encoding result, the intermediate node may send the encoding result in a manner in which one packet carries one encoding result, or may send the encoding result in a manner in which one packet carries a plurality of encoding results. This is not specifically limited herein.

For example, the intermediate node sends the encoding result in a manner in which one packet carries one encoding result. The intermediate node may add a packet header to each encoding result to form a packet, and then add a corresponding encoding coefficient to the packet header or a packet tail for sending together with the packet.

Optionally, for the encoding result, indication information may be further carried in the packet, and the indication information indicates an order of a finite field for recoding corresponding to the encoding result carried in the packet. For example, the indication information may be a value of a power corresponding to the finite field. For example, if the order of the finite field is $2^2$, the indication information may be 2.

In this embodiment of this application, the intermediate node recodes a packet output by the transmit end, so that the transmit end and the intermediate node can perform distributed encoding. To be specific, the transmit end encodes one part and the intermediate node encodes the other part. In this manner, the transmit end may perform encoding with relatively low complexity, and the intermediate node further recodes the packet output by the transmit end, so that network load can be reduced and transmission efficiency can be improved.

In addition, the intermediate node may determine the finite field for recoding based on the encoding computing power of the intermediate node, a finite field corresponding to an encoding coefficient carried in a received packet, the network load, or the like. For example, the intermediate node receives a multicast packet. A low-computing-power intermediate node may perform recoding in a low-order finite field, then copy a recoded packet, and send the packet to all receive ends that join a multicast group. A high-computing-power intermediate node may perform recoding in a higher-order finite field, then copy a recoded packet, and send the packet to all the receive ends that join the multicast group. Alternatively, when computing load is heavy, the intermediate node may first perform recoding in a low-order finite field. When the computing load becomes lighter, the intermediate node may switch to a higher-order finite field to perform recoding, then copy a recoded packet, and send the packet to all receive ends that join a multicast group.

For another example, the intermediate node receives a unicast packet. A low-computing-power intermediate node may perform recoding in a low-order finite field (for example, $GF(2^1)$), and then send a packet to a receive end. A high-computing-power intermediate node may perform recoding in a higher-order finite field (for example, $GF(2^2)$), and then send a packet to the receive end. Alternatively, when computing load is heavy, the intermediate node may first perform recoding in a low-order finite field (for example, $GF(2^1)$). When the computing load becomes lighter, the intermediate node may switch to a higher-order finite field (for example, $GF(2^4)$) to perform recoding, and then send a packet to a receive end. Alternatively, when load of an intermediate node 1 is heavy, recoding can be performed in only a low-order finite field (for example, $GF(2^1)$), and user's service experience is poor. In this case, switching to a light-load path may be performed. A light-load intermediate node 2 can perform recoding in a higher-order finite field (for example, $GF(2^2)$), so that user's service experience is improved. For another example, if it is found that an intermediate node 1 is faulty, switching to another path is required, and path switching may be directly performed without renegotiating a finite field configuration of a transmit/receive end and an intermediate node 2 on the another path, so that a path switching latency is low.

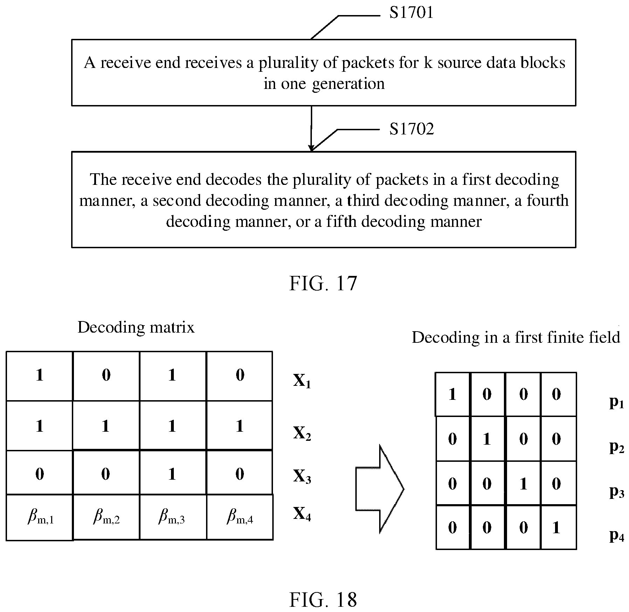

FIG. 17 is a schematic flowchart of a network encoding method according to this application. The method may be applied to a receive end, and the receive end may be a communications device, a chip, a chip set, or the like. The method includes the following steps.

S1701: The receive end receives a plurality of packets for k source data blocks in one generation, where k is an integer greater than 0, and one packet carries at least one data block and a group of encoding coefficients corresponding to each data block.

S1702: The receive end decodes the plurality of packets in a first decoding manner, a second decoding manner, a third decoding manner, a fourth decoding manner, or a fifth decoding manner.

In an implementation, if a transmit end performs encoding in the manner shown in FIG. 6, the receive end may decode the plurality of packets in the first decoding manner, the second decoding manner, or the third decoding manner.

The first decoding manner is decoding the plurality of packets in a first finite field, and the first finite field is a finite field with a lowest order in a network. For example, if a finite field with a lowest order in a current network is $GF(2^1)$, the first finite field may be $GF(2^1)$. If a finite field with a lowest order in the network in future communication development is another finite field, the first finite field may be the another finite field.

In some embodiments, if the transmit end performs encoding in the manner shown in FIG. 6, in the first decoding manner, the plurality of packets may carry k linearly independent data blocks, and encoding coefficients corresponding to the k data blocks belong to the first finite field.

In an implementation, after the receive end receives the k linearly independent data blocks, if the encoding coefficients corresponding to the k data blocks all belong to the first finite field, the receive end performs decoding in the first decoding manner.

In another implementation, if the receive end performs decoding in the first decoding manner, the receive end may receive k linearly independent data blocks, and encoding coefficients corresponding to the k data blocks all belong to the first finite field.

In a possible implementation, when decoding the plurality of packets in the first decoding manner, the receive end may decode the plurality of packets in the first finite field, so that after decoding, diagonal elements of a decoding matrix are 1, and elements other than the diagonal elements are 0, where elements in any row in the decoding matrix are a group of encoding coefficients corresponding to one data block.

In an example description, it is assumed that the transmit end performs encoding in the manner shown in FIG. 6. For example, the first finite field is $GF(2^1)$, and one generation includes four source data blocks. The receive end may receive four linearly independent data blocks $x_1$ to $x_4$. Four encoding coefficients corresponding to one data block belong to the first finite field, encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

For example, it is assumed that a group of encoding coefficients corresponding to $x_1$ is {1010}, a group of encoding coefficients corresponding to $x_2$ is {1111}, a group of encoding coefficients corresponding to $x_3$ is {0010}, and a group of encoding coefficients corresponding to $x_4$ is $\{\beta_{m,1} ... \beta_{m,4}\}$. The encoding coefficients corresponding to $x_1$ to $x_4$ form a $4 \times 4$ decoding matrix, where the first row in the decoding matrix is 1010, the second row in the decoding matrix is 1111, the third row in the decoding matrix is 0010, and the fourth row in the decoding matrix is $\beta_{m,1} ... \beta_{m,4}$. The receive end performs Gaussian elimination on the decoding matrix in the first finite field. The first row in a decoding matrix obtained after decoding is 1000, the second row in the decoding matrix is 0100, the third row in the decoding matrix is 0010, and the fourth row in the decoding matrix is 0001, as shown in FIG. 18.

The first decoding manner can improve a decoding speed, and the first decoding manner has advantages such as low computing complexity and a high throughput.

The second decoding manner is decoding the plurality of packets in a second finite field, and the second finite field is a finite field with a highest order in finite fields corresponding to encoding coefficients carried in the plurality of packets.

In some embodiments, in the second decoding manner, the plurality of packets may carry k linearly independent data blocks, and encoding coefficients corresponding to the k data blocks belong to two or more finite fields.

In an implementation, after the receive end receives the k linearly independent data blocks, if the encoding coefficients corresponding to the k data blocks belong to two or more finite fields, the receive end performs decoding in the second decoding manner.

In a possible implementation, when decoding the plurality of packets in the second decoding manner, the receive end may decode the plurality of packets in a second finite field, so that after decoding, diagonal elements of a decoding matrix are 1, and elements other than the diagonal elements are 0, where elements in any row in the decoding matrix are a group of encoding coefficients corresponding to one data block.

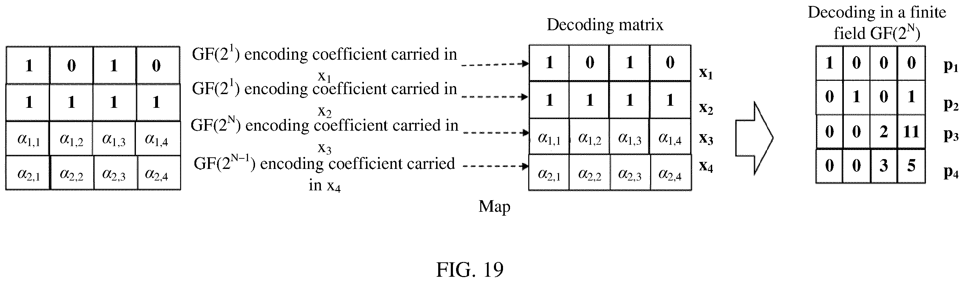

In an example description, for example, one generation includes four source data blocks. The receive end may receive four linearly independent data blocks $x_1$ to $x_4$, where four encoding coefficients corresponding to $x_1$ belong to $GF(2^1)$, four encoding coefficients corresponding to $x_2$ belong to $GF(2^1)$, four encoding coefficients corresponding to $x_3$ belong to a finite field $GF(2^N)$, and four encoding coefficients corresponding to $x_4$ belong to a finite field $GF(2^{N-1})$. The encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block, as shown in FIG. 19. The receive end performs a Gaussian elimination operation on the decoding matrix in the finite field $GF(2^N)$, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

Because k>>n actually, most coefficients in the decoding matrix are encoding coefficients 1 or 0 from the first finite field. Therefore, there are a very small quantity of decoding operations in the second finite field, so that operation complexity in the second finite field can be greatly reduced. For example, as shown in FIG. 19, the receive end may transform the third row and the fourth row of the decoding matrix to obtain $p_1$, $p_2$, $p_3$, and $p_4$.

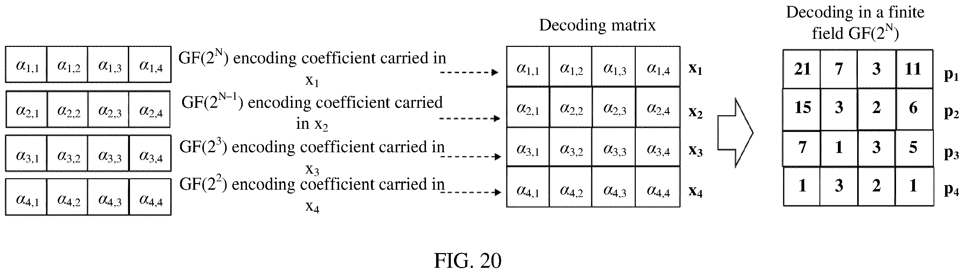

In another example description, for example, one generation includes four source data blocks. The receive end may receive four linearly independent data blocks $x_1$ to $x_4$, where four encoding coefficients corresponding to $x_1$ belong to a finite field $GF(2^N)$, four encoding coefficients corresponding to $x_2$ belong to a finite field $GF(2^{N-1})$, four encoding coefficients corresponding to $x_3$ belong to a finite field $GF(2^3)$, and four encoding coefficients corresponding to $x_4$ belong to a finite field $GF(2^2)$. The encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block, as shown in FIG. 20. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

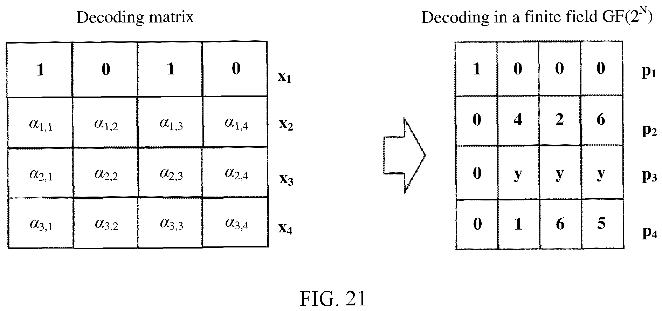

In still another example description, for example, one generation includes four source data blocks. The receive end may receive four linearly independent data blocks $x_1$ to $x_4$, where four encoding coefficients corresponding to $x_1$ belong to a finite field $GF(2^3)$, four encoding coefficients corresponding to $x_2$ belong to a finite field $GF(2^N)$, four encoding coefficients corresponding to $x_3$ belong to a finite field $GF(2^{N-1})$, and four encoding coefficients corresponding to $x_4$ belong to a finite field $GF(2^3)$. The encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block, as shown in FIG. 21. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

For example, if data blocks carried in the plurality of packets belong to M types of high-order finite fields, the second decoding manner may also be referred to as a "hybrid M-field decoder". For example, in FIG. 19, two types of high-order finite fields (that is, a finite field $GF(2^N)$ and a finite field $GF(2^{N-1})$) are mixed. Therefore, a corresponding decoding manner is referred to as a "hybrid 2-field decoder". For another example, in FIG. 20, four types of high-order finite fields (that is, a finite field $GF(2^N)$, a finite field $GF(2^{N-1})$, a finite field $GF(2^3)$, and a finite field $GF(2^2)$) are mixed. Therefore, a corresponding decoding manner may be referred to as a "hybrid 4-field decoder". For another example, in FIG. 21, three types of high-order finite fields (that is, a finite field $GF(2^N)$, a finite field $GF(2^{N-1})$, and a finite field $GF(2^3)$) are mixed. Therefore, a corresponding decoding manner may be referred to as a "hybrid 3-field decoder".

The second decoding manner can improve a decoding speed, and can improve a decoding success rate, so that a balance between the decoding speed and the decoding success rate can be implemented.

The third decoding manner is decoding the plurality of packets in a third finite field, the third finite field is another finite field other than a first finite field in finite fields corresponding to encoding coefficients carried in the plurality of packets, and the first finite field is a finite field with a lowest order in a network.

In some embodiments, in the third decoding manner, the plurality of packets carry k linearly independent data blocks, an encoding coefficient corresponding to at least one of the k data blocks belongs to the first finite field, an encoding coefficient corresponding to another data block other than the at least one data block in the k data blocks belongs to the third finite field, and the third finite field is a finite field different from the first finite field. In other words, in the third decoding manner, the k data blocks belong to two different finite fields, and one of the finite fields is the first finite field.

In an implementation, after the receive end receives the k linearly independent data blocks, if the encoding coefficients corresponding to the k data blocks belong to two different finite fields, and one of the finite fields is the first finite field, the receive end performs decoding in the third decoding manner.

In another implementation, if the receive end performs decoding in the third decoding manner, the receive end may receive k linearly independent data blocks, encoding coefficients corresponding to the k data blocks belong to two different finite fields, and one of the finite fields is the first finite field.

In a possible implementation, when decoding the plurality of packets in the third decoding manner, the receive end may decode the plurality of packets in a third finite field, so that after decoding, diagonal elements of a decoding matrix are 1, and elements other than the diagonal elements are transformed into 0, where elements in any row in the decoding matrix are a group of encoding coefficients corresponding to one data block.

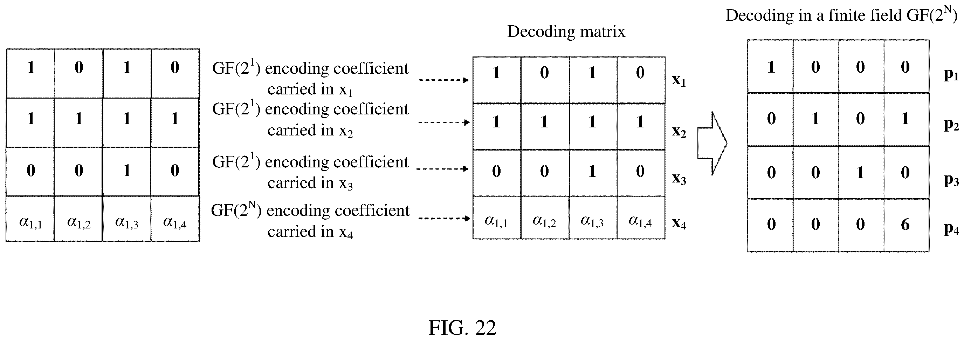

In an example description, for example, one generation includes four source data blocks. The receive end may receive four linearly independent data blocks $x_1$ to $x_4$, where encoding coefficients corresponding to $x_1$ to $x_3$ belong to $GF(2^1)$, and four encoding coefficients corresponding to $x_4$ belong to a finite field $GF(2^N)$. The encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block, as shown in FIG. 22. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

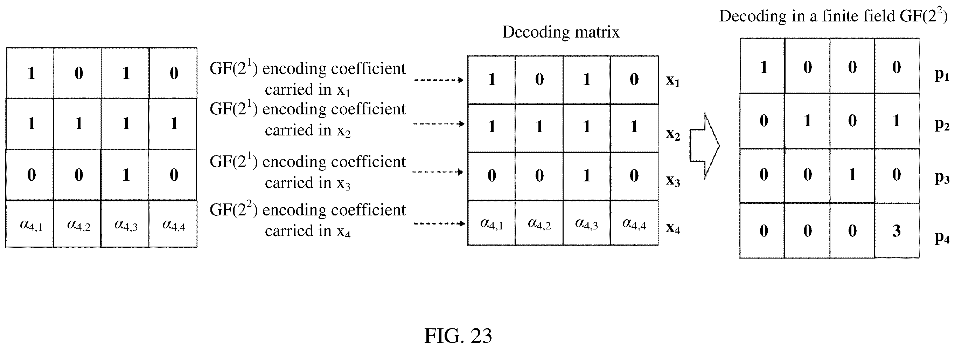

In another example description, for example, one generation includes four source data blocks. The receive end may receive four linearly independent data blocks $x_1$ to $x_4$, where encoding coefficients corresponding to $x_1$ to $x_3$ belong to $GF(2^1)$, and four encoding coefficients corresponding to $x_4$ belong to a finite field $GF(2^2)$. The encoding coefficients corresponding to $x_1$ to $x_4$ form a $4 \times 4$ decoding matrix, and elements in any row in the decoding matrix are a group of encoding coefficients (that is, four corresponding encoding coefficients) corresponding to one data block, as shown in FIG. 23. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_4$ change synchronously by bits, so that $p_1$, $p_2$, $p_3$, and $p_4$ can be obtained through decoding.

In the third decoding manner, an encoding coefficient corresponding to a data block corresponds to only one finite field (that is, the third finite field) other than the first finite field. Because k>>n actually, most coefficients in the decoding matrix are encoding coefficients 1 or 0 from the first finite field. Therefore, there are a very small quantity of decoding operations in the third finite field, so that operation complexity in the third finite field can be greatly reduced. For example, as shown in FIG. 22, the receive end may transform the fourth row of the decoding matrix to obtain $p_1$, $p_2$, $p_3$, and $p_4$. For example, as shown in FIG. 23, the receive end may transform the fourth row of the decoding matrix to obtain $p_1$, $p_2$, $p_3$, and $p_4$.

In some embodiments, the receive end may select a to-be-used decoding manner according to a decoding policy. For example, if the decoding policy is to pursue a high decoding speed, low computing complexity, or a high throughput, the receive end may perform decoding in the first decoding manner. If decoding fails, the receive end performs decoding in the third decoding manner. If decoding still fails, the receive end may perform decoding in the second decoding manner.

For another example, if the decoding policy is to pursue a high decoding success rate or low transmission overheads, the receive end may perform decoding in the second decoding manner.

Optionally, the receive end may receive a packet based on an encoding/decoding computing power of the receive end. For example, if the encoding/decoding computing power of the receive end supports at most a finite field $GF(2^4)$, the receive end may discard a packet in a finite field whose order is higher than $2^4$, and decode packets in the finite field $GF(2^4)$ and a finite field whose order is lower than $2^4$.

If the transmit end performs encoding in the manner shown in FIG. 6, and there are four source data blocks in one generation, features of decoding manners used by the receive end may be shown in Table 1.

**Table 1**

| | Second decoding manner | | | | Third decoding manner | | | Conventional decoding manner | |
|---|---|---|---|---|---|---|---|---|---|
| Finite field for decoding | Second finite field GF $(2^1)$ | Second finite field GF $(2^2)$ | Second finite field GF $(2^3)$ | Second finite field GF $(2^N)$ | Hybrid 2-field | Hybrid 3-field | Hybrid n-field | GF$(2^N)$ | GF$(2^1)$ |
| Quantity of received packets (waiting time) | k=4 | k=4 | k=4 | k=4 | k=4 | k=4 | k=4 | k=4 | k=4 |
| Finite field for decoding | Second finite field GF $(2^1)$ | Second finite field GF $(2^2)$ | Second finite field GF $(2^3)$ | Secon d finite field GF $(2^N)$ | Hybrid 2-field | Hybrid 3-field | Hybrid n-field | GF$(2^N)$ | GF$(2^1)$ |
| Decoding success rate (a higher level indicates a higher success rate) | Level 1 | Level 2 | Level 3 | Level 4 | Level 3 | Level 4 | Level 5 | Level 5 | Level 1 |
| Rank of a final decoding matrix | k=4 | k=4 | k=4 | k=4 | k=4 | k=4 | k=4 | k=4 | k=4 |
| Decoding speed (computing complexity) (a higher level indicates a lower speed) | Level 1 | Level 2 | Level 3 | Level 4 | Level 3 | Level 4 | Level 5 | Level 8 | Level 1 |
| Throughput (a higher level indicates a higher throughput) | Level 8 | Level 5 | Level 4 | Level 3 | Level 4 | Level 3 | Level 2 | Level 1 | Level 8 |

It can be learned from Table 1 that, in this embodiment of this application, both a decoding speed and a decoding success rate can be considered. Compared with the conventional decoding manner, a decoding speed and a throughput in this embodiment of this application are much higher than those in the conventional decoding manner.

In another implementation, if a transmit end performs encoding in the manner shown in FIG. 8, the receive end may decode the plurality of packets in the first decoding manner, the fourth decoding manner, or the fifth decoding manner.

The first decoding manner used by the receive end in a scenario in which the transmit end performs encoding in the manner shown in FIG. 8 is similar to the first decoding manner used by the receive end in a scenario in which the transmit end performs encoding in the manner shown in FIG. 6, except that quantities of received data blocks are different. k linearly independent data blocks are received in the first decoding manner used by the receive end in the scenario in which the transmit end performs encoding in the manner shown in FIG. 6, and k+n linearly independent data blocks are received in the first decoding manner used by the receive end in the scenario in which the transmit end performs encoding in the manner shown in FIG. 8, where n is a quantity of encoded data blocks encoded in a high-order finite field.

In an implementation, after the receive end receives the k+n linearly independent data blocks, if encoding coefficients corresponding to the k+n data blocks all belong to the first finite field, the receive end performs decoding in the first decoding manner.

In another implementation, if the receive end performs decoding in the first decoding manner, the receive end may receive k+n linearly independent data blocks, and encoding coefficients corresponding to the k+n data blocks all belong to the first finite field.

In an example description, it is assumed that the transmit end performs encoding in the manner shown in FIG. 8, and four encoded data blocks are encoded in the high-order finite field. For example, the first finite field is GF$(2^1)$,

and one generation includes four source data blocks. The receive end may receive 4+4, that is, 8, linearly independent data blocks $x_1$ to $x_8$. One data block corresponds to eight encoding coefficients belonging to the first finite field, encoding coefficients corresponding to $x_1$ to $x_8$ form an $8\times8$ decoding matrix, and elements in any row in the decoding matrix are a group of encoding coefficients (that is, eight corresponding encoding coefficients) corresponding to one data block. The receive end performs a Gaussian elimination operation on the decoding matrix, to transform diagonal elements of the decoding matrix into 1 and transform remaining elements into 0. When the decoding matrix is transformed, payloads of the packets $x_1$, ..., and $x_8$ change synchronously by bits, so that $p_1$ to $p_4$ and $c_1$ to $c_4$ can be obtained through decoding.

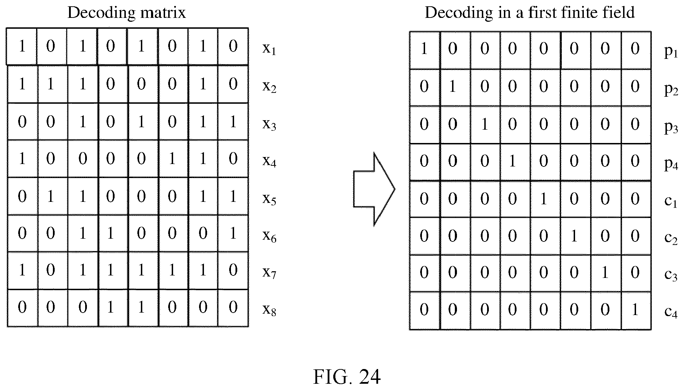

For example, it is assumed that a group of encoding coefficients corresponding to $x_1$ is {10101010}, a group of encoding coefficients corresponding to $x_2$ is {11100010}, a group of encoding coefficients corresponding to $x_3$ is {00101011}, a group of encoding coefficients corresponding to $x_4$ is {10000110}, a group of encoding coefficients corresponding to $x_5$ is {01100011}, a group of encoding coefficients corresponding to $x_6$ is {00110001}, a group of encoding coefficients corresponding to $x_7$ is {10111110}, and a group of encoding coefficients corresponding to $x_8$ is { 00011000}. Encoding coefficients corresponding to $x_1$ to $x_8$ form an $8\times8$ decoding matrix, the first row in the decoding matrix is 10101010, the second row in the decoding matrix is 11100010, the third row in the decoding matrix is 00101011, the fourth row in the decoding matrix is 10000110, the fifth row in the decoding matrix is 01100011, the sixth row in the decoding matrix is 00110001, the seventh row in the decoding matrix is 10111110, and the eighth row in the decoding matrix is 00011000. The receive end performs Gaussian elimination on the decoding matrix. The first row in a decoding matrix obtained after decoding is 10000000, the second row in the decoding matrix is 01000000, the third row in the decoding matrix is 00100000, the fourth row in the decoding matrix is 00010000, the fifth row in the decoding matrix is 00001000, the sixth row in the decoding matrix is 00000100, the seventh row in the decoding matrix is 00000010, and the eighth row in the decoding matrix is 00000001, as shown in FIG. 24.

The fourth decoding manner is decoding the plurality of packets in a first finite field and a fourth finite field, the first finite field is a finite field with a lowest order in a network, the fourth finite field is any high-order finite field corresponding to encoding coefficients carried in the plurality of packets, and the high-order finite field is a finite field whose order is higher than that of the first finite field.

In some embodiments, in the fourth decoding manner, the plurality of packets carry (k-1)+n linearly independent data blocks, an encoding coefficient corresponding to at least one of the (k-1)+n data blocks belongs to the fourth finite field, and n is the quantity of encoded data blocks encoded in the high-order finite field.

In an implementation, after receiving the (k-1)+n linearly independent data blocks, the receive end may perform decoding in the fourth decoding manner.

In another implementation, if the receive end performs decoding in the fourth decoding manner, the receive end may receive (k-1)+n linearly independent data blocks.

In a possible implementation, when decoding the plurality of packets in the fourth decoding manner, the receive end may perform a first decoding operation on the plurality of packets in the first finite field, and then perform a second decoding operation on a result of the first decoding operation in the fourth finite field.

For example, the first decoding operation may be as follows: The first decoding operation is performed on the plurality of packets in the first finite field to obtain a second decoding matrix, so that after the first decoding operation, in a fifth decoding matrix, an element in an $i^{th}$ row and a $j^{th}$ column (that is, an element in an $i^{th}$ row and a $j^{th}$ column of the second decoding matrix) is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column (that is, an element in an $h^{th}$ row and an $(h+1)^{th}$ column in an element in the $h^{th}$ row and a $(k+1)^{th}$ column to an element in the $h^{th}$ row and a $(k+n)^{th}$ column in the second decoding matrix) is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column (that is, another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column in the second decoding matrix) is 0. Elements in any row in the fifth decoding matrix are encoding coefficients belonging to the first finite field in a group of encoding coefficients corresponding to one data block, i={1, 2, ..., and H-n}, j={k+1, k+2, ..., and k+n}, h is an integer greater than H-n and less than H+1, H is a quantity of data blocks carried in the plurality of packets, and n is the quantity of encoded data blocks encoded in the high-order finite field.

The second decoding operation may be as follows: The second decoding operation is performed on the result of the first decoding operation in the fourth finite field, so that after the second decoding operation, diagonal elements of a first decoding matrix are 1, and elements other than the diagonal elements are 0. An upper matrix of the first decoding matrix includes an element in an $i^{th}$ row and a $g^{th}$ column of a second decoding matrix, a lower matrix of the first decoding matrix is a result of performing an operation on an element in a $T^{th}$ row and the $g^{th}$ column of the second decoding matrix and an encoding coefficient belonging to the fourth finite field in encoding coefficients corresponding to the $T^{th}$ row, elements in any row in the second decoding matrix are a result of performing the first decoding operation on an encoding coefficient belonging to the first finite field in a group of encoding coefficients corresponding to one data block, i={1, 2, ..., and H-n}, g={1, 2, ..., and k}, the $T^{th}$ row of the second decoding matrix is a row corresponding to an encoding coefficient in the fourth finite field, H is a quantity of data blocks carried in the plurality of packets, and n is a quantity of encoded data blocks encoded in the high-order finite field.

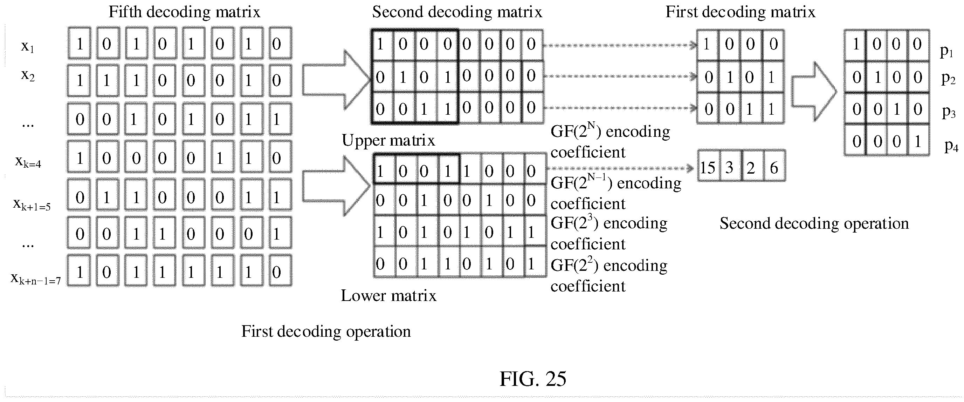

In an example description, it is assumed that the transmit end performs encoding in the manner shown in FIG. 8. For example, the first finite field is $GF(2^1)$, one generation includes four source data blocks, that is, k is equal to 4, the quantity of encoded data blocks encoded in the high-order finite field is 4, that is, n is equal to 4, and high-order finite fields are $GF(2^N)$, $GF(2^{N-1})$, $GF(2^3)$, and $GF(2^2)$. It is assumed that one packet carries one data block. If the fourth finite field is $GF(2^N)$, as shown in FIG. 25, a process in which the receive end performs decoding in the fourth decoding manner may be as follows:

S1: The receive end may receive k-1+n, that is, 7, linearly independent packets $x_1$ to X7.

S2: The receive end forms a fifth decoding matrix by using encoding coefficients that are carried in $x_1$, ..., and $x_7$ and that belong to the finite field $GF(2^1)$, where the fifth decoding matrix is a (k-1+n)×(k+n) matrix, that is, a 7×8 matrix, and elements in any row in the 7×8 matrix are encoding coefficients that are carried in one packet and that belong to the finite field $GF(2^1)$.

S3: The fifth decoding matrix includes an upper matrix and a lower matrix, and the upper matrix is a (k-1)×(k+n) submatrix, that is, a 3×8 submatrix. The lower matrix is an n×(k+n) submatrix in which a value of a lower diagonal element is 1, that is, a 4×8 matrix. The lower diagonal element is an element whose column number is equal to row number + 1 in the fifth decoding matrix. The receive end performs the first decoding operation on the fifth decoding matrix in the finite field $GF(2^1)$ to obtain a second decoding matrix. After the first decoding operation, in the upper matrix of the fifth decoding matrix, elements in first k columns, that is, elements in first four columns, are 0. Specifically, elements in last n columns, that is, last four columns, in the upper matrix may be transformed into 0 through Gaussian elimination by using the lower diagonal element in the lower matrix. It is assumed that a row corresponding to a packet carrying an encoding coefficient in the finite field $GF(2^N)$ is the first row of the lower matrix, that is, the fifth row of the fifth decoding matrix. After the first decoding operation, in the lower matrix of the fifth decoding matrix, a remaining element other than a lower diagonal element in last n elements, that is, last four elements, is transformed into 0 through the decoding operation. Specifically, the remaining element other than the lower diagonal element in the last four elements in the first row of the lower matrix of the fifth decoding matrix may be transformed into 0 through Gaussian elimination by using the lower diagonal element in the lower matrix.

To be specific, elements in the first to third rows and the fifth to eighth columns in the second decoding matrix are 0, and in an element in the fifth row and the fifth column to an element in the fifth row and the eighth column, the element in the fifth row and the fifth column is 1, and the other elements are 0. The fifth row of the second decoding matrix is a row corresponding to a packet carrying an encoding coefficient in the finite field $GF(2^N)$. For example, it is assumed that $x_4$ carries an encoding coefficient in the finite field $GF(2^N)$. After the first decoding operation, the encoding coefficient that is carried in $x_4$ and that is in the finite field $GF(2^N)$ is transformed to the fifth row. During the first decoding operation, payloads of the packets $x_1$, ..., and $x_7$ change synchronously by bits.

S4: The receive end equivalently uses elements in the first to third rows and the first to fourth columns of the second decoding matrix as the first to third rows and the first to fourth columns of the first decoding matrix, performs an operation on elements in the fifth row and the first to fourth columns of the second decoding matrix and encoding coefficients in the finite field $GF(2^N)$ to obtain four elements, and uses the four elements as the fourth row of the first decoding matrix. For example, an addition operation is performed, in the finite field $GF(2^N)$, on the elements in the fifth row and the first to fourth columns of the second decoding matrix and the encoding coefficients in the finite field $GF(2^N)$.

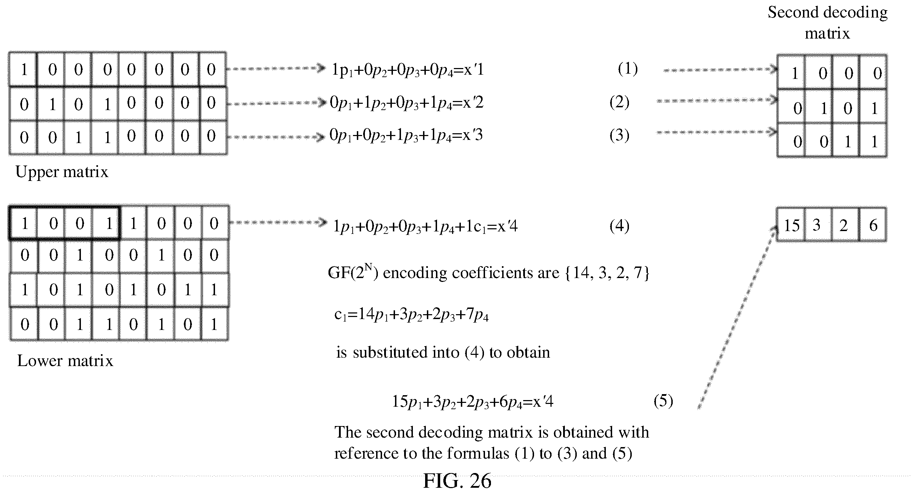

For example, if the elements in the fifth row and the first to fourth columns of the second decoding matrix are 1001, the operation may be represented as follows: $1p_1+0p_2+0p_3+1p_4+1c_1=x'_4$. If the encoding coefficients in the finite field $GF(2^N)$ are {14, 3, 2, 7}, the operation may be represented as follows: If $c_1=14p_1+3p_2+2p_3+7p_4$, $15p_1+3p_2+2p_3+6p_4=x'_4$. Therefore, the elements in the fourth row of the first decoding matrix are {15, 3, 2, 6}, as shown in FIG. 26.

S5: The receive end performs the second decoding operation on the first decoding matrix in the finite field $GF(2^N)$, so that after the second decoding operation, diagonal elements in the first decoding matrix are transformed into 1, and remaining elements are transformed into 0. When the first decoding matrix is transformed, payloads of the packets $x_1$, ..., and $x_7$ change synchronously by n bits, so that $p_1$, $p_2$, $p_3$, and $p_4$ can be obtained through decoding.

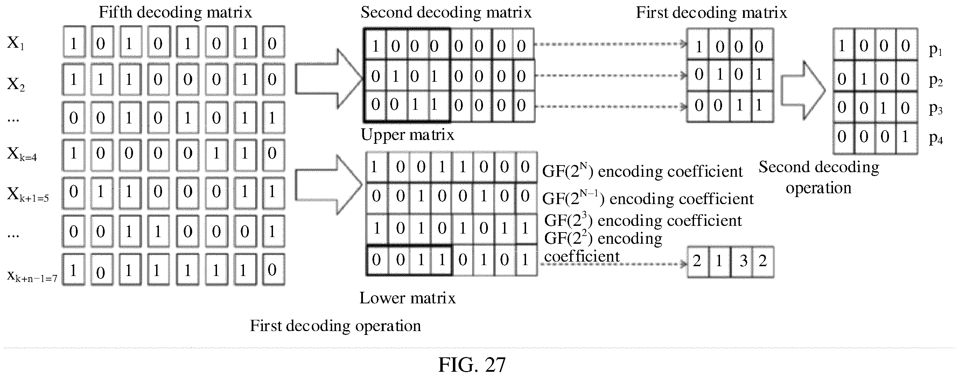

When the fourth finite field is $GF(2^2)$, a process in which the receive end performs decoding in the fourth decoding manner may be shown in FIG. 27. The process in which the receive end performs decoding in the fourth decoding manner when the fourth finite field is $GF(2^2)$ is similar to the process in which the receive end performs decoding in the fourth decoding manner when the fourth finite field is $GF(2^N)$. A difference lies in that the fifth row of the second decoding matrix is selected in step S3 when the fourth finite field is $GF(2^N)$, because the fifth row of the second decoding matrix is a row corresponding to a packet carrying an encoding coefficient in the finite field $GF(2^N)$; but the eighth row of the second decoding matrix is selected in step S3 when the fourth finite field is $GF(2^2)$, because the eighth row of the second decoding matrix is a row corresponding to a packet carrying an encoding coefficient in the finite field $GF(2^2)$. In

addition, an operation is performed on the elements in the fifth row and the first to fourth columns of the second decoding matrix and the encoding coefficients in the finite field $GF(2^N)$ in step S4 when the fourth finite field is $GF(2^N)$, but an operation is performed on elements in the eighth row and the first to fourth columns of the second decoding matrix and encoding coefficients in the finite field $GF(2^2)$ in step S4 when the fourth finite field is $GF(2^2)$; and the second decoding operation is performed in the finite field $GF(2^N)$ in step S5 when the fourth finite field is $GF(2^N)$, but the second decoding operation is performed in the finite field $GF(2^2)$ in step S5 when the fourth finite field is $GF(2^2)$. For details, refer to S1 to S5. No repeated description is provided herein.

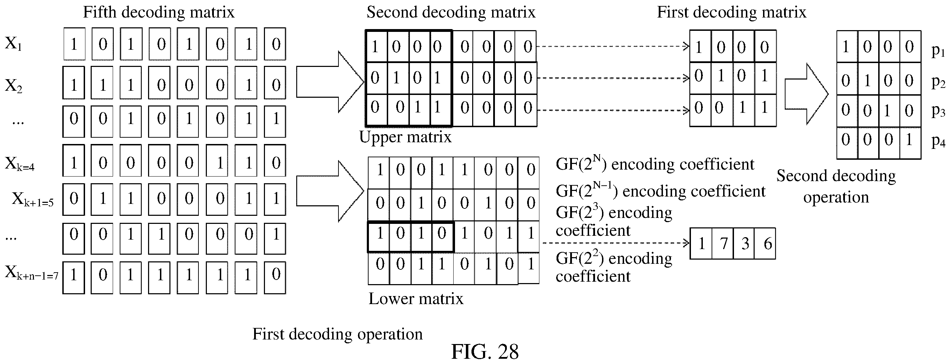

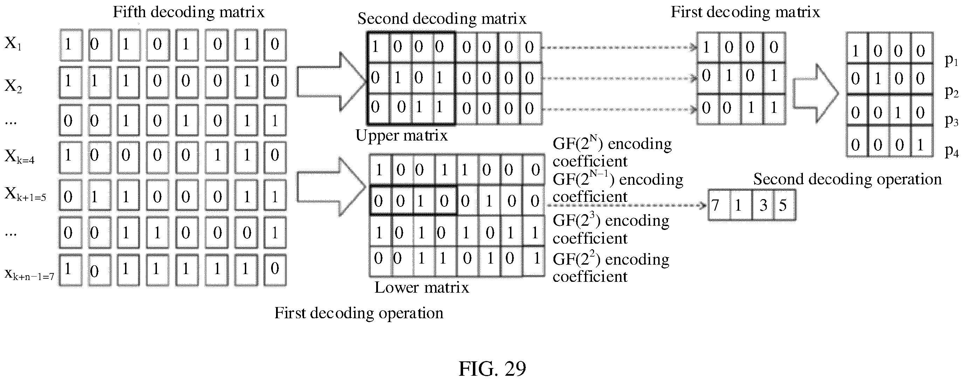

Similar to the foregoing logic, when the fourth finite field is $GF(2^3)$, a process in which the receive end performs decoding in the fourth decoding manner may be shown in FIG. 28. When the fourth finite field is $GF(2^{N-1})$, a process in which the receive end performs decoding in the fourth decoding manner may be shown in FIG. 29.

The fourth decoding manner can improve a decoding speed, and can improve a decoding success rate, so that a balance between the decoding speed and the decoding success rate can be implemented. In addition, an increase in the order of the fourth finite field leads to a higher decoding success rate, and a decrease in the order of the fourth finite field leads to a higher decoding speed.

In addition, most coefficients in the decoding matrix are encoding coefficients 1 or 0 from the first finite field. Therefore, there are a very small quantity of decoding operations in the fourth finite field, so that operation complexity in the fourth finite field can be greatly reduced.

The fifth decoding manner is decoding the plurality of packets in a first finite field and a fifth finite field, the first finite field is a finite field with a lowest order in a network, the fifth finite field is a finite field with a highest order in any t high-order finite fields corresponding to encoding coefficients carried in the plurality of packets, the high-order finite field is a finite field whose order is higher than that of the first finite field, and t is an integer greater than 1.

In some embodiments, in the fifth decoding manner, the plurality of packets carry k+n-t data blocks, encoding coefficients corresponding to the k+n-t data blocks belong to at least t different high-order finite fields, and n is a quantity of encoded data blocks encoded in the high-order finite field.

In an implementation, after receiving k+n-t data blocks, the receive end may perform decoding in the fifth decoding manner, and encoding coefficients corresponding to the k+n-t data blocks belong to at least t different high-order finite fields.

In another implementation, if the receive end performs decoding in the fifth decoding manner, the receive end may receive k+n-t data blocks, and encoding coefficients corresponding to the k+n-t data blocks belong to at least t different high-order finite fields.

In a possible implementation, when decoding the plurality of packets in the fifth decoding manner, the receive end may perform a fourth decoding operation on the plurality of packets in the first finite field, and perform a third decoding operation on a result of the fourth decoding operation in the fifth finite field.

For example, the fourth decoding operation may be as follows: The fourth decoding operation is performed on the plurality of packets in the first finite field to obtain a fourth decoding matrix, so that after the first decoding operation, in a fifth decoding matrix, an element in an $i^{th}$ row and a $j^{th}$ column (that is, an element in an $i^{th}$ row and a $j^{th}$ column of the fourth decoding matrix) is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column (that is, an element in an $h^{th}$ row and an $(h+1)^{th}$ column in an element in the $h^{th}$ row and a $(k+1)^{th}$ column to an element in the $h^{th}$ row and a $(k+n)^{th}$ column in the fourth decoding matrix) is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column (that is, another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column in the fourth decoding matrix) is 0. Elements in any row in the fifth decoding matrix are encoding coefficients belonging to the first finite field in a group of encoding coefficients corresponding to one data block, i={1, 2, ..., and H-n}, j={k+1, k+2, ..., and k+n}, h is any t integers greater than H-n and less than H+1, H is the quantity of data blocks carried in the plurality of packets, and n is the quantity of encoded data blocks encoded in the high-order finite field.

The third decoding operation may be as follows: The third decoding operation is performed on the result of the fourth decoding operation in the fifth finite field, so that after the third decoding operation, diagonal elements of a third decoding matrix are 1, and elements other than the diagonal elements are 0. An upper matrix of the third decoding matrix includes an element in an $i^{th}$ row and a $g^{th}$ column of a fourth decoding matrix, a lower matrix of the first decoding matrix is a result of performing an operation on elements in a $g^{th}$ column of any t rows in an $(H-n+1)^{th}$ row to an $H^{th}$ row of the fourth decoding matrix and an encoding coefficient belonging to the high-order finite field in encoding coefficients corresponding to the any t rows, elements in any row in the fourth decoding matrix are a result of performing the first decoding operation on an encoding coefficient belonging to the first finite field in a group of encoding coefficients corresponding to one data block, i={ 1, 2, ..., and H-n}, g={1, 2, ..., and k}, H is the quantity of data blocks carried in the plurality of packets, and n is the quantity of encoded data blocks encoded in the high-order finite field.

In an example description, it is assumed that the transmit end performs encoding in the manner shown in FIG.

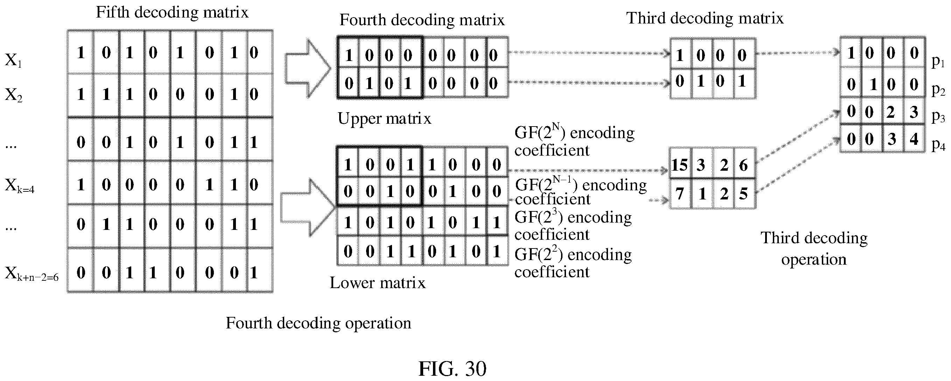

8. For example, the first finite field is $GF(2^1)$, one generation includes four source data blocks, that is, k is equal to 4, the quantity of encoded data blocks encoded in the high-order finite field is 4, that is, n is equal to 4, and high-order finite fields are $GF(2^N)$, $GF(2^{N-1})$, $GF(2^3)$, and $GF(2^2)$. It is assumed that one packet carries one data block. If t is 2, as shown in FIG. 30, a process in which the receive end performs decoding in the fifth decoding manner may be as follows:

A1: The receive end may receive (k-t+n), that is, 6, linearly independent packets $x_1$ to X6.

A2: The receive end forms a fifth decoding matrix by using encoding coefficients that are carried in $x_1$, ..., and $x_6$ and that belong to the finite field $GF(2^1)$, where the fifth decoding matrix is a (k-t+n)×(k+n) matrix, that is, a 6×8 matrix, and elements in any row in the 6×8 matrix are encoding coefficients that are carried in one packet and that belong to the finite field $GF(2^1)$.

A3: The fifth decoding matrix includes an upper matrix and a lower matrix, and the upper matrix is a (k-t)×(k+n) submatrix, that is, a 2×8 submatrix. The lower matrix is an n×(k+n) submatrix in which a value of a lower diagonal element is 1, that is, a 4×8 matrix. The lower diagonal element is an element whose column number is equal to row number + 1 in the fifth decoding matrix. The receive end performs the fourth decoding operation on the fifth decoding matrix in the finite field $GF(2^1)$ to obtain a fourth decoding matrix. After the fourth decoding operation, in the upper matrix of the fifth decoding matrix, elements in first k columns, that is, elements in first four columns, are 0. Specifically, elements in last n columns, that is, last four columns, in the upper matrix may be transformed into 0 through Gaussian elimination by using the lower diagonal element in the lower matrix. Any t rows in the lower matrix of the fifth decoding matrix are selected. It is assumed that first two rows in the lower matrix, that is, the third and fourth rows of the fifth decoding matrix, are selected. After the first decoding operation, in the lower matrix of the fifth decoding matrix, a remaining element other than a lower diagonal element in last k columns, that is, last four columns, of the first two rows is transformed into 0 through the decoding operation. Specifically, the remaining element other than the lower diagonal element in elements in last four columns of the third and fourth rows of the fifth decoding matrix may be transformed into 0 through Gaussian elimination by using the lower diagonal element in the lower matrix.

To be specific, elements in the first and second rows and the fifth to eighth columns of the fourth decoding matrix are 0, and in elements in the third and fourth rows and the fifth to eighth columns of the fourth decoding matrix, an element in the third row and the fifth column and an element in the fourth row and the sixth column are 1, and remaining elements are 0.

A4: The receive end equivalently uses elements in the first and second rows and the first to fourth columns of the fourth decoding matrix as the first and second rows and the first to fourth columns of the third decoding matrix. An operation is performed on elements in the third row and the first to fourth columns of the fourth decoding matrix and encoding coefficients in a corresponding high-order finite field. If the third row of the fourth decoding matrix is a row corresponding to an encoding coefficient in the finite field $GF(2^N)$, an operation is performed on the elements in the third row and the first to fourth columns of the fourth decoding matrix and encoding coefficients in the finite field $GF(2^N)$ to obtain four elements, and the four elements are used as the third row of the third decoding matrix. For example, an addition operation is performed, in the finite field $GF(2^N)$, on the elements in the third row and the first to fourth columns of the fourth decoding matrix and the encoding coefficients in the finite field $GF(2^N)$.

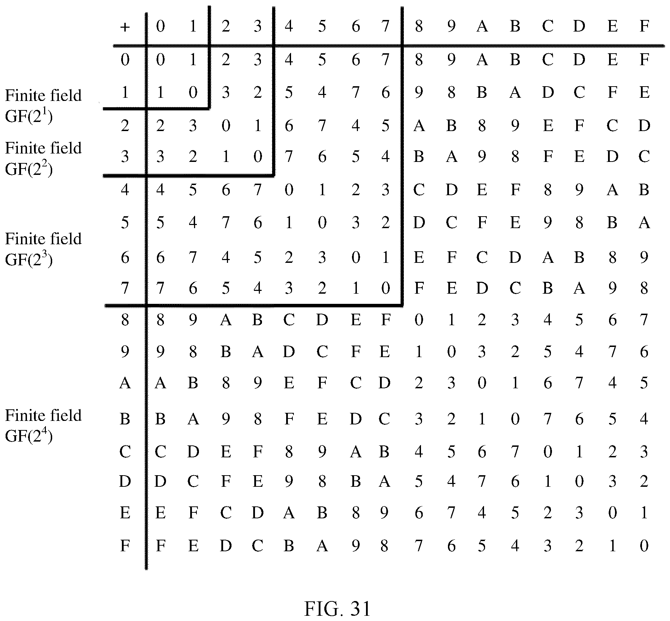

An operation is performed on elements in the fourth row and the first to fourth columns of the fourth decoding matrix and encoding coefficients in a corresponding high-order finite field. If the fourth row of the fourth decoding matrix is a row corresponding to an encoding coefficient in the finite field $GF(2^{N-1})$, an operation is performed on the elements in the fourth row and the first to fourth columns of the fourth decoding matrix and encoding coefficients in the finite field $GF(2^{N-1})$ to obtain four elements, and the four elements are used as the fourth row of the third decoding matrix. For example, an addition operation is performed, in the finite field $GF(2^{N-1})$, on the elements in the fourth row and the first to fourth columns of the fourth decoding matrix and the encoding coefficients in the finite field $GF(2^{N-1})$, and then a result of the addition operation is equivalently transformed into an N-order field. A key technology used herein is that an addition operation in a low-order finite field can be equivalently transformed into an addition operation in a high-order finite field. As shown in FIG. 31, an addition table in the low-order finite field is a nested subset of an addition table in the high-order finite field. That the high-order finite field is $GF(2^1)$ is determined on the basis that a highest-order field carried in a packet corresponding to two selected corresponding rows of the lower matrix is the finite field $GF(2^2)$. Therefore, a 2×k lower matrix is finally obtained through decoding in the finite field $GF(2^2)$.

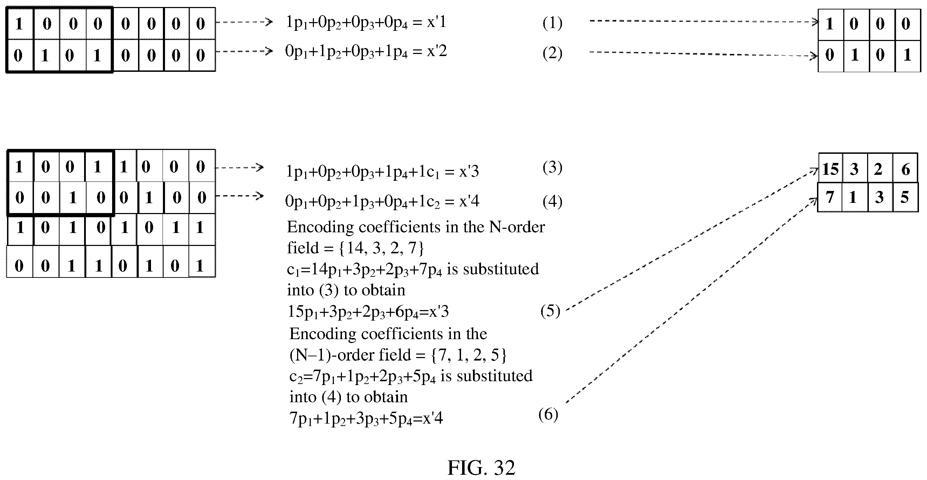

For example, as shown in FIG. 32, for a process of performing an operation on the elements in the third row and the first to fourth columns of the fourth decoding matrix and the encoding coefficients in the finite field $GF(2^N)$, and a process of performing an operation on the elements in the fourth row and the first to fourth columns of the fourth decoding matrix and the encoding coefficients in the finite field $GF(2^{N-1})$, refer to the process of performing an operation on the elements in the fifth row and the first to fourth columns of the second decoding matrix and the encoding coefficients in the finite field $GF(2^N)$ in step S4. Details are not described herein.

A5: Because any two rows selected in step A3 are the third and fourth rows of the fourth decoding matrix, and high-order finite fields corresponding to the third and fourth rows of the fourth decoding matrix are the finite field $GF(2^N)$ and the finite field $GF(2^{N-1})$, where a high-order finite field with a highest order is the finite field $GF(2^N)$, the receive end performs the third decoding operation on the third decoding matrix in the finite field $GF(2^N)$, so that after the second decoding operation, diagonal elements of the first decoding matrix are transformed into 1, and remaining elements are transformed into 0. When the third decoding matrix is transformed, payloads of the packets $x_1$ to $x_6$ change synchronously by n bits, so that $p_1$, $p_2$, $p_3$, and $p_4$ can be obtained through decoding.

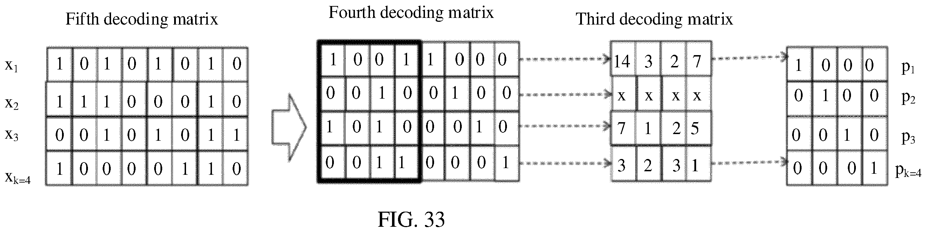

In an example description, it is assumed that the transmit end performs encoding in the manner shown in FIG. 8. For example, the first finite field is $GF(2^1)$, one generation includes four source data blocks, that is, k is equal to 4, the quantity of encoded data blocks encoded in the high-order finite field is 4, that is, n is equal to 4, and high-order finite fields are $GF(2^N)$, $GF(2^{N-1})$, $GF(2^3)$, and $GF(2^2)$. It is assumed that one packet carries one data block. If t is 4, as shown in FIG. 33, a process in which the receive end performs decoding in the fifth decoding manner may be as follows:

B1: The receive end may receive (k-t+n), that is, 4, linearly independent packets $x_1$ to X4.

B2: The receive end forms a fifth decoding matrix by using encoding coefficients that are carried in $x_1$, ..., and $x_4$ and that belong to the finite field $GF(2^1)$, where the fifth decoding matrix is a $(k-t+n) \times (k+n)$ matrix, that is, a $4 \times 8$ matrix, and elements in any row in the $4 \times 8$ matrix are encoding coefficients that are carried in one packet and that belong to the finite field $GF(2^1)$.

B3: When k≤n, there is no upper matrix. When k>n, there is an upper matrix. Therefore, in this example, the fifth decoding matrix includes a lower matrix, where the lower matrix is an $n \times (k+n)$ submatrix, that is, a $4 \times 8$ matrix, in which a value of a lower diagonal element is 1, and the lower diagonal element is an element whose column number is equal to row number + 1 in the fifth decoding matrix. The receive end performs the fourth decoding operation on the fifth decoding matrix in the finite field $GF(2^1)$ to obtain a fourth decoding matrix. After the first decoding operation, in the lower matrix of the fifth decoding matrix, a remaining element other than a lower diagonal element in last k columns, that is, last four columns, of the lower matrix is transformed into 0 through the decoding operation. Specifically, the remaining element other than the lower diagonal element in elements in the last four columns of the lower matrix of the fifth decoding matrix may be transformed into 0 through Gaussian elimination by using the lower diagonal element in the lower matrix.

To be specific, in a matrix including the fifth to eighth rows in the fourth decoding matrix, diagonal elements are 1, and the other elements are 0. During the fourth decoding operation, payloads of the packets $x_1$, ..., and $x_4$ change synchronously by bits.

B4: The receive end performs an operation on the fifth to eighth columns of each row of the fourth decoding matrix and encoding coefficients in a corresponding high-order finite field to obtain one row of elements in the third decoding matrix.

For a process of performing an operation on the fifth to eighth columns of each row of the fourth decoding matrix and the encoding coefficients in the corresponding high-order finite field, refer to the process of performing an operation on the elements in the fifth row and the first to fourth columns of the second decoding matrix and the encoding coefficients in the finite field $GF(2^N)$ in step S4. Details are not described herein.

B5: Because a high-order finite field with a highest order in high-order finite fields corresponding to the first to fourth rows of the fourth decoding matrix is the finite field $GF(2^N)$, the receive end performs the third decoding operation on the third decoding matrix in the finite field $GF(2^N)$, so that after the second decoding operation, diagonal elements in the first decoding matrix are transformed into 1, and remaining elements are transformed into 0. When the third decoding matrix is transformed, payloads of the packets $x_1$ to $x_6$ change synchronously by n bits, so that $p_1$, $p_2$, $p_3$, and $p_4$ can be obtained through decoding.

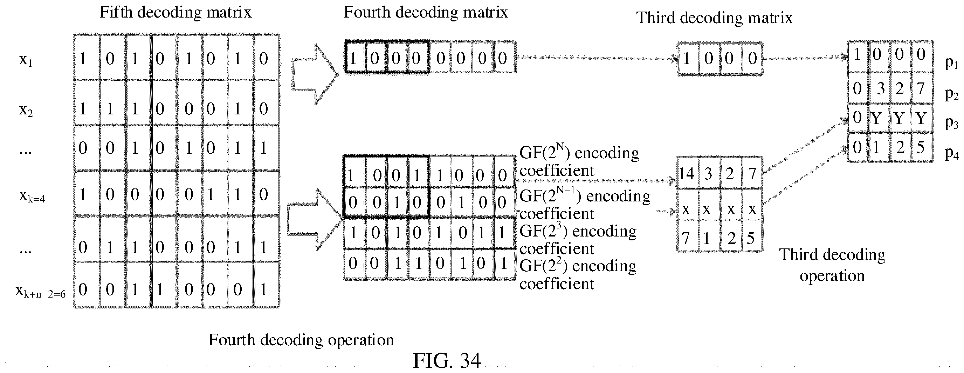

Similar to the foregoing logic, when t is equal to 3, and the fifth finite field is $GF(2^N)$, a process in which the receive end performs decoding in the fifth decoding manner may be shown in FIG. 34.

In the fifth decoding manner, for k=4 source data blocks, only k-t+n packets need to be received to start decoding, so that a latency can be reduced.

In some embodiments, the receive end may select a to-be-used decoding manner according to a decoding policy. For example, if the decoding policy is to pursue a high decoding speed, low computing complexity, or a high throughput, after at least k+n linearly independent data blocks $x_1$, ..., and $x_{k+n}$ are received for the k source data blocks, the first decoding manner may be used. Alternatively, if the decoding policy is to pursue a balance between a decoding speed (computing complexity or a throughput) and a decoding success rate (or transmission overheads), after at least (k-1)+n linearly independent data blocks are received for the k source data blocks, the fourth decoding manner is used. Alternatively, if the decoding policy is to pursue a high decoding success rate or low transmission overheads (that is, a small quantity of encoded packets that need to be received), for k source data blocks in one generation, a fifth decoding manner obtained when t=n may be attempted after at least k linearly independent packets $x_1$, ..., and $x_k$ are received, or a fifth decoding manner obtained when t=n-1 may be attempted after at least k+1 linearly independent packets $x_1$, ...,

and $x_{k+1}$ are received, or a fifth decoding manner obtained when t=3 may be attempted after at least k-3+n linearly independent packets are received, or a fifth decoding manner obtained when t=2 may be attempted after at least k-2+n linearly independent packets are received. A larger value of t indicates a higher decoding success rate and lower transmission overheads.

Optionally, the receive end may receive a packet based on an encoding/decoding computing power of the receive end. For example, if the encoding/decoding computing power of the receive end supports at most a finite field $GF(2^4)$, the receive end may discard a packet in a finite field whose order is higher than $2^4$, and decode packets in the finite field $GF(2^4)$ and a finite field whose order is lower than $2^4$.

If the transmit end performs encoding in the manner shown in FIG. 8, there are four source data blocks in one generation, that is, k=4, and there are four encoded data blocks encoded in the high-order finite field, that is, n is equal to 4, features of decoding manners used by the receive end may be shown in Table 2.

**Table 2**

| | Fourth decoding manner | | | | Fifth decoding manner | | | Conventional decoding manner | |
|---|---|---|---|---|---|---|---|---|---|
| Finite field for decoding | Fourth finite field GF $(2^1)$ | Fourth finite field GF $(2^2)$ | Fourth finite field GF $(2^3)$ | Fourth finite field GF $(2^N)$ | t=2 | t=3 | t=4 | $GF(2^N)$ | $GF(2^3)$ |
| Quantity of received packets (waiting time) | k+n=8 | k-1+n=7 | k-1+n=7 | k-1+n=7 | k+n-t=6 | k+n-t=5 | k+n-t=4 | k=4 | k=4 |
| Decoding success rate (a higher level indicates a higher success rate) | Level 1 | Level 2 | Level 3 | Level 4 | Level 3 | Level 4 | Level 5 | Level 5 | Level 1 |
| Rank of a final decoding matrix | k+n=8 | k=4 | k=4 | k=4 | k=4 | k=4 | k=4 | k=4 | k=4 |
| Decoding speed (computing complexity) (a higher level indicates a lower speed) | Level 1 | Level 2 | Level 3 | Level 4 | Level 3 | Level 4 | Level 5 | Level 8 | Level 1 |
| Throughput (a higher level indicates a higher throughput) | Level 8 | Level 5 | Level 4 | Level 3 | Level 4 | Level 3 | Level 2 | Level 1 | Level 8 |

It can be learned from Table 2 that, in the fourth decoding manner and the fifth decoding manner in this embodiment of this application, a high-order finite field may be used to improve a decoding success rate from a perspective of a decoding success rate or transmission overheads. In addition, from a perspective of a decoding speed or a throughput, most operations are performed in the first finite field in the fourth decoding manner and the fifth decoding manner. Compared with the conventional technology in which operations are performed in a high-order finite field, this embodiment of this application can effectively reduce computing complexity and improve a decoding speed and a throughput. In addition, linear independence is determined in the first finite field, instead of actually switching to a high-order finite field for determining. Therefore, computing complexity can be reduced. Therefore, in this embodiment of this application, with reference to a characteristic that a decoding speed in a low-order field is high and a decoding probability in a high-order field is high, a decoding speed and a throughput can be far greater than those in conventional decoding in a high-order finite-field.

When receiving a unicast packet, the receive end may first perform most decoding in the high-speed first finite field (for example, $GF(2^1)$), and then attempt to switch to a high-order finite field (for example, $GF(2^4)$) to perform remaining decoding, so that a decoding speed and a throughput can be greatly improved. Switching to a high-order finite field is attempted in the first finite field (for example, $GF(2^1)$), instead of actually switching to a high-order finite field for operation. The operation is finally performed in a selected high-order finite field only when the attempt in the first finite field succeeds. Therefore, a total decoding speed does not decrease. For a unicast packet that is sent by the transmit end and that is encoded in a high-order finite field (for example, $GF(2^5)$, $GF(2^6)$, or $GF(2^8)$), the receive end may discard the packet if the receive end does not use the packet.

In embodiments of this application, the transmit end may send a series of hierarchical packets encoded in a finite field with a low order, a finite field with an intermediate order, and a finite field with a high order. The intermediate node may determine a finite field for recoding based on an encoding computing power of the intermediate node, a finite field corresponding to an encoding coefficient carried in a received packet, network load, or the like, without depending on an encoding computing power of a transmit/receive end and a network configuration. The receive end may first perform most decoding in the high-speed first finite field, and then attempt to switch to a high-order finite field to perform remaining decoding.

The transmit/receive end and the intermediate node may perform encoding/decoding in different finite fields, to eliminate a throughput bottleneck of the network node. The intermediate node does not need to perform configuration for each stream or each application, and may adaptively perform recoding based on an encoding computing power of the intermediate node, a finite field corresponding to an encoding coefficient carried in a received packet, network load, or the like. The receive end may independently select a finite field for encoding/decoding based on a computing power of the receive end and an application requirement. In this way, many requirements can be satisfied, and an application encoding requirement and finite field selection can be arbitrarily and independently adjusted at any time.

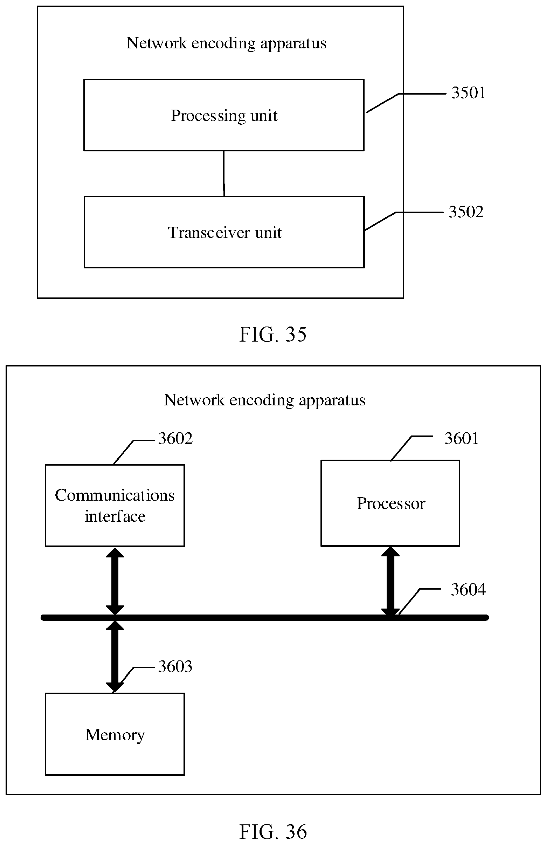

Based on a same technical concept as the method embodiment, an embodiment of this application provides a network encoding apparatus. A structure of the apparatus may be shown in FIG. 35, and includes a processing unit 3501 and a transceiver unit 3502.

In an implementation, the network encoding apparatus may be specifically configured to implement the method performed by the transmit end in the embodiments in FIG. 5 to FIG. 12. The apparatus may be a communications device, or may be a chip or a chip set in the communications device, or a part for performing a related method function in the chip. The processing unit 3501 is configured to: encode k source data blocks in one generation to obtain a plurality of encoded data blocks, where k is an integer greater than 0, and encoding coefficients used for at least two of the plurality of encoded data blocks correspond to finite fields with different orders; and generate one or more packets based on the plurality of encoded data blocks, where each packet carries at least one encoded data block and an encoding coefficient corresponding to the encoded data block. The transceiver unit 3502 is configured to send the one or more packets.

Optionally, when encoding the k source data blocks in one generation to obtain the plurality of encoded data blocks, the processing unit 3501 is specifically configured to perform a first encoding operation on the k source data blocks by using a first encoding matrix to obtain the plurality of encoded data blocks, where the first encoding matrix includes encoding coefficients of at least two types of finite fields with different orders.

The processing unit 3501 may be further configured to generate h1 packets based on the k source data blocks, where each of the h1 packets carries at least one source data block and an encoding coefficient corresponding to the source data block, encoding coefficients corresponding to the k source data blocks form a $k \times k$ matrix in which diagonal elements are 1 and elements other than the diagonal elements are 0, elements in any row in the matrix are k encoding coefficients corresponding to one of the k source data blocks, and h1 is an integer greater than 0 and not greater than k. The transceiver unit 3502 may be further configured to send the h1 packets.

In some embodiments, when encoding the k source data blocks in one generation to obtain the plurality of encoded data blocks, the processing unit 3501 is specifically configured to: perform a second encoding operation on the k source data blocks by using a second encoding matrix to obtain $n_1$ encoded data blocks, where $n_1$ is an integer greater than 0, an order of a finite field corresponding to a first encoding coefficient included in the second encoding matrix is higher than an order of a first finite field, and the first finite field is a finite field corresponding to a third encoding matrix; and perform a third encoding operation on the $n_1$ encoded data blocks and the k source data blocks by using the third encoding matrix to obtain m encoded data blocks, where m is an integer greater than 0, and the plurality of encoded data blocks include the $n_1$ encoded data blocks and the m encoded data blocks.

Optionally, the processing unit 3501 may be further configured to generate h2 packets based on the k source data blocks, where each of the h2 packets carries at least one source data block and an encoding coefficient corresponding to the source data block, and h2 is an integer greater than 0 and not greater than k. Encoding coefficients corresponding to the k source data blocks and second encoding coefficients corresponding to the ni encoded data blocks form a $(k+n_1) \times (k+n_1)$ matrix in which diagonal elements are 1 and elements other than the diagonal elements are 0, elements in any row in the matrix are $k+n_1$ encoding coefficients corresponding to one of the k source data blocks or $k+n_1$ encoding coefficients corresponding to one of the $n_1$ encoded data blocks, and the second encoding coefficient is an encoding coefficient in encoding coefficients corresponding to the $n_1$ encoded data blocks other than the first encoding coefficient used for the second encoding operation. The transceiver unit 3502 may be further configured to send the h2 packets.

In some embodiments, when encoding the k source data blocks in one generation to obtain the plurality of encoded data blocks, the processing unit 3501 may be specifically configured to: perform a fourth encoding operation on the k source data blocks by using a fourth encoding matrix to obtain $n_2$ intermediate data blocks, where $n_2$ is an integer greater than 0, an order of a finite field corresponding to an encoding coefficient included in the fourth encoding matrix is higher than an order of a second finite field, and the second finite field is a finite field corresponding to a fifth encoding matrix; and perform a fifth encoding operation on the $n_2$ intermediate data blocks and the k source data blocks by using the fifth encoding matrix to obtain the plurality of encoded data blocks.

For example, the packet further carries indication information, and the indication information indicates an order of a finite field corresponding to a source data block carried in the packet, or the indication information indicates an order of a finite field corresponding to an encoded data block carried in the packet.

In an implementation, the network encoding apparatus may be specifically configured to implement the method performed by the intermediate node in the embodiments in FIG. 13 to FIG. 16. The apparatus may be an intermediate node, or may be a chip or a chip set in a communications device, or a part for performing a related method function in the chip. The transceiver unit 3502 is configured to receive n packets, where n is an integer greater than 1, one packet carries $a_1$ data blocks and encoding coefficients corresponding to the $a_1$ data blocks, $a_1$ is an integer greater than 0, and encoding coefficients carried in the n packets correspond to one or more finite fields. The processing unit 3501 is configured to: determine a finite field for recoding based on one or more of the following information: an encoding computing power of a network node, the finite field corresponding to the encoding coefficients carried in the n packets, and network load; and recode, based on the finite field for recoding, data blocks and the encoding coefficients carried in the n packets to obtain v encoding results, where v is an integer greater than 0. The transceiver unit 3502 is further configured to send m1 recoded packets, where one recoded packet carries at least one encoding result, and m1 is an integer greater than 0 and not greater than v.

For example, there are one or more finite fields for recoding.

Optionally, when recoding, based on the finite field for recoding, the data blocks and the encoding coefficients carried in the n packets, the processing unit 3501 is specifically configured to: perform, by using a seventh encoding matrix, an encoding operation on the data blocks carried in the n packets to obtain v recoded data blocks, where an encoding coefficient included in the seventh encoding matrix belongs to the finite field for recoding; and perform, by using the seventh encoding matrix, an encoding operation on the encoding coefficients carried in the n packets to obtain v groups of recoded encoding coefficients, where one encoding result includes one recoded data block and one group of corresponding recoded encoding coefficients.

Optionally, when determining the finite field for recoding based on the finite field corresponding to the encoding coefficients carried in the n packets, the processing unit 3501 is specifically configured to determine, as the finite field for recoding, a finite field with a highest order in the finite field corresponding to the encoding coefficients carried in the n packets.

In an implementation, the network encoding apparatus may be specifically configured to implement the method performed by the receive end in the embodiments in FIG. 17 to FIG. 34. The apparatus may be a communications device, or may be a chip or a chip set in the communications device, or a part for performing a related method function in the chip. The transceiver unit 3502 is configured to receive a plurality of packets for k source data blocks in one generation, where k is an integer greater than 0, and one packet carries at least one data block and a group of encoding coefficients corresponding to each data block. The processing unit 3501 is configured to decode the plurality of packets in a first decoding manner, a second decoding manner, a third decoding manner, a fourth decoding manner, or a fifth decoding manner.

The first decoding manner is decoding the plurality of packets in a first finite field, and the first finite field is a finite field with a lowest order in a network. The second decoding manner is decoding the plurality of packets in a second finite field, and the second finite field is a finite field with a highest order in finite fields corresponding to encoding coefficients carried in the plurality of packets. The third decoding manner is decoding the plurality of packets in a third finite field, the third finite field is another finite field other than a first finite field in finite fields corresponding to encoding coefficients carried in the plurality of packets, and the first finite field is a finite field with a lowest order in a network. The fourth decoding manner is decoding the plurality of packets in a first finite field and a fourth finite field, the first finite field is a finite field with a lowest order in a network, the fourth finite field is any high-order finite field corresponding to encoding coefficients carried in the plurality of packets, and the high-order finite field is a finite field whose order is higher than that of the first finite field. The fifth decoding manner is decoding the plurality of packets in a first finite field and a fifth finite field, the first finite field is a finite field with a lowest order in a network, the fifth finite field is a finite field with a highest order in any t high-order finite fields corresponding to encoding coefficients carried in the plurality of packets, the high-order finite field is a finite field whose order is higher than that of the first finite field, and t is an integer greater than 1.

Optionally, when decoding the plurality of packets in the first decoding manner, the processing unit 3501 is specifically configured to decode the plurality of packets in the first finite field, so that after decoding, diagonal elements of a decoding matrix are 1, and elements other than the diagonal elements are 0, where elements in any row in the decoding matrix are a group of encoding coefficients corresponding to one data block.

For example, the plurality of packets carry k data blocks, and encoding coefficients corresponding to the k data blocks belong to the first finite field; or the plurality of packets carry k+n data blocks, a finite field corresponding to encoding coefficients corresponding to the k+n data blocks is the first finite field, n is a quantity of encoded data blocks encoded in a high-order finite field, and the high-order finite field is a finite field whose order is higher than that of the first finite field.

Optionally, when decoding the plurality of packets in the second decoding manner, the processing unit 3501 is specifically configured to decode the plurality of packets in the second finite field, so that after decoding, diagonal elements of a decoding matrix are 1, and elements other than the diagonal elements are 0, where elements in any row in the decoding matrix are a group of encoding coefficients corresponding to one data block.

For example, the plurality of packets carry k data blocks, and encoding coefficients corresponding to the k data blocks belong to two or more finite fields.

Optionally, when decoding the plurality of packets in the third decoding manner, the processing unit 3501 is specifically configured to decode the plurality of packets in the third finite field, so that after decoding, diagonal elements of a decoding matrix are 1, and elements other than the diagonal elements are transformed into 0, where elements in any row in the decoding matrix are a group of encoding coefficients corresponding to one data block.

For example, the plurality of packets carry k data blocks, an encoding coefficient corresponding to at least one of the k data blocks belongs to the first finite field, and an encoding coefficient corresponding to another data block other than the at least one data block in the k data blocks belongs to the third finite field.

Optionally, when decoding the plurality of packets in the fourth decoding manner, the processing unit 3501 is specifically configured to: perform a first decoding operation on the plurality of packets in the first finite field; and perform a second decoding operation on a result of the first decoding operation in the fourth finite field.

Optionally, when performing the second decoding operation on the result of the first decoding operation in the fourth finite field, the processing unit 3501 is specifically configured to perform the second decoding operation on the result of the first decoding operation in the fourth finite field, so that after the second decoding operation, diagonal elements of a first decoding matrix are 1, and elements other than the diagonal elements are 0.

An upper matrix of the first decoding matrix includes an element in an $i^{th}$ row and a $g^{th}$ column of a second decoding matrix, a lower matrix of the first decoding matrix is a result of performing an operation on an element in a $T^{th}$ row and the $g^{th}$ column of the second decoding matrix and an encoding coefficient belonging to the fourth finite field in encoding coefficients corresponding to the $T^{th}$ row, elements in any row in the second decoding matrix are a result of performing the first decoding operation on an encoding coefficient belonging to the first finite field in a group of encoding coefficients corresponding to one data block, i={ 1, 2, ..., and H-n}, g={ 1, 2, ..., and k}, the $T^{th}$ row of the second decoding matrix is a row corresponding to an encoding coefficient in the fourth finite field, H is a quantity of data blocks carried in the plurality of packets, and n is a quantity of encoded data blocks encoded in the high-order finite field.

Optionally, when performing the first decoding operation on the plurality of packets in the first finite field, the processing unit 3501 is specifically configured to perform the first decoding operation on the plurality of packets in the first finite field, so that after the first decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0.

Elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, the $h^{th}$ row of the fifth decoding matrix obtained after the first decoding operation is a row corresponding to the encoding coefficient in the fourth finite field, H is the quantity of data blocks carried in the plurality of packets, and n is the quantity of encoded data blocks encoded in the high-order finite field.

For example, the plurality of packets carry (k-1)+n data blocks, an encoding coefficient corresponding to at least one of the (k-1)+n data blocks belongs to the fourth finite field, and n is the quantity of encoded data blocks encoded in the high-order finite field.

Optionally, when decoding the plurality of packets in the fifth decoding manner, the processing unit 3501 is specifically configured to: perform a fourth decoding operation on the plurality of packets in the first finite field; and perform a third decoding operation on a result of the fourth decoding operation in the fifth finite field.

When performing the third decoding operation on the result of the fourth decoding operation in the fifth finite field, the processing unit 3501 may be specifically configured to:
perform the third decoding operation on the result of the fourth decoding operation in the fifth finite field, so that after the third decoding operation, diagonal elements of a third decoding matrix are 1, and elements other than the diagonal elements are 0.

An upper matrix of the third decoding matrix includes an element in an $i^{th}$ row and a $g^{th}$ column of a fourth decoding matrix, a lower matrix of the first decoding matrix is a result of performing an operation on elements in a $g^{th}$ column of any t rows in an $(H-n+1)^{th}$ row to an $H^{th}$ row of the fourth decoding matrix and an encoding coefficient belonging to the high-order finite field in encoding coefficients corresponding to the any t rows, elements in any row in the fourth decoding matrix are a result of performing the first decoding operation on an encoding coefficient belonging to the first finite field in a group of encoding coefficients corresponding to one data block, i={ 1, 2, ..., and H-n}, g={1, 2, ..., and k}, H is a quantity of data blocks carried in the plurality of packets, and n is a quantity of encoded data blocks encoded in the high-order finite field.

When performing the fourth decoding operation on the plurality of packets in the first finite field, the processing unit 3501 may be specifically configured to perform the fourth decoding operation on the plurality of packets in the first finite field, so that after the fourth decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0.

Elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, h is any t integers greater than H-n and less than H+1, H is the quantity of data blocks carried in the plurality of packets, and n is the quantity of encoded data blocks encoded in the high-order finite field.

For example, the plurality of packets carry k+n-t data blocks, encoding coefficients corresponding to the k+n-t data blocks belong to at least t different high-order finite fields, and n is the quantity of encoded data blocks encoded in the high-order finite field.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The integrated module may be implemented in a form of hardware, or may be implemented in a form of a software functional module. It may be understood that for functions or implementations of the modules in embodiments of this application, further refer to related descriptions in the method embodiments.

In a possible manner, a resource multiplexing apparatus may be shown in FIG. 36. The apparatus may be a first node or a chip in the first node, and the first node may be a communications device, or may be an upper-level node or a donor node of the communications device. The apparatus may include a processor 3601, a communications interface 3602, and a memory 3603. The processing unit 3501 may be the processor 3601. The transceiver unit 3502 may be the communications interface 3602.

The processor 3601 may be a central processing unit (central processing unit, CPU), a digital processing unit, or the like. The communications interface 3602 may be a transceiver, may be an interface circuit such as a transceiver circuit, or may be a transceiver chip or the like. The apparatus further includes the memory 3603, configured to store a program to be executed by the processor 3601. The memory 3603 may be a non-volatile memory, such as a hard disk drive (hard disk drive, HDD) or a solid-state drive (solid-state drive, SSD), or may be a volatile memory (volatile memory), such as a random access memory (random access memory, RAM). The memory 3603 is any other medium that can carry or store expected program code in a form of an instruction structure or a data structure and that can be accessed by a computer, but is not limited thereto.

The processor 3601 is configured to execute program code stored in the memory 3603, and is specifically configured to perform an action of the processing unit 3501. Details are not described again in this application. The communications interface 3602 is specifically configured to perform an action of the transceiver unit 3502. Details are not described again in this application.

A specific connection medium between the communications interface 3602, the processor 3601, and the memory 3603 is not limited in this embodiment of this application. In this embodiment of this application, the memory 3603, the processor 3601, and the communications interface 3602 are connected by using a bus 3604 in FIG. 36. The bus is represented by a bold line in FIG. 36. A connection manner between other components is merely an example for description, and constitutes no limitation. The bus may be classified into an address bus, a data bus, a control bus, and the like. For ease of representation, only one bold line is used for representation in FIG. 36, but this does not mean that there is only one bus or only one type of bus.

An embodiment of the present invention further provides a computer-readable storage medium, configured to store computer software instructions that need to be executed by the foregoing processor, and the computer software instructions include a program that needs to be executed by the foregoing processor.

A person skilled in the art should understand that the embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.

It is clearly that a person skilled in the art can make various modifications and variations to this application without departing from the scope of this application. This application is intended to cover these modifications and variations of this application provided that they fall within the scope of protection defined by the following claims and their equivalent technologies.

**Claims**

1.  A network encoding method, comprising:

    encoding k source data blocks in one generation to obtain a plurality of encoded data blocks, wherein k is an integer greater than 0, and encoding coefficients used for at least two of the plurality of encoded data blocks correspond to finite fields with different orders;
    generating one or more packets based on the plurality of encoded data blocks, wherein each packet carries at least one encoded data block and an encoding coefficient corresponding to the encoded data block; and
    sending the one or more packets.

2.  The method according to claim 1, wherein the encoding k source data blocks in one generation to obtain a plurality of encoded data blocks comprises:
    performing a first encoding operation on the k source data blocks by using a first encoding matrix to obtain the plurality of encoded data blocks, wherein the first encoding matrix comprises encoding coefficients of at least two types of finite fields with different orders.

3.  The method according to claim 2, wherein the method further comprises:

    generating h1 packets based on the k source data blocks, wherein each of the h1 packets carries at least one source data block and an encoding coefficient corresponding to the source data block, encoding coefficients corresponding to the k source data blocks form a $k \times k$ matrix in which diagonal elements are 1 and elements other than the diagonal elements are 0, elements in any row in the matrix are k encoding coefficients corresponding to one of the k source data blocks, and h1 is an integer greater than 0 and not greater than k; and
    sending the h1 packets.

4.  The method according to claim 1, wherein the encoding k source data blocks in one generation to obtain a plurality of encoded data blocks comprises:

    performing a second encoding operation on the k source data blocks by using a second encoding matrix to obtain $n_1$ encoded data blocks, wherein $n_1$ is an integer greater than 0, an order of a finite field corresponding to a first encoding coefficient comprised in the second encoding matrix is higher than an order of a first finite field, and the first finite field is a finite field corresponding to a third encoding matrix; and
    performing a third encoding operation on the $n_1$ encoded data blocks and the k source data blocks by using the third encoding matrix to obtain m encoded data blocks, wherein m is an integer greater than 0, and the plurality of encoded data blocks comprise the $n_1$ encoded data blocks and the m encoded data blocks.

**5.** The method according to claim 4, wherein the method further comprises:

generating h2 packets based on the k source data blocks, wherein each of the h2 packets carries at least one source data block and an encoding coefficient corresponding to the source data block, and h2 is an integer greater than 0 and not greater than k, wherein
encoding coefficients corresponding to the k source data blocks and second encoding coefficients corresponding to the $n_1$ encoded data blocks form a $(k+n_1) \times (k+n_1)$ matrix in which diagonal elements are 1 and elements other than the diagonal elements are 0, elements in any row in the matrix are $k+n_1$ encoding coefficients corresponding to one of the k source data blocks or $k+n_1$ encoding coefficients corresponding to one of the $n_1$ encoded data blocks, and the second encoding coefficient is an encoding coefficient in encoding coefficients corresponding to the $n_1$ encoded data blocks other than the first encoding coefficient used for the second encoding operation; and
sending the h2 packets.

**6.** The method according to claim 1, wherein the encoding k source data blocks in one generation to obtain a plurality of encoded data blocks comprises:

performing a fourth encoding operation on the k source data blocks by using a fourth encoding matrix to obtain $n_2$ intermediate data blocks, wherein $n_2$ is an integer greater than 0, an order of a finite field corresponding to an encoding coefficient comprised in the fourth encoding matrix is higher than an order of a second finite field, and the second finite field is a finite field corresponding to a fifth encoding matrix; and
performing a fifth encoding operation on the nz intermediate data blocks and the k source data blocks by using the fifth encoding matrix to obtain the plurality of encoded data blocks.

**7.** The method according to any one of claims 1 to 6, wherein the packet further carries indication information, and the indication information indicates an order of a finite field corresponding to a source data block carried in the packet, or the indication information indicates an order of a finite field corresponding to an encoded data block carried in the packet.

**8.** A network encoding method, comprising:

receiving n packets, wherein n is an integer greater than 1, one packet carries $a_1$ data blocks and encoding coefficients corresponding to the $a_1$ data blocks, $a_1$ is an integer greater than 0, and encoding coefficients carried in the n packets correspond to one or more finite fields;
determining a finite field for recoding based on one or more of the following information: an encoding computing power of a network node, the finite field corresponding to the encoding coefficients carried in the n packets, and network load;
recoding, based on the finite field for recoding, data blocks and the encoding coefficients carried in the n packets to obtain v encoding results, wherein v is an integer greater than 0; and
sending m1 recoded packets, wherein one recoded packet carries at least one encoding result, and m1 is an integer greater than 0 and not greater than v.

**9.** The method according to claim 8, wherein there are one or more finite fields for recoding.

**10.** The method according to claim 8 or 9, wherein the recoding, based on the finite field for recoding, data blocks and the encoding coefficients carried in the n packets comprises:

performing, by using a seventh encoding matrix, an encoding operation on the data blocks carried in the n packets to obtain v recoded data blocks, wherein an encoding coefficient comprised in the seventh encoding matrix belongs to the finite field for recoding; and
performing, by using the seventh encoding matrix, an encoding operation on the encoding coefficients carried in the n packets to obtain v groups of recoded encoding coefficients, wherein one encoding result comprises one recoded data block and one group of corresponding recoded encoding coefficients.

**11.** The method according to any one of claims 8 to 10, wherein the determining a finite field for recoding based on the finite field corresponding to the encoding coefficients carried in the n packets comprises:
determining, as the finite field for recoding, a finite field with a highest order in the finite field corresponding to the encoding coefficients carried in the n packets.

**12.** A network encoding method, comprising:

receiving a plurality of packets for k source data blocks in one generation, wherein k is an integer greater than 0, and one packet carries at least one data block and a group of encoding coefficients corresponding to each data block; and

decoding the plurality of packets in a first decoding manner, a second decoding manner, a third decoding manner, a fourth decoding manner, or a fifth decoding manner, wherein

the first decoding manner is decoding the plurality of packets in a first finite field, and the first finite field is a finite field with a lowest order in a network;

the second decoding manner is decoding the plurality of packets in a second finite field, and the second finite field is a finite field with a highest order in finite fields corresponding to encoding coefficients carried in the plurality of packets;

the third decoding manner is decoding the plurality of packets in a third finite field, the third finite field is another finite field other than a first finite field in finite fields corresponding to encoding coefficients carried in the plurality of packets, and the first finite field is a finite field with a lowest order in a network;

the fourth decoding manner is decoding the plurality of packets in a first finite field and a fourth finite field, the first finite field is a finite field with a lowest order in a network, the fourth finite field is any high-order finite field corresponding to encoding coefficients carried in the plurality of packets, and the high-order finite field is a finite field whose order is higher than that of the first finite field; and

the fifth decoding manner is decoding the plurality of packets in a first finite field and a fifth finite field, the first finite field is a finite field with a lowest order in a network, the fifth finite field is a finite field with a highest order in any t high-order finite fields corresponding to encoding coefficients carried in the plurality of packets, the high-order finite field is a finite field whose order is higher than that of the first finite field, and t is an integer greater than 1.

**13.** The method according to claim 12, wherein the decoding the plurality of packets in a first decoding manner comprises: decoding the plurality of packets in the first finite field, so that after decoding, diagonal elements of a decoding matrix are 1, and elements other than the diagonal elements are 0, wherein elements in any row in the decoding matrix are a group of encoding coefficients corresponding to one data block.

**14.** The method according to claim 13, wherein the plurality of packets carry k data blocks, and encoding coefficients corresponding to the k data blocks belong to the first finite field; or

the plurality of packets carry k+n data blocks, a finite field corresponding to encoding coefficients corresponding to the k+n data blocks is the first finite field, n is a quantity of encoded data blocks encoded in a high-order finite field, and the high-order finite field is a finite field whose order is higher than that of the first finite field.

**15.** The method according to claim 12, wherein the decoding the plurality of packets in a second decoding manner comprises: decoding the plurality of packets in the second finite field, so that after decoding, diagonal elements of a decoding matrix are 1, and elements other than the diagonal elements are 0, wherein elements in any row in the decoding matrix are a group of encoding coefficients corresponding to one data block.

**16.** The method according to claim 15, wherein the plurality of packets carry k data blocks, and encoding coefficients corresponding to the k data blocks belong to two or more finite fields.

**17.** The method according to claim 12, wherein the decoding the plurality of packets in a third decoding manner comprises: decoding the plurality of packets in the third finite field, so that after decoding, diagonal elements of a decoding matrix are 1, and elements other than the diagonal elements are transformed into 0, wherein elements in any row in the decoding matrix are a group of encoding coefficients corresponding to one data block.

**18.** The method according to claim 17, wherein the plurality of packets carry k data blocks, an encoding coefficient corresponding to at least one of the k data blocks belongs to the first finite field, and an encoding coefficient corresponding to another data block other than the at least one data block in the k data blocks belongs to the third finite field.

**19.** The method according to claim 12, wherein the decoding the plurality of packets in a fourth decoding manner comprises:

performing a first decoding operation on the plurality of packets in the first finite field; and
performing a second decoding operation on a result of the first decoding operation in the fourth finite field.

**20.** The method according to claim 19, wherein the performing a second decoding operation on a result of the first decoding operation in the fourth finite field comprises:

performing the second decoding operation on the result of the first decoding operation in the fourth finite field, so that after the second decoding operation, diagonal elements of a first decoding matrix are 1, and elements other than the diagonal elements are 0, wherein

an upper matrix of the first decoding matrix comprises an element in an $i^{th}$ row and a $g^{th}$ column of a second decoding matrix, a lower matrix of the first decoding matrix is a result of performing an operation on an element in a $T^{th}$ row and the $g^{th}$ column of the second decoding matrix and an encoding coefficient belonging to the fourth finite field in encoding coefficients corresponding to the $T^{th}$ row, elements in any row in the second decoding matrix are a result of performing the first decoding operation on an encoding coefficient belonging to the first finite field in a group of encoding coefficients corresponding to one data block, i={ 1, 2, ..., and H-n}, g={ 1, 2, ..., and k}, the $T^{th}$ row of the second decoding matrix is a row corresponding to an encoding coefficient in the fourth finite field, H is a quantity of data blocks carried in the plurality of packets, and n is a quantity of encoded data blocks encoded in the high-order finite field.

**21.** The method according to claim 19 or 20, wherein the performing a first decoding operation on the plurality of packets in the first finite field comprises:

performing the first decoding operation on the plurality of packets in the first finite field, so that after the first decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0, wherein elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, the $h^{th}$ row of the fifth decoding matrix obtained after the first decoding operation is a row corresponding to the encoding coefficient in the fourth finite field, H is the quantity of data blocks carried in the plurality of packets, and n is the quantity of encoded data blocks encoded in the high-order finite field.

**22.** The method according to any one of claims 19 to 21, wherein the plurality of packets carry (k-1)+n data blocks, an encoding coefficient corresponding to at least one of the (k-1)+n data blocks belongs to the fourth finite field, and n is the quantity of encoded data blocks encoded in the high-order finite field.

**23.** The method according to claim 12, wherein the decoding the plurality of packets in a fifth decoding manner comprises:

performing a fourth decoding operation on the plurality of packets in the first finite field; and
performing a third decoding operation on a result of the fourth decoding operation in the fifth finite field.

**24.** The method according to claim 23, wherein the performing a third decoding operation on a result of the fourth decoding operation in the fifth finite field comprises:

performing the third decoding operation on the result of the fourth decoding operation in the fifth finite field, so that after the third decoding operation, diagonal elements of a third decoding matrix are 1, and elements other than the diagonal elements are 0, wherein

an upper matrix of the third decoding matrix comprises an element in an $i^{th}$ row and a $g^{th}$ column of a fourth decoding matrix, a lower matrix of the third decoding matrix is a result of performing an operation on elements in a $g^{th}$ column of any t rows in an $(H-n+1)^{th}$ row to an $H^{th}$ row of the fourth decoding matrix and an encoding coefficient belonging to the high-order finite field in encoding coefficients corresponding to the any t rows, elements in any row in the fourth decoding matrix are a result of performing the fourth decoding operation on an encoding coefficient belonging to the first finite field in a group of encoding coefficients corresponding to one data block, i={ 1, 2, ..., and H-n}, g={ 1, 2, ..., and k}, H is a quantity of data blocks carried in the plurality of packets, and n is a quantity of encoded data blocks encoded in the high-order finite field.

**25.** The method according to claim 23 or 24, wherein the performing a fourth decoding operation on the plurality of packets in the first finite field comprises:

performing the fourth decoding operation on the plurality of packets in the first finite field, so that after the fourth decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0, wherein elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, h is any t integers greater than H-n and less than H+1, H is the quantity of data blocks carried in the plurality of packets, and n is the quantity of encoded data blocks encoded in the high-order finite field.

26. The method according to any one of claims 23 to 25, wherein the plurality of packets carry k+n-t data blocks, encoding coefficients corresponding to the k+n-t data blocks belong to at least t different high-order finite fields, and n is the quantity of encoded data blocks encoded in the high-order finite field.

27. A network encoding apparatus, comprising:

a processing unit, configured to: encode k source data blocks in one generation to obtain a plurality of encoded data blocks, wherein k is an integer greater than 0, and encoding coefficients used for at least two of the plurality of encoded data blocks correspond to finite fields with different orders; and
generate one or more packets based on the plurality of encoded data blocks, wherein each packet carries at least one encoded data block and an encoding coefficient corresponding to the encoded data block; and
a transceiver unit, configured to send the one or more packets.

28. The apparatus according to claim 27, wherein when encoding the k source data blocks in one generation to obtain the plurality of encoded data blocks, the processing unit is specifically configured to:
perform a first encoding operation on the k source data blocks by using a first encoding matrix to obtain the plurality of encoded data blocks, wherein the first encoding matrix comprises encoding coefficients of at least two types of finite fields with different orders.

29. The apparatus according to claim 28, wherein the processing unit is further configured to generate h1 packets based on the k source data blocks, wherein each of the h1 packets carries at least one source data block and an encoding coefficient corresponding to the source data block, encoding coefficients corresponding to the k source data blocks form a $k \times k$ matrix in which diagonal elements are 1 and elements other than the diagonal elements are 0, elements in any row in the matrix are k encoding coefficients corresponding to one of the k source data blocks, and h1 is an integer greater than 0 and not greater than k; and
the transceiver unit is further configured to send the h1 packets.

30. The apparatus according to claim 27, wherein when encoding the k source data blocks in one generation to obtain the plurality of encoded data blocks, the processing unit is specifically configured to:

perform a second encoding operation on the k source data blocks by using a second encoding matrix to obtain $n_1$ encoded data blocks, wherein $n_1$ is an integer greater than 0, an order of a finite field corresponding to a first encoding coefficient comprised in the second encoding matrix is higher than an order of a first finite field, and the first finite field is a finite field corresponding to a third encoding matrix; and
perform a third encoding operation on the $n_1$ encoded data blocks and the k source data blocks by using the third encoding matrix to obtain m encoded data blocks, wherein m is an integer greater than 0, and the plurality of encoded data blocks comprise the $n_1$ encoded data blocks and the m encoded data blocks.

31. The apparatus according to claim 30, wherein the processing unit is further configured to:

generate h2 packets based on the k source data blocks, wherein each of the h2 packets carries at least one source data block and an encoding coefficient corresponding to the source data block, and h2 is an integer greater than 0 and not greater than k, wherein
encoding coefficients corresponding to the k source data blocks and second encoding coefficients corresponding to the $n_1$ encoded data blocks form a $(k+n_1) \times (k+n_1)$ matrix in which diagonal elements are 1 and elements other than the diagonal elements are 0, elements in any row in the matrix are $k+n_1$ encoding coefficients corresponding to one of the k source data blocks or $k+n_1$ encoding coefficients corresponding to one of the $n_1$ encoded data blocks, and the second encoding coefficient is an encoding coefficient in encoding coefficients corresponding to the $n_1$ encoded data blocks other than the first encoding coefficient used for the second encoding operation; and
the transceiver unit is further configured to send the h2 packets.

32. The apparatus according to claim 27, wherein when encoding the k source data blocks in one generation to obtain the plurality of encoded data blocks, the processing unit is specifically configured to:

perform a fourth encoding operation on the k source data blocks by using a fourth encoding matrix to obtain $n_2$ intermediate data blocks, wherein $n_2$ is an integer greater than 0, an order of a finite field corresponding to an encoding coefficient comprised in the fourth encoding matrix is higher than an order of a second finite field, and the second finite field is a finite field corresponding to a fifth encoding matrix; and
perform a fifth encoding operation on the nz intermediate data blocks and the k source data blocks by using the fifth encoding matrix to obtain the plurality of encoded data blocks.

33. The apparatus according to any one of claims 27 to 32, wherein the packet further carries indication information, and the indication information indicates an order of a finite field corresponding to a source data block carried in the packet, or the indication information indicates an order of a finite field corresponding to an encoded data block carried in the packet.

34. A network encoding apparatus, comprising:

a transceiver unit, configured to receive n packets, wherein n is an integer greater than 1, one packet carries $a_1$ data blocks and encoding coefficients corresponding to the $a_1$ data blocks, $a_1$ is an integer greater than 0, and encoding coefficients carried in the n packets correspond to one or more finite fields; and
a processing unit, configured to: determine a finite field for recoding based on one or more of the following information: an encoding computing power of a network node, the finite field corresponding to the encoding coefficients carried in the n packets, and network load; and recode, based on the finite field for recoding, data blocks and the encoding coefficients carried in the n packets to obtain v encoding results, wherein v is an integer greater than 0, wherein
the transceiver unit is further configured to send m1 recoded packets, wherein one recoded packet carries at least one encoding result, and m1 is an integer greater than 0 and not greater than v.

35. The apparatus according to claim 34, wherein there are one or more finite fields for recoding.

36. The apparatus according to claim 34 or 35, wherein when recoding, based on the finite field for recoding, the data blocks and the encoding coefficients carried in the n packets, the processing unit is specifically configured to:

perform, by using a seventh encoding matrix, an encoding operation on the data blocks carried in the n packets to obtain v recoded data blocks, wherein an encoding coefficient comprised in the seventh encoding matrix belongs to the finite field for recoding; and
perform, by using the seventh encoding matrix, an encoding operation on the encoding coefficients carried in the n packets to obtain v groups of recoded encoding coefficients, wherein one encoding result comprises one recoded data block and one group of corresponding recoded encoding coefficients.

37. The apparatus according to any one of claims 34 to 36, wherein when determining the finite field for recoding based on the finite field corresponding to the encoding coefficients carried in the n packets, the processing unit is specifically configured to:
determine, as the finite field for recoding, a finite field with a highest order in the finite field corresponding to the encoding coefficients carried in the n packets.

38. A network encoding apparatus, comprising:

a transceiver unit, configured to receive a plurality of packets for k source data blocks in one generation, wherein k is an integer greater than 0, and one packet carries at least one data block and a group of encoding coefficients corresponding to each data block; and
a processing unit, configured to decode the plurality of packets in a first decoding manner, a second decoding manner, a third decoding manner, a fourth decoding manner, or a fifth decoding manner, wherein
the first decoding manner is decoding the plurality of packets in a first finite field, and the first finite field is a finite field with a lowest order in a network;

the second decoding manner is decoding the plurality of packets in a second finite field, and the second finite field is a finite field with a highest order in finite fields corresponding to encoding coefficients carried in the plurality of packets;

the third decoding manner is decoding the plurality of packets in a third finite field, the third finite field is another finite field other than a first finite field in finite fields corresponding to encoding coefficients carried in the plurality of packets, and the first finite field is a finite field with a lowest order in a network;

the fourth decoding manner is decoding the plurality of packets in a first finite field and a fourth finite field, the first finite field is a finite field with a lowest order in a network, the fourth finite field is any high-order finite field corresponding to encoding coefficients carried in the plurality of packets, and the high-order finite field is a finite field whose order is higher than that of the first finite field; and

the fifth decoding manner is decoding the plurality of packets in a first finite field and a fifth finite field, the first finite field is a finite field with a lowest order in a network, the fifth finite field is a finite field with a highest order in any t high-order finite fields corresponding to encoding coefficients carried in the plurality of packets, the high-order finite field is a finite field whose order is higher than that of the first finite field, and t is an integer greater than 1.

39. The apparatus according to claim 38, wherein when decoding the plurality of packets in the first decoding manner, the processing unit is specifically configured to:
decode the plurality of packets in the first finite field, so that after decoding, diagonal elements of a decoding matrix are 1, and elements other than the diagonal elements are 0, wherein elements in any row in the decoding matrix are a group of encoding coefficients corresponding to one data block.

40. The apparatus according to claim 39, wherein the plurality of packets carry k data blocks, and encoding coefficients corresponding to the k data blocks belong to the first finite field; or
the plurality of packets carry k+n data blocks, a finite field corresponding to encoding coefficients corresponding to the k+n data blocks is the first finite field, n is a quantity of encoded data blocks encoded in a high-order finite field, and the high-order finite field is a finite field whose order is higher than that of the first finite field.

41. The apparatus according to claim 38, wherein when decoding the plurality of packets in the second decoding manner, the processing unit is specifically configured to:
decode the plurality of packets in the second finite field, so that after decoding, diagonal elements of a decoding matrix are 1, and elements other than the diagonal elements are 0, wherein elements in any row in the decoding matrix are a group of encoding coefficients corresponding to one data block.

42. The apparatus according to claim 41, wherein the plurality of packets carry k data blocks, and encoding coefficients corresponding to the k data blocks belong to two or more finite fields.

43. The apparatus according to claim 38, wherein when decoding the plurality of packets in the third decoding manner, the processing unit is specifically configured to:
decode the plurality of packets in the third finite field, so that after decoding, diagonal elements of a decoding matrix are 1, and elements other than the diagonal elements are transformed into 0, wherein elements in any row in the decoding matrix are a group of encoding coefficients corresponding to one data block.

44. The apparatus according to claim 43, wherein the plurality of packets carry k data blocks, an encoding coefficient corresponding to at least one of the k data blocks belongs to the first finite field, and an encoding coefficient corresponding to another data block other than the at least one data block in the k data blocks belongs to the third finite field.

45. The apparatus according to claim 38, wherein when decoding the plurality of packets in the fourth decoding manner, the processing unit is specifically configured to:

perform a first decoding operation on the plurality of packets in the first finite field; and
perform a second decoding operation on a result of the first decoding operation in the fourth finite field.

46. The apparatus according to claim 45, wherein when performing the second decoding operation on the result of the first decoding operation in the fourth finite field, the processing unit is specifically configured to:

perform the second decoding operation on the result of the first decoding operation in the fourth finite field, so that after the second decoding operation, diagonal elements of a first decoding matrix are 1, and elements other than the diagonal elements are 0, wherein

an upper matrix of the first decoding matrix comprises an element in an $i^{th}$ row and a $g^{th}$ column of a second decoding matrix, a lower matrix of the first decoding matrix is a result of performing an operation on an element in a $T^{th}$ row and the $g^{th}$ column of the second decoding matrix and an encoding coefficient belonging to the fourth finite field in encoding coefficients corresponding to the $T^{th}$ row, elements in any row in the second decoding matrix are a result of performing the first decoding operation on an encoding coefficient belonging to the first finite field in a group of encoding coefficients corresponding to one data block, i={ 1, 2, ..., and H-n}, g={ 1, 2, ..., and k}, the $T^{th}$ row of the second decoding matrix is a row corresponding to an encoding coefficient in the fourth finite field, H is a quantity of data blocks carried in the plurality of packets, and n is a quantity of encoded data blocks encoded in the high-order finite field.

47. The apparatus according to claim 45 or 46, wherein when performing the first decoding operation on the plurality of packets in the first finite field, the processing unit is specifically configured to:

   perform the first decoding operation on the plurality of packets in the first finite field, so that after the first decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0, wherein elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, the $h^{th}$ row of the fifth decoding matrix obtained after the first decoding operation is a row corresponding to the encoding coefficient in the fourth finite field, H is the quantity of data blocks carried in the plurality of packets, and n is the quantity of encoded data blocks encoded in the high-order finite field.

48. The apparatus according to any one of claims 45 to 47, wherein the plurality of packets carry (k-1)+n data blocks, an encoding coefficient corresponding to at least one of the (k-1)+n data blocks belongs to the fourth finite field, and n is the quantity of encoded data blocks encoded in the high-order finite field.

49. The apparatus according to claim 38, wherein when decoding the plurality of packets in the fifth decoding manner, the processing unit is specifically configured to:

   perform a fourth decoding operation on the plurality of packets in the first finite field; and
   perform a third decoding operation on a result of the fourth decoding operation in the fifth finite field.

50. The apparatus according to claim 49, wherein when performing the third decoding operation on the result of the fourth decoding operation in the fifth finite field, the processing unit is specifically configured to:

   perform the third decoding operation on the result of the fourth decoding operation in the fifth finite field, so that after the third decoding operation, diagonal elements of a third decoding matrix are 1, and elements other than the diagonal elements are 0, wherein
   an upper matrix of the third decoding matrix comprises an element in an $i^{th}$ row and a $g^{th}$ column of a fourth decoding matrix, a lower matrix of the first decoding matrix is a result of performing an operation on elements in a $g^{th}$ column of any t rows in an $(H-n+1)^{th}$ row to an $H^{th}$ row of the fourth decoding matrix and an encoding coefficient belonging to the high-order finite field in encoding coefficients corresponding to the any t rows, elements in any row in the fourth decoding matrix are a result of performing the first decoding operation on an encoding coefficient belonging to the first finite field in a group of encoding coefficients corresponding to one data block, i={1, 2, ..., and H-n}, g={1, 2, ..., and k}, H is a quantity of data blocks carried in the plurality of packets, and n is a quantity of encoded data blocks encoded in the high-order finite field.

51. The apparatus according to claim 49 or 50, wherein when performing the fourth decoding operation on the plurality of packets in the first finite field, the processing unit is specifically configured to:

   perform the fourth decoding operation on the plurality of packets in the first finite field, so that after the fourth decoding operation, in a fifth decoding matrix, an element in an $i^{th}$ row and a $j^{th}$ column is 0, an element in an $h^{th}$ row and an $(h+1)^{th}$ column in an element in the $h^{th}$ row and a $(k+1)^{th}$ column to an element in the $h^{th}$ row and a $(k+n)^{th}$ column is 1, and another element other than the element in the $h^{th}$ row and the $(h+1)^{th}$ column in the element in the $h^{th}$ row and the $(k+1)^{th}$ column to the element in the $h^{th}$ row and the $(k+n)^{th}$ column is 0, wherein elements in any row in the fifth decoding matrix are encoding coefficients belonging to the first finite field in a group of encoding coefficients corresponding to one data block, i={ 1, 2, ..., and H-n}, j={k+1, k+2, ..., and k+n}, h is any t integers greater than H-n and less than H+1, H is the quantity of data blocks carried in the plurality of packets, and n is the quantity of encoded data blocks encoded in the high-order finite field.

52. The apparatus according to any one of claims 49 to 51, wherein the plurality of packets carry k+n-t data blocks, encoding coefficients corresponding to the k+n-t data blocks belong to at least t different high-order finite fields, and n is the quantity of encoded data blocks encoded in the high-order finite field.

53. A computer-readable storage medium, wherein the computer-readable storage medium stores a program or instructions, and when the program or the instructions is/are read and executed by one or more processors, the method according to any one of claims 1 to 26 is implemented.

54. A computer program product, wherein when the computer program product runs on a network device, the network device is enabled to perform the method according to any one of claims 1 to 26.

FIG. 1

Intermediate node 1

Transmit end

Intermediate node 2

Receive end

FIG. 2

$GF(2^8)$

$GF(2^8)$

Transmit end

$GF(2^8)$

Intermediate node

A network becomes a bottleneck

$GF(2^8)$

Computer

$GF(2^8)$

IoT device

FIG. 3

$GF(2)$

Transmit end

$GF(2)$

Intermediate node

A network restricts SLA

$GF(2)$

Receive end

FIG. 4

S501

A transmit end encodes k source data blocks in one generation to obtain a plurality of encoded data blocks

S502

The transmit end generates one or more packets based on the plurality of encoded data blocks

S503

The transmit end sends the one or more packets

FIG. 5

| 1 | 0 | 1 | 1 | x | x | x | x | $p_1$ |

⋮

| 0 | 0 | 0 | 1 | x | x | x | x | $p_k$ |

$\alpha'_{m,1}$    $\alpha_{n,1}$    $\alpha_{1,1}$

$\alpha'_{m,k}$    $\alpha_{n,k}$    $\alpha_{1,k}$

GF($2^t$)

| 0 | 0 | 1 | 0 | x | x | x | x | $c_1$ |

GF($2^s$)    ⋮    ⋮

| 1 | 0 | 0 | 0 | x | x | x | x | $c_n$ |

GF($2^l$)

$b_1$
⋮

| 1 | 0 | 1 | 0 | x | x | x | x | $b_m$ |

FIG. 6

First encoding matrix · Source data block

Output data block · Encoding coefficient

Finite field GF($2^N$)
Finite field GF($2^{N-1}$)
Finite field GF($2^3$)
Finite field GF($2^2$)
Finite field GF($2^1$)

FIG. 7

FIG. 8

| 1 | 0 | 0 | 0 |
|---|---|---|---|
| 0 | 1 | 0 | 0 |
| 0 | 0 | 1 | 0 |
| 0 | 0 | 0 | 1 |
| $\alpha_{1,1}$ | $\alpha_{1,2}$ | $\alpha_{1,3}$ | $\alpha_{1,4}$ |
| $\alpha_{2,1}$ | $\alpha_{2,2}$ | $\alpha_{2,3}$ | $\alpha_{2,4}$ |
| $\alpha_{3,1}$ | $\alpha_{3,2}$ | $\alpha_{3,3}$ | $\alpha_{3,4}$ |
| $\alpha_{4,1}$ | $\alpha_{4,2}$ | $\alpha_{4,3}$ | $\alpha_{4,4}$ |

Second encoding matrix

$*$

| $p_1$ |
|---|
| $p_2$ |
| $p_3$ |
| $p_4$ |

Source data block

$=$

| $p_1$ |
|---|
| $p_2$ |
| $p_3$ |
| $p_4$ |
| $c_1$ |
| $c_2$ |
| $c_3$ |
| $c_4$ |

| $p_1$ | | | | |
|---|---|---|---|---|
| $\vdots$ | | | | |
| $p_4$ | | | | |
| $c_1$ | $\alpha_{1,1}$ | $\alpha_{1,2}$ | $\alpha_{1,3}$ | $\alpha_{1,4}$ | Finite field $GF(2^N)$ |
| $c_2$ | $\alpha_{2,1}$ | $\alpha_{2,2}$ | $\alpha_{2,3}$ | $\alpha_{2,4}$ | Finite field $GF(2^{N-1})$ |
| $c_3$ | $\alpha_{3,1}$ | $\alpha_{3,2}$ | $\alpha_{3,3}$ | $\alpha_{3,4}$ | Finite field $GF(2^3)$ |
| $c_4$ | $\alpha_{4,1}$ | $\alpha_{4,2}$ | $\alpha_{4,3}$ | $\alpha_{4,4}$ | Finite field $GF(2^2)$ |

Encoding coefficient

FIG. 9

FIG. 10

FIG. 11

FIG. 12

Encoding coefficient

Output data block

Fifth encoding matrix

S1301

An intermediate node receives n packets

S1302

The intermediate node determines a finite field for recoding based on one or more of the following information: an encoding computing power of the intermediate node, a finite field corresponding to encoding coefficients carried in the n packets, and network load

S1303

The intermediate node recodes, based on the finite field for recoding, data blocks and the encoding coefficients carried in the n packets to obtain v encoding results

S1304

The intermediate node sends m1 recoded packets

FIG. 13

Input packet → Intermediate node → Output packet

Network

$X_1$    $Y_1 = X_1$

$\gamma_{1,1}$    $\gamma_{1,2}$

$X_2$    $Y_2 = X_2$

$\gamma_{1,2}$

$\gamma_{v,2}$

$X_u$    $Y_u = X_u$

$\gamma_{1,u}$    $Y_{u+1}$

$\gamma_{v,u}$

$Y_{u+v}$

FIG. 14

Data block      Encoding coefficient

$f_1$   $f_2$   $f_3$   $f_4$   $\alpha_{1,1}$   $\alpha_{1,2}$    Packet X1

$\times$   $\times$   $\times$   $\times$   $\times$   $\times$

$d_1$   $d_1$   $d_1$   $d_1$   $d_1$   $d_1$    Random recoding coefficient 1

$+$   $+$   $+$   $+$   $+$   $+$

$e_1$   $e_2$   $e_3$   $e_4$   $\alpha_{2,1}$   $\alpha_{2,2}$    Packet X2

$\times$   $\times$   $\times$   $\times$   $\times$   $\times$

$d_2$   $d_2$   $d_2$   $d_2$   $d_2$   $d_2$    Random recoding coefficient 2

New encoded data   $\gamma_{11}$   $\gamma_{12}$    Recoded packet $Y_{u+1}$

FIG. 15

Data block      Encoding coefficient

$f_1$   $f_2$   $f_3$   $f_4$   $\alpha'_{1,1}$   $\alpha'_{1,2}$   $\alpha'_{1,3}$   $\alpha'_{1,4}$    Packet X1

$\times$   $\times$   $\times$   $\times$   $\times$   $\times$   $\times$   $\times$

$d_1$   $d_1$   $d_1$   $d_1$   $d_1$   $d_1$   $d_1$   $d_1$    Random recoding coefficient 1

$+$   $+$   $+$   $+$   $+$   $+$   $+$

$e_1$   $e_2$   $e_3$   $e_4$   $\alpha'_{2,1}$   $\alpha'_{2,2}$   $\alpha'_{2,1}$   $\alpha'_{2,2}$    Packet X2

$\times$   $\times$   $\times$   $\times$   $\times$   $\times$   $\times$   $\times$

$d_2$   $d_2$   $d_2$   $d_2$   $d_2$   $d_2$   $d_2$   $d_2$    Random recoding coefficient 2

New encoded data   $\gamma_{11}$   $\gamma_{12}$   $\gamma_{13}$   $\gamma_{14}$    Recoded packet $Y_{u+1}$

FIG. 16

```
                                           ┌─────── S1701
A receive end receives a plurality of packets for k source data blocks
                          in one generation

                                           ┌─────── S1702
The receive end decodes the plurality of packets in a first decoding
manner, a second decoding manner, a third decoding manner, a fourth
             decoding manner, or a fifth decoding manner
```

FIG. 17

Decoding matrix

| 1 | 0 | 1 | 0 | $X_1$ |
|---|---|---|---|---|
| 1 | 1 | 1 | 1 | $X_2$ |
| 0 | 0 | 1 | 0 | $X_3$ |
| $\beta_{m,1}$ | $\beta_{m,2}$ | $\beta_{m,3}$ | $\beta_{m,4}$ | $X_4$ |

Decoding in a first finite field

| 1 | 0 | 0 | 0 | $p_1$ |
|---|---|---|---|---|
| 0 | 1 | 0 | 0 | $p_2$ |
| 0 | 0 | 1 | 0 | $p_3$ |
| 0 | 0 | 0 | 1 | $p_4$ |

FIG. 18

FIG. 19

| $\alpha_{1,1}$ | $\alpha_{1,2}$ | $\alpha_{1,3}$ | $\alpha_{1,4}$ |
|---|---|---|---|
| $\alpha_{2,1}$ | $\alpha_{2,2}$ | $\alpha_{2,3}$ | $\alpha_{2,4}$ |
| $\alpha_{3,1}$ | $\alpha_{3,2}$ | $\alpha_{3,3}$ | $\alpha_{3,4}$ |
| $\alpha_{4,1}$ | $\alpha_{4,2}$ | $\alpha_{4,3}$ | $\alpha_{4,4}$ |

$GF(2^N)$ encoding coefficient carried in $x_1$

$GF(2^{N-1})$ encoding coefficient carried in $x_2$

$GF(2^3)$ encoding coefficient carried in $x_3$

$GF(2^2)$ encoding coefficient carried in $x_4$

Decoding matrix

| $\alpha_{1,1}$ | $\alpha_{1,2}$ | $\alpha_{1,3}$ | $\alpha_{1,4}$ | $x_1$ |
|---|---|---|---|---|
| $\alpha_{2,1}$ | $\alpha_{2,2}$ | $\alpha_{2,3}$ | $\alpha_{2,4}$ | $x_2$ |
| $\alpha_{3,1}$ | $\alpha_{3,2}$ | $\alpha_{3,3}$ | $\alpha_{3,4}$ | $x_3$ |
| $\alpha_{4,1}$ | $\alpha_{4,2}$ | $\alpha_{4,3}$ | $\alpha_{4,4}$ | $x_4$ |

Decoding in a finite field $GF(2^N)$

| 21 | 7 | 3 | 11 | $p_1$ |
|---|---|---|---|---|
| 15 | 3 | 2 | 6 | $p_2$ |
| 7 | 1 | 3 | 5 | $p_3$ |
| 1 | 3 | 2 | 1 | $p_4$ |

FIG. 20

Decoding matrix

| | | | | |
|---|---|---|---|---|
| **1** | **0** | **1** | **0** | $x_1$ |
| $\alpha_{1,1}$ | $\alpha_{1,2}$ | $\alpha_{1,3}$ | $\alpha_{1,4}$ | $x_2$ |
| $\alpha_{2,1}$ | $\alpha_{2,2}$ | $\alpha_{2,3}$ | $\alpha_{2,4}$ | $x_3$ |
| $\alpha_{3,1}$ | $\alpha_{3,2}$ | $\alpha_{3,3}$ | $\alpha_{3,4}$ | $x_4$ |

Decoding in a finite field $GF(2^N)$

| | | | | |
|---|---|---|---|---|
| **1** | **0** | **0** | **0** | $p_1$ |
| **0** | **4** | **2** | **6** | $p_2$ |
| **0** | **y** | **y** | **y** | $p_3$ |
| **0** | **1** | **6** | **5** | $p_4$ |

FIG. 21

Decoding matrix

| 1 | 0 | 1 | 0 |
|---|---|---|---|
| 1 | 1 | 1 | 1 |
| 0 | 0 | 1 | 0 |
| $\alpha_{1,1}$ | $\alpha_{1,2}$ | $\alpha_{1,3}$ | $\alpha_{1,4}$ |

$GF(2^1)$ encoding coefficient carried in $x_1$

$GF(2^1)$ encoding coefficient carried in $x_2$

$GF(2^1)$ encoding coefficient carried in $x_3$

$GF(2^N)$ encoding coefficient carried in $x_4$

| 1 | 0 | 1 | 0 | $x_1$ |
|---|---|---|---|---|
| 1 | 1 | 1 | 1 | $x_2$ |
| 0 | 0 | 1 | 0 | $x_3$ |
| $\alpha_{1,1}$ | $\alpha_{1,2}$ | $\alpha_{1,3}$ | $\alpha_{1,4}$ | $x_4$ |

| 1 | 0 | 0 | 0 | $p_1$ |
|---|---|---|---|---|
| 0 | 1 | 0 | 1 | $p_2$ |
| 0 | 0 | 1 | 0 | $p_3$ |
| 0 | 0 | 0 | 6 | $p_4$ |

FIG. 22

Decoding in a finite field $GF(2^2)$

Decoding matrix

| 1 | 0 | 1 | 0 |
|---|---|---|---|
| 1 | 1 | 1 | 1 |
| 0 | 0 | 1 | 0 |
| $\alpha_{4,1}$ | $\alpha_{4,2}$ | $\alpha_{4,3}$ | $\alpha_{4,4}$ |

$GF(2^1)$ encoding coefficient carried in $x_1$

$GF(2^1)$ encoding coefficient carried in $x_2$

$GF(2^1)$ encoding coefficient carried in $x_3$

$GF(2^2)$ encoding coefficient carried in $x_4$

| 1 | 0 | 1 | 0 | $x_1$ |
|---|---|---|---|---|
| 1 | 1 | 1 | 1 | $x_2$ |
| 0 | 0 | 1 | 0 | $x_3$ |
| $\alpha_{4,1}$ | $\alpha_{4,2}$ | $\alpha_{4,3}$ | $\alpha_{4,4}$ | $x_4$ |

| 1 | 0 | 0 | 0 | $p_1$ |
|---|---|---|---|---|
| 0 | 1 | 0 | 1 | $p_2$ |
| 0 | 0 | 1 | 0 | $p_3$ |
| 0 | 0 | 0 | 3 | $p_4$ |

FIG. 23

Decoding matrix

| 1 | 0 | 1 | 0 | 1 | 0 | 1 | 0 | $x_1$ |
| 1 | 1 | 1 | 0 | 0 | 0 | 1 | 0 | $x_2$ |
| 0 | 0 | 1 | 0 | 1 | 0 | 1 | 1 | $x_3$ |
| 1 | 0 | 0 | 0 | 0 | 1 | 1 | 0 | $x_4$ |
| 0 | 1 | 1 | 0 | 0 | 0 | 1 | 1 | $x_5$ |
| 0 | 0 | 1 | 1 | 0 | 0 | 0 | 1 | $x_6$ |
| 1 | 0 | 1 | 1 | 1 | 1 | 1 | 0 | $x_7$ |
| 0 | 0 | 0 | 1 | 1 | 0 | 0 | 0 | $x_8$ |

Decoding in a first finite field

| 1 | 0 | 0 | 0 | 0 | 0 | 0 | 0 | $p_1$ |
| 0 | 1 | 0 | 0 | 0 | 0 | 0 | 0 | $p_2$ |
| 0 | 0 | 1 | 0 | 0 | 0 | 0 | 0 | $p_3$ |
| 0 | 0 | 0 | 1 | 0 | 0 | 0 | 0 | $p_4$ |
| 0 | 0 | 0 | 0 | 1 | 0 | 0 | 0 | $c_1$ |
| 0 | 0 | 0 | 0 | 0 | 1 | 0 | 0 | $c_2$ |
| 0 | 0 | 0 | 0 | 0 | 0 | 1 | 0 | $c_3$ |
| 0 | 0 | 0 | 0 | 0 | 0 | 0 | 1 | $c_4$ |

FIG. 24

EP 4 184 827 A1

Fifth decoding matrix

$x_1$

| 1 | 0 | 1 | 0 | 1 | 0 | 1 | 0 |

$x_2$

| 1 | 1 | 1 | 0 | 0 | 0 | 1 | 0 |

...

| 0 | 0 | 1 | 0 | 1 | 0 | 1 | 1 |

$x_{k=4}$

| 1 | 0 | 0 | 0 | 0 | 1 | 1 | 0 |

$x_{k+1=5}$

| 0 | 1 | 1 | 0 | 0 | 0 | 1 | 1 |

...

| 0 | 0 | 1 | 1 | 0 | 0 | 0 | 1 |

$x_{k+n-1=7}$

| 1 | 0 | 1 | 1 | 1 | 1 | 1 | 0 |

First decoding operation

Second decoding matrix

| 1 | 0 | 0 | 0 | 0 | 0 | 0 | 0 |
| 0 | 1 | 0 | 1 | 0 | 0 | 0 | 0 |
| 0 | 0 | 1 | 1 | 0 | 0 | 0 | 0 |

Upper matrix

| 1 | 0 | 0 | 1 | 1 | 0 | 0 | 0 |
| 0 | 0 | 1 | 0 | 0 | 1 | 0 | 0 |
| 1 | 0 | 1 | 0 | 1 | 0 | 1 | 1 |
| 0 | 0 | 1 | 1 | 0 | 1 | 0 | 1 |

Lower matrix

$GF(2^N)$ encoding coefficient

$GF(2^{N-1})$ encoding coefficient

$GF(2^3)$ encoding coefficient

$GF(2^2)$ encoding coefficient

First decoding matrix

| 1 | 0 | 0 | 0 |
| 0 | 1 | 0 | 1 |
| 0 | 0 | 1 | 1 |

| 15 | 3 | 2 | 6 |

Second decoding operation

| 1 | 0 | 0 | 0 | $p_1$ |
| 0 | 1 | 0 | 0 | $p_2$ |
| 0 | 0 | 1 | 0 | $p_3$ |
| 0 | 0 | 0 | 1 | $p_4$ |

FIG. 25

Second decoding
matrix

Upper matrix:

| 1 | 0 | 0 | 0 | 0 | 0 | 0 | 0 |
| 0 | 1 | 0 | 1 | 0 | 0 | 0 | 0 |
| 0 | 0 | 1 | 1 | 0 | 0 | 0 | 0 |

Upper matrix

$1p_1+0p_2+0p_3+0p_4=x'1$  (1)

$0p_1+1p_2+0p_3+1p_4=x'2$  (2)

$0p_1+0p_2+1p_3+1p_4=x'3$  (3)

Second decoding matrix:

| 1 | 0 | 0 | 0 |
| 0 | 1 | 0 | 1 |
| 0 | 0 | 1 | 1 |

Lower matrix:

| 1 | 0 | 0 | 1 | 1 | 0 | 0 | 0 |
| 0 | 0 | 1 | 0 | 0 | 1 | 0 | 0 |
| 1 | 0 | 1 | 0 | 1 | 0 | 1 | 1 |
| 0 | 0 | 1 | 1 | 0 | 1 | 0 | 1 |

Lower matrix

$1p_1+0p_2+0p_3+1p_4+1c_1=x'4$  (4)

$GF(2^N)$ encoding coefficients are $\{14, 3, 2, 7\}$

$c_1=14p_1+3p_2+2p_3+7p_4$

is substituted into (4) to obtain

$$15p_1+3p_2+2p_3+6p_4=x'4 \qquad (5)$$

| 15 | 3 | 2 | 6 |

The second decoding matrix is obtained with
reference to the formulas (1) to (3) and (5)

FIG. 26

Fifth decoding matrix

Second decoding matrix

First decoding matrix

$X_1$   1 0 1 0 1 0 1 0

$X_2$   1 1 1 0 0 0 1 0

...   0 0 1 0 1 0 1 1

$X_{k=4}$   1 0 0 0 0 1 1 0

$X_{k+1=5}$   0 1 1 0 0 0 1 1

...   0 0 1 1 0 0 0 1

$X_{k+n-1=7}$   1 0 1 1 1 1 1 0

| 1 | 0 | 0 | 0 | 0 | 0 | 0 | 0 |
| 0 | 1 | 0 | 1 | 0 | 0 | 0 | 0 |
| 0 | 0 | 1 | 1 | 0 | 0 | 0 | 0 |

Upper matrix

| 1 | 0 | 0 | 0 |
| 0 | 1 | 0 | 1 |
| 0 | 0 | 1 | 1 |

| 1 | 0 | 0 | 0 | $p_1$ |
| 0 | 1 | 0 | 0 | $p_2$ |
| 0 | 0 | 1 | 0 | $p_3$ |
| 0 | 0 | 0 | 1 | $p_4$ |

| 1 | 0 | 0 | 1 | 1 | 0 | 0 | 0 | $GF(2^N)$ encoding coefficient |
| 0 | 0 | 1 | 0 | 0 | 1 | 0 | 0 | $GF(2^{N-1})$ encoding coefficient |
| 1 | 0 | 1 | 0 | 1 | 0 | 1 | 1 | $GF(2^3)$ encoding coefficient |
| 0 | 0 | 1 | 1 | 0 | 1 | 0 | 1 | $GF(2^2)$ encoding coefficient |

Second decoding operation

Lower matrix

coefficient   2 1 3 2

First decoding operation

FIG. 27

EP 4 184 827 A1

Fifth decoding matrix    Second decoding matrix    First decoding matrix

$X_1$

| 1 | 0 | 1 | 0 | 1 | 0 | 1 | 0 |

$X_2$

| 1 | 1 | 1 | 0 | 0 | 0 | 1 | 0 |

...

| 0 | 0 | 1 | 0 | 1 | 0 | 1 | 1 |

$X_{k=4}$

| 1 | 0 | 0 | 0 | 0 | 1 | 1 | 0 |

$X_{k+1=5}$

| 0 | 1 | 1 | 0 | 0 | 0 | 1 | 1 |

...

| 0 | 0 | 1 | 1 | 0 | 0 | 0 | 1 |

$X_{k+n-1=7}$

| 1 | 0 | 1 | 1 | 1 | 1 | 1 | 0 |

Second decoding matrix (Upper matrix):

| 1 | 0 | 0 | 0 | 0 | 0 | 0 | 0 |
| 0 | 1 | 0 | 1 | 0 | 0 | 0 | 0 |
| 0 | 0 | 1 | 1 | 0 | 0 | 0 | 0 |

Upper matrix

First decoding matrix:

| 1 | 0 | 0 | 0 |
| 0 | 1 | 0 | 1 |
| 0 | 0 | 1 | 1 |

Second decoding matrix (result):

| 1 | 0 | 0 | 0 | $p_1$ |
| 0 | 1 | 0 | 0 | $p_2$ |
| 0 | 0 | 1 | 0 | $p_3$ |
| 0 | 0 | 0 | 1 | $p_4$ |

Second decoding operation

Lower matrix:

| 1 | 0 | 0 | 1 | 1 | 0 | 0 | 0 |
| 0 | 0 | 1 | 0 | 0 | 1 | 0 | 0 |
| 1 | 0 | 1 | 0 | 1 | 0 | 1 | 1 |
| 0 | 0 | 1 | 1 | 0 | 1 | 0 | 1 |

Lower matrix

$GF(2^N)$ encoding coefficient

$GF(2^{N-1})$ encoding coefficient

$GF(2^3)$ encoding coefficient

$GF(2^2)$ encoding coefficient

| 1 | 7 | 3 | 6 |

First decoding operation

FIG. 28

Fifth decoding matrix

Second decoding matrix

First decoding matrix

| | | | | | | | |
|---|---|---|---|---|---|---|---|
| $X_1$ | 1 | 0 | 1 | 0 | 1 | 0 | 1 | 0 |

$X_1$: 1 0 1 0 1 0 1 0
$X_2$: 1 1 1 0 0 0 1 0
...: 0 0 1 0 1 0 1 1
$X_{k=4}$: 1 0 0 0 0 1 1 0
$X_{k+1=5}$: 0 1 1 0 0 0 1 1
...: 0 0 1 1 0 0 0 1
$X_{k+n-1=7}$: 1 0 1 1 1 1 1 0

Second decoding matrix (Upper matrix):
1 0 0 0 | 0 0 0 0
0 1 0 1 | 0 0 0 0
0 0 1 1 | 0 0 0 0

First decoding matrix:
1 0 0 0
0 1 0 1
0 0 1 1

| 1 | 0 | 0 | 0 | $p_1$ |
| 0 | 1 | 0 | 0 | $p_2$ |
| 0 | 0 | 1 | 0 | $p_3$ |
| 0 | 0 | 0 | 1 | $p_4$ |

Lower matrix:
1 0 0 1 1 0 0 0
0 0 1 0 0 1 0 0
1 0 1 0 1 0 1 1
0 0 1 1 0 1 0 1

$GF(2^N)$ encoding coefficient
$GF(2^{N-1})$ encoding coefficient
$GF(2^3)$ encoding coefficient
$GF(2^2)$ encoding coefficient

Second decoding operation

7 1 3 5

First decoding operation

FIG. 29

Fifth decoding matrix

Fourth decoding matrix

Third decoding matrix

| | | | | | | | |
|---|---|---|---|---|---|---|---|
| 1 | 0 | 1 | 0 | 1 | 0 | 1 | 0 |
| 1 | 1 | 1 | 0 | 0 | 0 | 1 | 0 |
| 0 | 0 | 1 | 0 | 1 | 0 | 1 | 1 |
| 1 | 0 | 0 | 0 | 0 | 1 | 1 | 0 |
| 0 | 1 | 1 | 0 | 0 | 0 | 1 | 1 |
| 0 | 0 | 1 | 1 | 0 | 0 | 0 | 1 |

$X_1$
$X_2$
...
$X_{k=4}$
...
$X_{k+n-2=6}$

| | | | | | | | |
|---|---|---|---|---|---|---|---|
| 1 | 0 | 0 | 0 | 0 | 0 | 0 | 0 |
| 0 | 1 | 0 | 1 | 0 | 0 | 0 | 0 |

Upper matrix

| | | | | | | | |
|---|---|---|---|---|---|---|---|
| 1 | 0 | 0 | 1 | 1 | 0 | 0 | 0 |
| 0 | 0 | 1 | 0 | 0 | 1 | 0 | 0 |
| 1 | 0 | 1 | 0 | 1 | 0 | 1 | 1 |
| 0 | 0 | 1 | 1 | 0 | 1 | 0 | 1 |

Lower matrix

$GF(2^N)$ encoding coefficient
$GF(2^{N-1})$ encoding coefficient
$GF(2^3)$ encoding coefficient
$GF(2^2)$ encoding coefficient

| | | | |
|---|---|---|---|
| 1 | 0 | 0 | 0 |
| 0 | 1 | 0 | 1 |

| | | |
|---|---|---|
| 15 | 3 | 2 | 6 |
| 7 | 1 | 2 | 5 |

Third decoding operation

| | | | |
|---|---|---|---|
| 1 | 0 | 0 | 0 |
| 0 | 1 | 0 | 0 |
| 0 | 0 | 2 | 3 |
| 0 | 0 | 3 | 4 |

$p_1$
$p_2$
$p_3$
$p_4$

Fourth decoding operation

FIG. 30

| + | 0 | 1 | 2 | 3 | 4 | 5 | 6 | 7 | 8 | 9 | A | B | C | D | E | F |
|---|---|---|---|---|---|---|---|---|---|---|---|---|---|---|---|---|
| 0 | 0 | 1 | 2 | 3 | 4 | 5 | 6 | 7 | 8 | 9 | A | B | C | D | E | F |
| 1 | 1 | 0 | 3 | 2 | 5 | 4 | 7 | 6 | 9 | 8 | B | A | D | C | F | E |
| 2 | 2 | 3 | 0 | 1 | 6 | 7 | 4 | 5 | A | B | 8 | 9 | E | F | C | D |
| 3 | 3 | 2 | 1 | 0 | 7 | 6 | 5 | 4 | B | A | 9 | 8 | F | E | D | C |
| 4 | 4 | 5 | 6 | 7 | 0 | 1 | 2 | 3 | C | D | E | F | 8 | 9 | A | B |
| 5 | 5 | 4 | 7 | 6 | 1 | 0 | 3 | 2 | D | C | F | E | 9 | 8 | B | A |
| 6 | 6 | 7 | 4 | 5 | 2 | 3 | 0 | 1 | E | F | C | D | A | B | 8 | 9 |
| 7 | 7 | 6 | 5 | 4 | 3 | 2 | 1 | 0 | F | E | D | C | B | A | 9 | 8 |
| 8 | 8 | 9 | A | B | C | D | E | F | 0 | 1 | 2 | 3 | 4 | 5 | 6 | 7 |
| 9 | 9 | 8 | B | A | D | C | F | E | 1 | 0 | 3 | 2 | 5 | 4 | 7 | 6 |
| A | A | B | 8 | 9 | E | F | C | D | 2 | 3 | 0 | 1 | 6 | 7 | 4 | 5 |
| B | B | A | 9 | 8 | F | E | D | C | 3 | 2 | 1 | 0 | 7 | 6 | 5 | 4 |
| C | C | D | E | F | 8 | 9 | A | B | 4 | 5 | 6 | 7 | 0 | 1 | 2 | 3 |
| D | D | C | F | E | 9 | 8 | B | A | 5 | 4 | 7 | 6 | 1 | 0 | 3 | 2 |
| E | E | F | C | D | A | B | 8 | 9 | 6 | 7 | 4 | 5 | 2 | 3 | 0 | 1 |
| F | F | E | D | C | B | A | 9 | 8 | 7 | 6 | 5 | 4 | 3 | 2 | 1 | 0 |

Finite field GF($2^1$)

Finite field GF($2^2$)

Finite field GF($2^3$)

Finite field GF($2^4$)

FIG. 31

$$1p_1+0p_2+0p_3+0p_4 = x'1 \quad (1)$$
$$0p_1+1p_2+0p_3+1p_4 = x'2 \quad (2)$$

$$1p_1+0p_2+0p_3+1p_4+1c_1 = x'3 \quad (3)$$
$$0p_1+0p_2+1p_3+0p_4+1c_2 = x'4 \quad (4)$$

Encoding coefficients in the N-order field = {14, 3, 2, 7}
$c_1=14p_1+3p_2+2p_3+7p_4$ is substituted into (3) to obtain
$$15p_1+3p_2+2p_3+6p_4=x'3 \quad (5)$$
Encoding coefficients in the (N−1)-order field = {7, 1, 2, 5}
$c_2=7p_1+1p_2+2p_3+5p_4$ is substituted into (4) to obtain
$$7p_1+1p_2+3p_3+5p_4=x'4 \quad (6)$$

FIG. 32

EP 4 184 827 A1

FIG. 33

Fifth decoding matrix

Fourth decoding matrix

Third decoding matrix

| $x_1$ | 1 | 0 | 1 | 0 | 1 | 0 | 1 | 0 |
| $x_2$ | 1 | 1 | 1 | 0 | 0 | 0 | 1 | 0 |
| ... | 0 | 0 | 1 | 0 | 1 | 0 | 1 | 1 |
| $x_{k=4}$ | 1 | 0 | 0 | 0 | 0 | 1 | 1 | 0 |
| ... | 0 | 1 | 1 | 0 | 0 | 0 | 1 | 1 |
| $x_{k+n-2=6}$ | 0 | 0 | 1 | 1 | 0 | 0 | 0 | 1 |

Fourth decoding matrix

| 1 | 0 | 0 | 0 | 0 | 0 | 0 | 0 |

Third decoding matrix

| 1 | 0 | 0 | 0 |

| 1 | 0 | 0 | 1 | 1 | 0 | 0 | 0 | — GF($2^N$) encoding coefficient |
| 0 | 0 | 1 | 0 | 0 | 1 | 0 | 0 | — GF($2^{N-1}$) encoding coefficient |
| 1 | 0 | 1 | 0 | 1 | 0 | 1 | 1 | — GF($2^3$) encoding coefficient |
| 0 | 0 | 1 | 1 | 0 | 1 | 0 | 1 | — GF($2^2$) encoding coefficient |

| 14 | 3 | 2 | 7 |
| x | x | x | x |
| 7 | 1 | 2 | 5 |

| 1 | 0 | 0 | 0 | $p_1$ |
| 0 | 3 | 2 | 7 | $p_2$ |
| 0 | Y | Y | Y | $p_3$ |
| 0 | 1 | 2 | 5 | $p_4$ |

Third decoding operation

Fourth decoding operation

FIG. 34

EP 4 184 827 A1

Network encoding apparatus

Processing unit — 3501

Transceiver unit — 3502

FIG. 35

Network encoding apparatus

— 3602 Communications interface

— 3601 Processor

— 3604

— 3603

Memory

FIG. 36

## INTERNATIONAL SEARCH REPORT

| International application No. |
|---|
| **PCT/CN2021/105002** |

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

H04L; H03M

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; IEEE; 3GPP: 华为, 郑若滨, 网络编码, 多播网络, 源数据块, 编码数据块, 编码系数, 伽罗瓦域, 伽罗华域, 有限域, 阶, 不同, 不等, 中间节点, 重编码, 解码, 译码, 报文, 编码算力, 瓶颈, 网络负载, HUAWEI, Zheng ruobin, network coding, NC, multicast, source, data block, galois field, GF, finite domain, order, level, different, high, even, recoding, decodeing, message, load+

### C. DOCUMENTS CONSIDERED TO BE RELEVANT

| Category* | Citation of document, with indication, where appropriate, of the relevant passages | Relevant to claim No. |
|---|---|---|
| X | US 2015281406 A1 (AALBORG UNIVERSITET) 01 October 2015 (2015-10-01) description paragraphs [0040]-[0045], [0090], [0095], figures 1-5 | 1, 27, 53, 54 |
| A | CN 103259865 A (COMPUTER NETWORK INFORMATION CENTER, CHINESE ACADEMY OF SCIENCES) 21 August 2013 (2013-08-21) entire document | 1-54 |
| A | CN 103200192 A (INSTITUTE OF ACOUSTICS, CHINESE ACADEMY OF SCIENCES) 10 July 2013 (2013-07-10) entire document | 1-54 |
| A | CN 101257366 A (HUAWEI TECHNOLOGY CO., LTD.) 03 September 2008 (2008-09-03) entire document | 1-54 |
| A | KR 101876130 B1 (EWHA UNIVERSITY-INDUSTRY COLLABORATION FOUNDATION) 06 July 2018 (2018-07-06) entire document | 1-54 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 September 2021** | **23 September 2021** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2021/105002**

| Patent document cited in search report | | | Publication date (day/month/year) | Patent family member(s) | | | Publication date (day/month/year) |
|---|---|---|---|---|---|---|---|
| US | 2015281406 | A1 | 01 October 2015 | US | 9647800 | B2 | 09 May 2017 |
| CN | 103259865 | A | 21 August 2013 | WO | 2014187123 | A1 | 27 November 2014 |
| CN | 103200192 | A | 10 July 2013 | CN | 103200192 | B | 17 February 2016 |
| CN | 101257366 | A | 03 September 2008 | CN | 101257366 | B | 22 September 2010 |
| KR | 101876130 | B1 | 06 July 2018 | | None | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010820352